# EUROPEAN PATENT APPLICATION

(11) **EP 4 660 703 A2**
(43) Date of publication of application: **10.12.2025**
(21) Application number: 25177200.0
(22) Date of filing: 19.05.2025
(51) Int. Cl.: G03F 7/004, G03F 7/09, G03F 7/40

(54) **METAL-CONTAINING FILM PATTERNING PROCESS**

(30) Priority: 29.05.2024 JP 2024087135
(71) Applicant: Shin-Etsu Chemical Co., Ltd., Tokyo 100-0005 (JP)
(72) Inventor: KOBAYASHI, Naoki, Niigata (JP); YAMAGUCHI, Hidenori, Niigata (JP); ISHIWATA, Kenta, Niigata (JP)
(74) Representative: Röthinger, Rainer

(57) **Abstract**

The present invention is a patterning process for forming a pattern on a substrate, including the steps of: (I-1) applying a composition for forming a metal-containing film onto a substrate on which a film to be processed has been formed, followed by heating to form a metal-containing film; (1-2) forming a pattern directly or indirectly in the metal-containing film; (1-3) subjecting the pattern of the metal-containing film to plasma irradiation; and (1-4) forming the pattern directly or indirectly in the film to be processed while using the plasma-irradiated pattern of the metal-containing film as an etching mask. This can provide a method that makes it possible to form a pattern having excellent edge roughness in a film to be processed by using a plasma-irradiated metal-containing film pattern as an etching mask.

## Description

### TECHNICAL FIELD

The present invention relates to a metal-containing film patterning process that can be used for fine patterning according to a multilayer resist method in a semiconductor device manufacturing process.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry-etched with a thinner photoresist film having lower etching resistance. Therefore, a demand for finding a composition used in this processing and the process therefor has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1, for example.

Meanwhile, in recent years, with the rapid miniaturization of DRAM memory, the proportion of edge roughness to the line width of a pattern has increased in fine patterns with high resolution in the order or nanometer, and it has become even more difficult than before to reduce the edge roughness of a pattern. Accordingly, the need for a resist underlayer film pattern having favorable edge roughness is rising.

Various methods are being considered for reducing line width variation in a pattern in a layer to be etched. As an example, there is a method of enhancing the etching resistance of a resist pattern by performing plasma treatment using H₂ gas to modify the resist film (Patent Document 2).

It is also reported that the dry etching resistance of an organic underlayer film material can be improved by irradiation with plasma, electron beam, and/or ion (Patent Document 3).

However, all the above-described methods use an organic film as an etching mask. When considering use as an etching mask in advanced generations, there are concerns regarding the dry etching resistance of organic films, and degradation in edge roughness is expected at the time of pattern transfer to a substrate to be processed.

### CITATION LIST

### PATENT LITERATURE

Patent Document 1: JP2004-205685A
Patent Document 2: JP5674375B2
Patent Document 3: JP2022-529888A

### SUMMARY OF INVENTION

### TECHNICAL PROBLEM

The present invention has been made in view of the above-described circumstances. An object of the present invention is to provide a method that makes it possible to form a pattern having excellent edge roughness in a film to be processed by using a plasma-irradiated metal-containing film pattern as an etching mask.

### SOLUTION TO PROBLEM

To achieve the object, the present invention provides a patterning process for forming a pattern on a substrate, comprising the steps of:
(I-1) applying a composition for forming a metal-containing film onto a substrate on which a film to be processed has been formed, followed by heating to form a metal-containing film;
(I-2) forming a pattern directly or indirectly in the metal-containing film;
(I-3) subjecting the pattern of the metal-containing film to plasma irradiation; and
(I-4) forming the pattern directly or indirectly in the film to be processed while using the plasma-irradiated pattern of the metal-containing film as an etching mask, wherein
a plasma used in the plasma irradiation in the step (I-3) etches the metal-containing film less than an etching gas used in the step (I-2) and etches the film to be processed less than an etching gas used in the step (I-4).

According to such a patterning process, the film surface on the side walls of the metal-containing film pattern is modified by plasma irradiation and dry etching is improved, and therefore, when the pattern is used as an etching mask, a film to be processed pattern having small edge roughness can be formed.

The present invention can also provide the above-described patterning process, where, in the step (I-2), the metal-containing film is subjected to pattern exposure with a high-energy beam and then development with a developer to form the pattern in the metal-containing film.

As the step (I-2), the pattern can be formed in the metal-containing film in this manner.

In the step (I-2), it is preferable that an extreme ultraviolet ray having a wavelength of 3 to 15 nm or an electron beam with an acceleration voltage of 1 to 150 kV is used as the high-energy beam.

When a high-energy beam with such a wavelength or acceleration voltage is used, organic groups are removed from the metal source easily and the progression of a crosslinking reaction can be promoted, and therefore, insolubility in a developer can be enhanced.

The patterning process, wherein, in the step (I-2), the developer contains an organic solvent, is preferable.

When such a developer is used, a metal-containing resist film pattern with small edge roughness can be formed.

The present invention can also provide the patterning process, comprising, between the step (I-1) and the step (I-2), the steps of:
(I-1-1) forming a resist upper layer film directly or indirectly on the metal-containing film; and
(I-1-2) subjecting the resist upper layer film to pattern exposure and then development with a developer to form a pattern in the resist upper layer film, wherein
in the step (I-2), the pattern is formed in the metal-containing film by performing etching at least once while using the pattern of the resist upper layer film as a mask.

According to such a patterning process, the film surface on the side walls of the metal-containing resist underlayer film pattern is modified by plasma irradiation and dry etching is improved, and therefore, when the pattern is used as an etching mask, a film to be processed pattern having small edge roughness can be formed.

The step of performing plasma irradiation is preferably performed under an atmosphere of N₂, NF₃, H₂, fluorocarbon, a rare gas, or a mixture thereof.

When the plasma irradiation of the metal-containing film pattern is performed under an atmosphere containing a gas given above, dry etching resistance can be imparted to the metal-containing film pattern while suppressing side-etching.

The step of performing plasma irradiation is preferably performed under an atmosphere containing hydrogen or helium.

When the plasma irradiation of the metal-containing film pattern is performed under an atmosphere containing a gas given above, dry etching resistance can be imparted to the metal-containing film pattern while suppressing side-etching with certainty.

It is also preferable from the viewpoint of productivity to perform the plasma irradiation under a gas atmosphere containing H₂ or helium.

The composition for forming a metal-containing film preferably contains (A) a metal source containing at least one of (A-1) a metal compound and (A-2) a metallic salt and contains (B) a solvent, the metal being a metal element belonging to the third period to the seventh period of group 3 to 15 of the periodic table.

According to the patterning process using the above-described composition for forming a metal-containing film, the modification caused by the plasma irradiation occurs easily, and it is possible to form a metal-containing film pattern having better resistance to processing by dry etching.

The metal contained in the metal compound (A-1) is preferably titanium, zirconium, or hafnium.

According to the patterning process using the above-described composition for forming a metal-containing film, the modification caused by the plasma irradiation occurs easily and dry etching is improved, and therefore, when the pattern is used as an etching mask, a film to be processed pattern having small edge roughness can be formed.

The film to be processed is preferably any of a metal film, a metal carbide film, a metal oxide film, a metal nitride film, a metal oxycarbide film, a metal oxynitride film, and an organic film containing carbon and one or more elements selected from nitrogen, hydrogen, and oxygen.

When the film to be processed is as described, a pattern having excellent edge roughness can be formed in the film to be processed by dry etching using the metal-containing film pattern as a mask.

In this case, the metal of the film to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy thereof.

When the film to be processed is as described, a pattern having excellent edge roughness can be formed in the film to be processed by dry etching using the metal-containing film pattern as a mask.

### ADVANTAGEOUS EFFECTS OF INVENTION

As explained above, in recent years, with the rapid miniaturization of DRAM, the proportion of edge roughness to the line width of a pattern has increased in fine patterns with high resolution in the order or nanometer, and it has become even more difficult than before to reduce the edge roughness of a pattern. Accordingly, the need is rising for a resist underlayer film pattern that makes it possible to form a pattern having excellent edge roughness in a substrate to be processed. The inventive patterning process makes it possible to form a pattern having excellent edge roughness in a film to be processed by using a plasma-irradiated metal-containing film pattern as an etching mask, and therefore, can be used particularly suitably in a multilayer resist process, and is extremely useful in fine patterning for manufacturing a semiconductor device.

### BRIEF DESCRIPTION OF DRAWINGS

FIG. 1 is an explanatory diagram of an example of the inventive patterning process (two-layer resist process).
FIG. 2 is an explanatory diagram of an example of the inventive patterning process (three-layer resist process).
FIG. 3 is an explanatory diagram of an example of the inventive patterning process (four-layer resist process).
FIG. 4 is an explanatory diagram of an example of the inventive patterning process (a process using a metal-containing resist upper layer film).

### DESCRIPTION OF EMBODIMENTS

As explained above, there have been demands for the development of a patterning process according to which a resist pattern can be transferred to a substrate to be processed with higher precision in a fine patterning process using a multilayer resist method.

The present inventors have searched for a method by which a film-to-be-processed pattern with small edge roughness can be formed and studied earnestly, and found out that, by forming a pattern directly or indirectly in a metal-containing film formed by using a composition for forming a metal-containing film and then performing plasma irradiation, a metal-containing film pattern excellent in dry etching resistance can be formed, and that when the pattern is used as an etching mask, a pattern having excellent edge roughness can be formed in a film to be processed. Thus, the present invention has been completed.

That is, the present invention provides a patterning process for forming a pattern on a substrate, comprising the steps of:
(I-1) applying a composition for forming a metal-containing film onto a substrate on which a film to be processed has been formed, followed by heating to form a metal-containing film;
(I-2) forming a pattern directly or indirectly in the metal-containing film;
(I-3) subjecting the pattern of the metal-containing film to plasma irradiation; and
(I-4) forming the pattern directly or indirectly in the film to be processed while using the plasma-irradiated pattern of the metal-containing film as an etching mask, wherein
a plasma used in the plasma irradiation in the step (I-3) etches the metal-containing film less than an etching gas used in the step (I-2) and etches the film to be processed less than an etching gas used in the step (I-4).

Hereinafter, the present invention will be described in detail, but the present invention is not limited thereto.

### [Patterning Process]

The present invention is a patterning process for forming a pattern on a substrate, including the steps of:
(I-1) applying a composition for forming a metal-containing film onto a substrate on which a film to be processed has been formed, followed by heating to form a metal-containing film;
(I-2) forming a pattern directly or indirectly in the metal-containing film;
(I-3) subjecting the pattern of the metal-containing film to plasma irradiation; and
(I-4) forming the pattern directly or indirectly in the film to be processed while using the plasma-irradiated pattern of the metal-containing film as an etching mask, where
a plasma used in the plasma irradiation in the step (I-3) etches the metal-containing film less than an etching gas used in the step (I-2) and etches the film to be processed less than an etching gas used in the step (I-4).

Note that, in the present invention, it is necessary to use, as a plasma used in the plasma irradiation in the step (I-3), a plasma that etches the metal-containing film less than an etching gas used in the step (I-2) and etches the film to be processed less than an etching gas used in the step (I-4). When a plasma that etches the metal-containing film less than an etching gas used in the step (I-2) is used as a plasma used in the plasma irradiation in the step (I-3), a pattern of the metal-containing film can be obtained in step (I-2), and meanwhile, it is possible to avoid the pattern of the metal-containing film obtained in step (I-3) being damaged or lost. Furthermore, when a plasma that etches the film to be processed less than an etching gas used in the step (I-4) is used, a pattern of the film to be processed can be obtained with certainty in step (I-4), and it is possible to avoid the metal-containing film obtained in step (I-3) being damaged or lost.

The present invention satisfies the summary given above, and the method for forming the metal-containing film pattern is not particularly limited.

Examples of the method include a patterning process (the following (i-1) to (i-4)) including, in the step (I-2), a step of subjecting the metal-containing film to pattern exposure with a high-energy beam and then development with a developer to form a pattern in the metal-containing film.

That is, the above-described patterning process for forming a pattern on a substrate may include the steps of:
(i-1) applying a composition for forming a metal-containing film onto a substrate on which a film to be processed has been formed, followed by heating to form a metal-containing film;
(i-2) subjecting the metal-containing film to pattern exposure with a high-energy beam and then development with a developer to form a pattern in the metal-containing film;
(i-3) subjecting the pattern of the metal-containing film to plasma irradiation; and
(i-4) forming the pattern directly or indirectly in the film to be processed while using the plasma-irradiated pattern of the metal-containing film as an etching mask.

Examples also include a patterning process (the following (ii-1) to (ii-6)) including, between the step (I-1) and the step (I-2), the steps of:
(I-1-1) forming a resist upper layer film directly or indirectly on the metal-containing film; and
(I-1-2) subjecting the resist upper layer film to pattern exposure and then development with a developer to form a pattern in the resist upper layer film.

That is, the above-described patterning process for forming a pattern on a substrate may include the steps of:
(ii-1) applying a composition for forming a metal-containing film onto a substrate on which a film to be processed has been formed, followed by heating to form a metal-containing resist underlayer film;
(ii-2) forming a resist upper layer film directly or indirectly on the metal-containing resist underlayer film;
(ii-3) subjecting the resist upper layer film to pattern exposure and then development with a developer to form a pattern in the resist upper layer film;
(ii-4) forming the pattern in the metal-containing resist underlayer film by performing etching at least once while using the pattern of the resist upper layer film as a mask;
(ii-5) subjecting the pattern of the metal-containing resist underlayer film to plasma irradiation; and
(ii-6) forming the pattern directly or indirectly in the film to be processed while using the plasma-irradiated pattern of the metal-containing resist underlayer film as an etching mask.

Specific examples of the inventive patterning process include the following patterning processes.

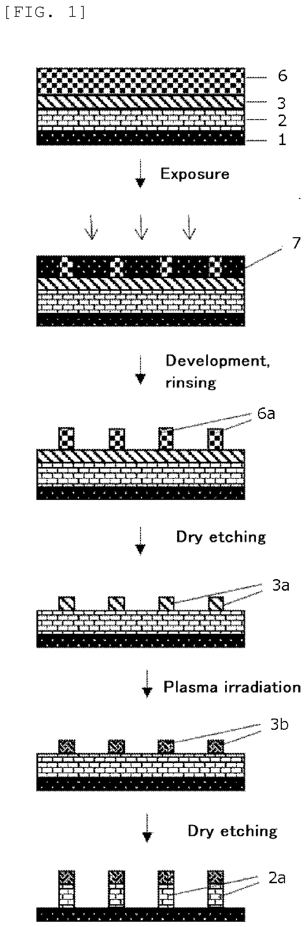

A patterning process according to a two-layer resist process is shown in FIG. 1.

Firstly, on a substrate (1) to be processed having a layer (2) to be processed, a metal-containing film (3) and a resist upper layer film (6) are formed. The resist upper layer film is exposed (7), and removal is performed by development and rinsing to form a resist upper layer film pattern (6a). Dry etching is performed while using the obtained resist upper layer film pattern (6a) as a mask for transfer to obtain a metal-containing film pattern (3a). The transferred metal-containing film pattern (3a) is irradiated with plasma to obtain a plasma-irradiated metal-containing film pattern (3b). Dry etching is performed while using the metal-containing film pattern (3b) as a mask to form a pattern (2a) in the layer to be processed.

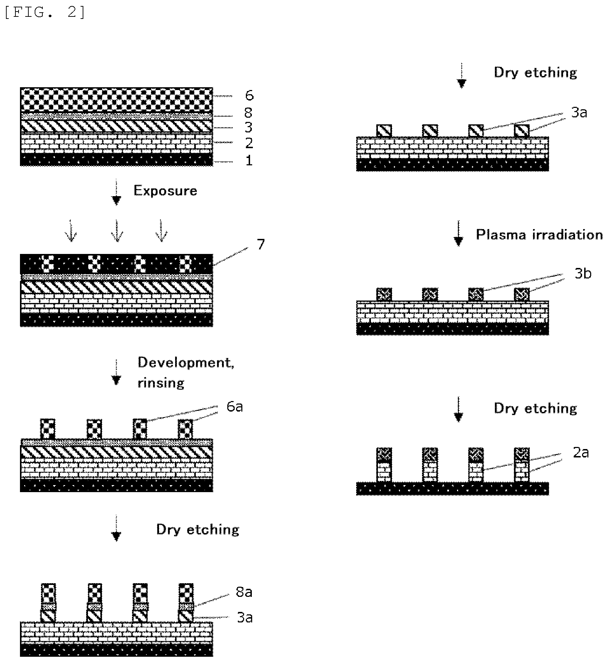

A patterning process according to a three-layer resist process is shown in FIG. 2.

Firstly, a metal-containing film (3), an adhesive film (8), and a resist upper layer film (6) are formed on a substrate (1) to be processed having a layer (2) to be processed. The resist upper layer film is exposed (7), and removal is performed by development and rinsing to form a resist upper layer film pattern (6a). Dry etching is performed while using the obtained resist upper layer film pattern (6a) as a mask for transfer to obtain an adhesive film pattern (8a) and a metal-containing film pattern (3a). The transferred metal-containing film pattern (3a) is irradiated with plasma to obtain a plasma-irradiated metal-containing film pattern (3b). Dry etching is performed while using the metal-containing film pattern (3b) as a mask to form a pattern (2a) in the layer to be processed.

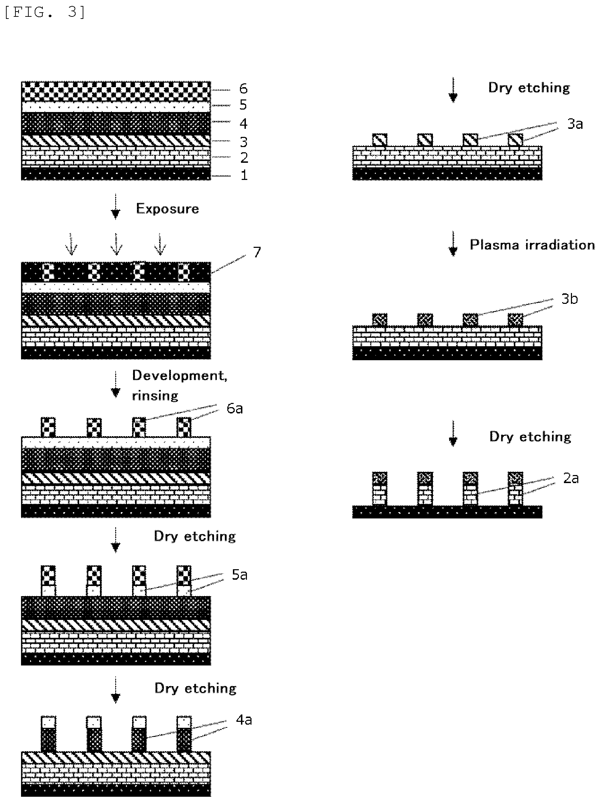

A patterning process according to a four-layer resist process is shown in FIG. 3.

Firstly, a metal-containing film (3), a resist underlayer film (4), a silicon-containing resist middle layer film (5), and a resist upper layer film (6) are formed on a substrate (1) to be processed having a layer (2) to be processed. The resist upper layer film is exposed (7), and removal is performed by development and rinsing to form a resist upper layer film pattern (6a). Dry etching is performed while using the obtained resist upper layer film pattern (6a) as a mask for transfer to obtain a silicon-containing resist middle layer film pattern (5a). The silicon-containing resist middle layer film pattern (5a) is further transferred by dry etching to obtain a resist underlayer film pattern (4a) and a metal-containing film pattern (3a). The transferred metal-containing film pattern (3a) is subjected to plasma irradiation to obtain a plasma-irradiated metal-containing film pattern (3b), and then a pattern (2a) is formed by dry etching in the layer to be processed.

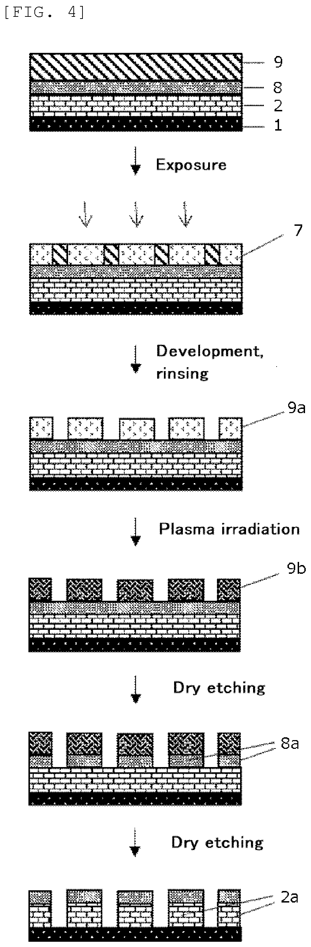

A process using a metal-containing resist upper layer film is shown in FIG. 4.

Firstly, an adhesive film (8) and a metal-containing resist upper layer film (9) are formed on a substrate (1) to be processed having a layer (2) to be processed. The metal-containing resist upper layer film is exposed (7), and removal is performed by development and rinsing to form a metal-containing resist upper layer film pattern (9a). The metal-containing resist upper layer film pattern is subjected to plasma irradiation to obtain a plasma-irradiated metal-containing resist upper layer film pattern (9b), and then dry etching is performed for transfer to obtain an adhesive film pattern (8a). Furthermore, a pattern (2a) is formed in the layer to be processed.

In the following, each step is described in detail in turn.

### [Step (I-1)]

Step (I-1) is a step of forming a metal-containing film on a substrate on which a film to be processed has been formed.

### <Substrate>

As the substrate, it is possible to use, for example, a substrate in which any of a metal film, a metal carbide film, a metal oxide film, a metal nitride film, a metal oxycarbide film, a metal oxynitride film, an organic film containing carbon and one or more elements selected from nitrogen, hydrogen, and oxygen, and a composite of these films is formed as a layer to be processed (portion to be processed) on a substrate for manufacturing a semiconductor.

The metal-containing film pattern of the present invention has excellent etching selectivity to the film to be processed, and therefore, a pattern having excellent edge roughness can be transferred to the layer to be processed. In particular, the pattern exhibits excellent etching selectivity to Si, SiO₂, SiN, SiON, SiOC, p-Si, α-Si, SOG (Spin on Glass), organic films containing carbon and one or more elements selected from nitrogen, hydrogen, and oxygen, and therefore, it is more preferable to use the pattern as a mask for transferring the pattern to these layers to be processed.

As the substrate for manufacturing a semiconductor, a silicon substrate is generally used, but the substrate is not particularly limited, and it is possible to use Si, amorphous silicon (α-Si), p-Si, SiO₂, SiN, SiON, W, TiN, Al, etc., being a material different from that of the layer to be processed.

As the metal constituting the layer to be processed, it is possible to use silicon, titanium, tungsten, hafnium, zirconium, chromium, germanium, copper, silver, gold, aluminum, indium, gallium, arsenic, palladium, iron, tantalum, iridium, molybdenum, or an alloy thereof. As a layer to be processed containing such metal, it is possible to use, for example, Si, SiO₂, SiN, SiON, SiOC, p-Si, α-Si, TiN, WSi, BPSG, SOG, Cr, CrO, CrON, MoSi, W, W-Si, Al, Cu, Al-Si, etc., and various low dielectric films and etching stopper films therefor.

When the film constituting the layer to be processed is an organic film containing carbon and one or more elements selected from nitrogen, hydrogen, and oxygen, it is possible to use a coating-type composition for forming an organic underlayer film. Examples of coating-type organic underlayer film materials include resins and compositions shown in WO2007-105776A1, WO2009-72465A1, WO2010-61774A1, WO2010-147155A1, WO2011-125839A1, WO2012-50064A1, WO2012-77640A1, WO2013-5797A1, WO2013-47106A1, WO2013-47516A1, WO2013-80929A1, WO2013-115097A1, WO2013-146670A1, WO2014-24836A1, WO2014-208324A1, WO2014-208499A1, WO2015-170736A1, WO2015-194273A1, WO2016-147989A1, JP2001-40293A, JP2002-214777A, JP2002-296789A, JP2004-205685A, JP2004-264710A, JP2005-043471A, JP2005-250434A, JP2005-128509A, JP2006-259249A, JP2006-285046A, JP2007-171895A, JP2007-199653A, JP2007-293294A, JP2008-65303A, JP2008-65081A, JP2008-274250A, JP2009-14816A, JP2009-229666A, JP2009-251130A, JP2010-122656A, JP2010-15112A, JP2010-271654A, JP2011-107684A, JP2011-170059A, JP2012-1687A, JP2012-77295A, JP2012-214720A, JP2012-215842A, JP2013-83939A, JP2014-24831A, JP2014-157169A, JP2015-131954A, JP2015-183406A, JP2016-29160A, JP2016-44272A, JP2016-60886A, JP2016-145849A, JP2016-167047A, JP2016-216367A, JP2017-3959A, JP2017-119670A, JP2017-119671A, JP2013-516643A, JP2015-515112A, JP2017-119671A, JP2019-44022A, etc. In the present invention, preferable are resins containing an aromatic skeleton-containing compound such as a naphthalene skeleton-containing compound, a fluorene skeleton-containing compound, a carbazole skeleton-containing compound, an acenaphthylene skeleton-containing compound, a naphthol skeleton-containing compound, and a bisnaphthol skeleton-containing compound.

In a case where the organic film is formed by a spin-coating method, baking (heating) is performed after spin-coating, so as to evaporate the solvent and promote a crosslinking reaction to prevent mixing with the upper layer film. The baking is preferably performed at a temperature of 100°C or higher and 600°C or lower for 10 to 600 seconds, more preferably at a temperature of 200°C or higher and 500°C or lower for 10 to 300 seconds. In consideration of influences on device damage, wafer deformation, and the like, the upper limit of the heating temperature in the wafer process of lithography is preferably not more than 600°C, and more preferably not more than 500°C.

The layer to be processed may also be coated with a composition for forming an organic underlayer film by spin-coating or the like in the same manner as described above, and then the composition for forming an organic underlayer film may be baked and cured under an atmosphere having an oxygen concentration of 0.1 volume % or more and 21 volume % or less to form a high refractive index film containing carbon.

By virtue of baking the composition for forming an organic underlayer film in such an oxygen atmosphere, a sufficiently cured film can be obtained. The atmosphere during baking may be air; however, to prevent oxidation of the organic underlayer film, it is preferable to enclose an inert gas, such as N₂, Ar, or He, therein to reduce the amount of oxygen. Control of oxygen concentration is necessary to prevent oxidation; the oxygen concentration is preferably 1000 ppm or less, more preferably 100 ppm or less (volumetric basis). By thus preventing oxidation, the absorption does not increase and the etching resistance does not decrease, which is preferable.

It is also possible to use amorphous carbon, diamond-like carbon, etc., formed by a PVD method, a CVD method, or an ALD method.

As the film thickness of the layer to be processed, the layer can usually be formed to have a thickness of 10 to 10,000 nm, particularly 30 to 5,000 nm.

### <Metal-Containing Film>

The composition for forming a metal-containing film preferably has (A) a metal source and (B) a solvent, and as the metal source, it is preferable to use (A-1) a metal compound, (A-2) a metallic salt, or a combination thereof.

The metal used as the metal source (A) is preferably a metal element belonging to the third period to the seventh period of group 3 to 15 of the periodic table.

The metal element (hereinafter, also referred to as "metal element (a)") constituting the metal source (A) belongs to the third period to the seventh period of group 3 to 15 of the periodic table.

Examples of metal elements (a) of the group 3 include scandium, yttrium, lanthanum, and cerium.

Examples of metal elements (a) of the group 4 include titanium, zirconium, and hafnium.

Examples of metal elements (a) of the group 5 include vanadium, niobium, and tantalum.

Examples of metal elements (a) of the group 6 include chromium, molybdenum, and tungsten.

Examples of metal elements (a) of the group 7 include manganese and rhenium.

Examples of metal elements (a) of the group 8 include iron, ruthenium, and osmium.

Examples of metal elements (a) of the group 9 include cobalt, rhodium, and iridium.

Examples of metal elements (a) of the group 10 include nickel, palladium, and platinum.

Examples of metal elements (a) of the group 11 include copper, silver, and gold.

Examples of metal elements (a) of the group 12 include zinc, cadmium, and mercury.

Examples of metal elements (a) of the group 13 include aluminum, gallium, and indium.

Examples of metal elements (a) of the group 14 include germanium, tin, and lead.

Examples of metal elements (a) of the group 15 include antimony and bismuth.

As the metal element (a) constituting the metal source (A), metal elements (a) of the third period to the seventh period of group 3 to 15 are preferable, metal elements (a) of the third period to the seventh period of group 4 to 6 and 13 are more preferable, and titanium, zirconium, and hafnium are further preferable.

### [(A-1) Metal Compound]

As the metal compound (A-1), a compound having a metal-oxygen covalent bond is preferable. The metal compound (A-1) may also contain another element other than the metal element (a) and oxygen. Examples of the other element include: semimetal elements, such as boron and silicon; nonmetal elements, such as carbon, hydrogen, nitrogen, phosphorus, sulfur, and halogens; etc. Among these, silicon, carbon, or hydrogen is preferable.

The lower limit of the percentage of atoms of the metal element (a) contained in the compound (A-1) is preferably 10 mass%, more preferably 20 mass%, and further preferably 30 mass%. The upper limit of the contained percentage is preferably 50 mass%. The contained percentage of atoms of the metal element (a) can be determined by measuring using a differential thermal analyzer (TG/DTA). When the compound (A-1) contains the atoms of the metal element (a) at a percentage in the above-described ranges, the structural modification of the metal source (A) by the plasma irradiation can be promoted more effectively, and as a result, the edge roughness and dry etching resistance of a line pattern can be further improved.

The lower limit of the amount of the compound (A-1) contained is preferably 70 mass%, more preferably 80 mass%, and further preferably 90 mass% based on the total solid content of the composition for forming a film. The upper limit of the contained amount may be 100 mass%. When the contained amount of the compound (A-1) is in the above-described ranges, the application property of the composition for forming a film can be further improved. The "total solid content" of the composition for forming a film refers to the components other than the solvent (B). The composition for forming a film may contain one kind of the compound (A-1) or two or more kinds thereof.

### [Method for Synthesizing Compound (A-1)]

As the compound (A-1), a commercially available metal compound may be used, but it is possible to synthesize the compound by, for example, a method of performing a hydrolysis condensation reaction using a metal-containing compound having a hydrolysable group (hereinafter, also referred to as "metal-containing compound (b)"). That is, the compound (A-1) may be derived from a metal-containing compound (b). Here, a "hydrolysis condensation reaction" refers to a reaction where a hydrolysable group contained in the metal-containing compound (b) is hydrolyzed and converted to - OH, and the two -OH groups obtained undergo dehydration condensation to form -O-.

### ((b) Metal-Containing Compound)

The metal-containing compound (b) is a metal compound having a hydrolysable group (hereinafter, also referred to as "metal compound (I)"), a hydrolysis product of the metal compound (I), a hydrolysis condensate of the metal compound (I), or a combination thereof. One kind of the metal compound (I) may be used, or a combination of two or more kinds thereof may be used.

Examples of the hydrolysable group include halogen atoms, alkoxy groups, a carboxylate group, acyloxy groups, and -NRR'. R and R' each independently represent a hydrogen atom or a monovalent organic group having 1 to 20 carbon atoms. Examples of the monovalent organic groups represented by R and R' having 1 to 20 carbon atoms include: a monovalent hydrocarbon group having 1 to 20 carbon atoms; a monovalent group (g), being the hydrocarbon group, containing a divalent heteroatom-containing group between carbon atoms; monovalent groups, being the hydrocarbon group and the group (g), where part or all of the hydrogen atoms contained are substituted with monovalent heteroatom-containing groups; etc.

Examples of the halogen atoms include a fluorine atom, a chlorine atom, a bromine atom, an iodine atom, etc.

Examples of the alkoxy groups include a methoxy group, an ethoxy group, an n-propoxy group, an i-propoxy group, an n-butoxy group, a t-butoxy group, etc.

Examples of the carboxylate groups include an acetate group, a propionate group, a butyrate group, an n-hexanecarboxylate group, an n-octanecarboxylate group, etc.

Examples of the acyloxy groups include an acetoxy group, an ethylyloxy group, a propionyloxy group, a butyryloxy group, a t-butyryloxy group, a t-amylyloxy group, an n-hexanecarbonyloxy group, an n-octanecarbonyloxy group, etc.

Examples of the -NRR' include an unsubstituted amino group, a methylamino group, a dimethylamino group, a diethylamino group, a dipropylamino group, etc.

As the hydrolysable group, an alkoxy group is preferable, and an i-propoxy group, an n-butoxy group, or a t-butoxy group is more preferable.

In a case where the metal-containing compound (b) is a hydrolysis condensate of a metal compound (I), the hydrolysis condensate of the metal compound (I) may be a hydrolysis condensate of a metal compound (I) containing a metal element (a) and a compound containing a semimetal element, depending on the purpose of the present invention. That is, the hydrolysis condensate of the metal compound (I) may contain a semimetal element depending on the purpose of the present invention. Examples of such semimetal elements include boron, silicon, arsenic, and tellurium. The percentage of semimetal atoms contained in the hydrolysis condensate of the metal compound (I) is usually less than 50 atom %, preferably 30 atom % or less, and more preferably 10 atom % or less based on the total amount of the atoms of the metal element (a) and semimetal atoms in the hydrolysis condensate.

Examples of the metal compound (I) include compounds represented by the following formula (1) (hereinafter, also referred to as "metal compound (I-1)"). When such a metal compound (I-1) is used, a stable compound (A-1) can be formed, and as a result, it is possible further to improve the property of suppressing change in coating film thickness and the property of suppressing change in plasma irradiation sensitivity.

**LₐMX_{b}** **(1)**

In the formula, M represents a metal atom. L represents a monodentate ligand having 1 to 30 carbon atoms or a polydentate ligand having 1 to 30 carbon atoms, and X represents a hydrolysable group selected from a halogen atom, an alkoxy group, a carboxylate group, an acyloxy group, and -NR¹R². R¹ and R² each independently represent a hydrogen atom or a monovalent organic group having 1 to 20 carbon atoms. "a" represents an integer of 0 to 6, and when "a" is 2 or more, the multiple Ls are identical to or different from each other. "b" represents an integer of 2 to 6. The multiple Xs are identical to or different from each other. L is a ligand that does not apply to X.

Examples of the metal atom represented by M in the formula (1) include the atoms given as examples of the atoms of the metal element (a) constituting the compound (A-1).

Examples of the ligand represented by L in the formula (1) include monodentate ligands and polydentate ligands.

### (Hydrolysable Group)

Examples of the hydrolysable group X of the formula (1) include halogen atoms, alkoxy groups, carboxylate groups, acyloxy groups, and -NR¹R². R¹ and R² preferably each independently represent a hydrogen atom or a monovalent organic group having 1 to 20 carbon atoms.

Examples of the halogen atoms include a fluorine atom, a chlorine atom, a bromine atom, an iodine atom, etc.

Examples of the alkoxy groups include a methoxy group, an ethoxy group, an n-propoxy group, an i-propoxy group, an n-butoxy group, a t-butoxy group, etc.

Examples of the carboxylate groups include an acetate group, a propionate group, a butyrate group, an n-hexanecarboxylate group, an n-octanecarboxylate group, etc.

Examples of the acyloxy groups include an acetoxy group, an ethylyloxy group, a propionyloxy group, a butyryloxy group, a t-butyryloxy group, a t-amylyloxy group, an n-hexanecarbonyloxy group, an n-octanecarbonyloxy group, etc.

Examples of the -NR¹R² include an unsubstituted amino group, a methylamino group, a dimethylamino group, a diethylamino group, a dipropylamino group, etc.

As the hydrolysable group X, an alkoxy group is preferable, and an i-propoxy group, an n-butoxy group, or a t-butoxy group is more preferable.

### (Monodentate Ligand)

Examples of the monodentate ligand include a hydroxo ligand, a carboxy ligand, an amido ligand, an amine ligand, an ammonia ligand, an olefin ligand, etc.

Examples of the amido ligand include an unsubstituted amido ligand (NH₂), a methylamido ligand (NHMe), a dimethylamido ligand (NMe₂), a diethylamido ligand (NEt₂), a dipropylamido ligand (NPr₂), etc.

Examples of the amine ligand include pyridine, a trimethylamine ligand, a piperidine ligand, etc.

Examples of the olefin ligand include: chain olefins, such as ethylene and propylene; cyclic olefins, such as cyclopentene, cyclohexene, and norbornene; etc.

### (Polydentate Ligand)

Examples of the polydentate ligand include a ligand derived from a hydroxy acid ester, a ligand derived from a β-diketone, a ligand derived from a β-keto ester, a ligand derived from an α,α-dicarboxylic acid ester, a hydrocarbon having a π bond, diphosphine, etc.

Examples of the hydroxy acid ester include glycolic acid esters, lactic acid esters, 2-hydroxycyclohexane-1-carboxylic acid esters, salicylic acid esters, etc.

Examples of the β-diketone include acetoacetic acid esters, α-alkyl-substituted acetoacetic acid esters, β-ketopentanoic acid esters, benzoylacetic acid esters, 1,3-acetonedicarboxylic acid esters, etc.

Examples of the α,α-dicarboxylic acid ester include malonic acid diesters, α-alkyl-substituted malonic acid diesters, α-cycloalkyl-substituted malonic acid diesters, α-aryl-substituted malonic acid diesters, etc.

Examples of the hydrocarbon having a π bond include: chain dienes, such as butadiene and isoprene; cyclic dienes, such as cyclopentadiene, methylcyclopentadiene, pentamethylcyclopentadiene, cyclohexadiene, and norbornadiene; aromatic hydrocarbons, such as benzene, toluene, xylene, hexamethylbenzene, naphthalene, and indene; etc.

Examples of the diphosphine include 1,1-bis(diphenylphosphino)methane, 1,2-bis(diphenylphosphino) ethane, 1,3-bis(diphenylphosphino)propane, 2,2'-bis(diphenylphosphino)-1,1'-binaphthyl, 1,1'-bis(diphenylphosphino)ferrocene, etc.

In the general formula (1), the "a" is preferably 0 to 4, more preferably 0 to 3, further preferably 1 or 2, and particularly preferably 2. When "a" has such a value, the stability of the compound (A-1) can be enhanced suitably, and as a result, it is possible further to improve the property of suppressing change in coating film thickness and the property of suppressing change in plasma irradiation sensitivity.

The "b" is preferably 2 to 4, more preferably 2 or 3, and further preferably 2. When "b" has such a value, the stability of the compound (A-1), being a hydrolysis condensate, can be enhanced suitably, and as a result, it is possible further to improve the property of suppressing change in coating film thickness and the property of suppressing change in plasma irradiation sensitivity.

As the metal-containing compound (b), preferable are: metal alkoxide that has not been subjected to hydrolysis or hydrolysis condensation; and metal alkoxide that has a ligand and has not been subjected to hydrolysis or hydrolysis condensation.

As the metal-containing compound (b),
examples of compounds containing titanium include diisopropoxybis(2,4-pentanedionate)titanium(IV), tetra-n-butoxytitanium(IV), tetra-n-propoxytitanium(IV), tri-n-butoxymonostearatetitanium(IV), titanium(IV)butoxide oligomer, aminopropyltrimethoxytitanium(IV), triethoxymono(2,4-pentanedionate)titanium(IV), tri-n-propoxymono(2,4-pentanedionate)titanium(IV), triisopropoxymono(2,4-pentanedionate)titanium, and di-n-butoxybis(2,4-pentanedionate)titanium(IV).

Examples of compounds containing zirconium include dibutoxybis(ethylacetoacetate)zirconium(IV), di-n-butoxybis(2,4-pentanedionate)zirconium(IV), tetra-n-butoxyzirconium(IV), tetra-n-propoxyzirconium(IV), tetraisopropoxyzirconium(IV), aminopropyltriethoxyzirconium(IV), 2-(3,4-epoxycyclohexyl)ethyltrimethoxyzirconium(IV), γ-glycidoxypropyltrimethoxyzirconium(IV), 3-isocyanopropyltrimethoxyzirconium(IV), triethoxymono(2,4-pentanedionate)zirconium(IV), tri-n-propoxymono (2, 4-pentanedionate) zirconium (IV), triisopropoxymono (2,4-pentanedionate) zirconium (IV), tri(3-methacryloxypropyl)methoxyzirconium(IV), and tri(3-acryloxypropyl)methoxyzirconium(IV).

Examples of compounds containing hafnium include diisopropoxybis(2,4-pentanedionate)hafnium(IV), tetrabutoxyhafnium(IV), tetraisopropoxyhafnium(IV), tetraethoxyhafnium(IV), and dichlorobis(cyclopentadienyl)hafnium(IV).

Examples of compounds containing tantalum include tetrabutoxytantalum(IV), pentabutoxytantalum(V), and pentaethoxytantalum(V).

Examples of compounds containing tungsten include tetrabutoxytungsten(IV), pentabutoxytungsten(V), pentamethoxytungsten(V), hexabutoxytungsten(VI), hexaethoxytungsten(VI), and dichlorobis(cyclopentadienyl)tungsten(IV).

Examples of compounds containing iron include iron chloride(III).

Examples of compounds containing ruthenium include diacetato[(S)-(-)-2,2'-bis(diphenylphosphino)-1,1'-binaphthyl]ruthenium(II).

Examples of compounds containing cobalt include dichloro[ethylenebis(diphenylphosphine)]cobalt(II).

Examples of compounds containing zinc include diisopropoxyzinc(II) and zinc(II) acetate.

Examples of compounds containing aluminum include diisopropoxyethylacetoacetatealuminum(III) and aluminum(III) acetate.

Examples of compounds containing indium include indium(III) acetate and triisopropoxyindium(III).

Examples of compounds containing tin include tetraethyldiacetoxy stannoxane, tetrabutoxytin(IV), tetraisopropoxytin(IV), and t-butyltris(diethylamide)tin(IV).

Examples of compounds containing germanium include tetraisopropoxygermanium(IV).

At the time of the synthesis reaction of the compound for forming a metal-containing film, a compound that may become a monodentate ligand or a polydentate ligand (hereinafter, compound (c) for forming a ligand) in the compound for forming a metal-containing film can be contained besides the metal compound (a).

Examples of the compound (c) for forming a ligand include compounds, such as organic compounds derived from a hydroxo ligand, a carboxy ligand, an amido ligand, an amine ligand, an ammonia ligand, an olefin ligand, etc. and organic compounds derived from a ligand derived from a hydroxy acid ester, a ligand derived from a β-diketone, a ligand derived from a β-keto ester, a ligand derived from an α,α-dicarboxylic acid ester, etc., given as examples of the L in the general formula (1). Examples also include compounds having multiple hydroxy groups etc.

For example, on the occasion of the synthesis reaction of the metal compound (A-1), it is possible to add an organic compound having 1 to 30 carbon atoms and containing at least one crosslinking group represented by the following general formulae (c-1) to (c-13).

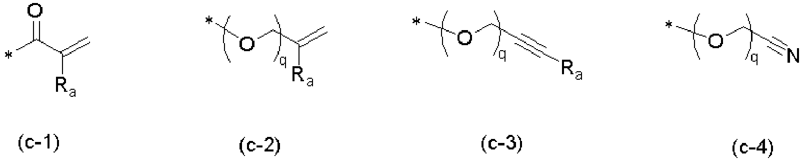

In the formulae, Rₐ represents hydrogen or a monovalent organic group having 1 to 10 carbon atoms; "q" represents 0 or 1; and "*" represents an attachment point.

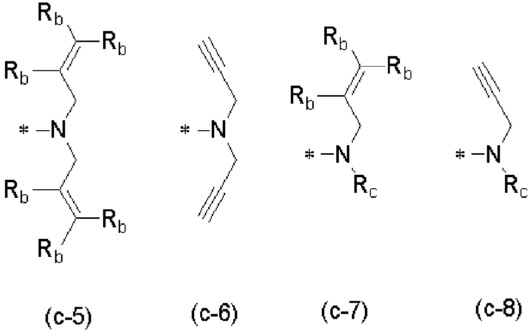

In the formulae, R_{b} represents a hydrogen atom or a methyl group and may be identical to or different from each other in a single formula; R_{c} represents hydrogen, a substituted or unsubstituted, saturated or unsaturated monovalent organic group having 1 to 20 carbon atoms, a substituted or unsubstituted aryl group having 6 to 30 carbon atoms, a substituted or unsubstituted arylalkyl group having 7 to 31 carbon atoms; and "*" represents an attachment point.

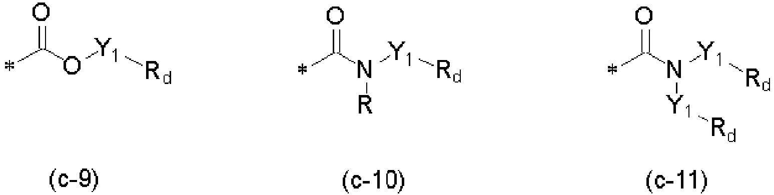

In the formulae, Y₁ represents a divalent organic group having 1 to 20 carbon atoms; R represents a hydrogen atom, a substituted or unsubstituted, saturated divalent organic group having 1 to 20 carbon atoms, a substituted or unsubstituted, unsaturated divalent organic group having 2 to 20 carbon atoms, a substituted or unsubstituted aryl group having 6 to 30 carbon atoms, a substituted or unsubstituted arylalkyl group having 7 to 31 carbon atoms; R_{d} represents an organic group that is represented by the following general formula (d-1) and whose protecting group is removed by the action of an acid, heat, or both to generate one or more hydroxy groups or carboxy groups; and "*" represents an attachment point.

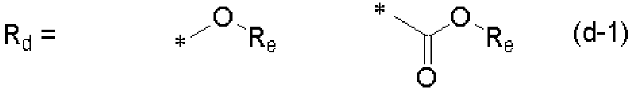

In the formulae, Rₑ represents an organic group whose protecting group is removed by the action of an acid, heat, or both; and "*" represents an attachment point to Y₁.

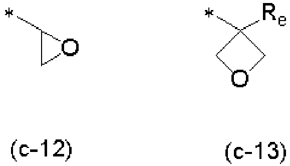

In the formulae, R_{d} represents a hydrogen atom or an organic group having 1 to 10 carbon atoms; and "*" represents an attachment point.

When the compound for forming a metal-containing film contains at least one crosslinking group represented by any of the general formulae (c-1) to (c-13), the thermosetting property of the metal compound can be enhanced. Since the heat resistance of the metal compound can be enhanced by organic crosslinking between ligands, reaction with a crosslinking agent during baking can be further promoted.

Examples of the compounds having multiple hydroxy groups include compounds obtained by an action on a dihydric or trihydric alcohol represented by the following formula (c-14).

R^{2A}(OH)ₘ (c-1 4)

In the formula, "m" represents 2 or 3. When "m" is 2, R^{2A} represents a divalent group selected from a substituted or unsubstituted, linear, branched, or cyclic, alkylene group, alkenylene group, alkynylene group, and aralkylene group, having 2 to 20 carbon atoms and optionally containing an ester bond or an ether bond. When "m" is 3, R^{2A} represents a trivalent group, being obtained by removing one hydrogen atom from the divalent group.

Specific examples of the monovalent organic group R^{1A} in the general formula (A-1) include a methyl group, an ethyl group, an n-propyl group, an isopropyl group, an n-butyl group, an isobutyl group, a sec-butyl group, a tert-butyl group, an n-pentyl group, an isopentyl group, a sec-pentyl group, a tert-pentyl group, a neopentyl group, an n-hexyl group, an n-heptyl group, an n-octyl group, an n-nonyl group, and an n-decyl group.

Specific examples of the dihydric or trihydric alcohol represented by the general formula (c-14) are shown below.

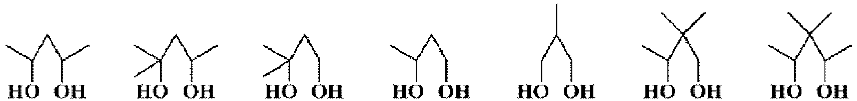

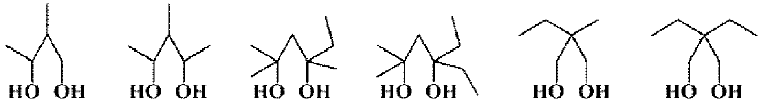

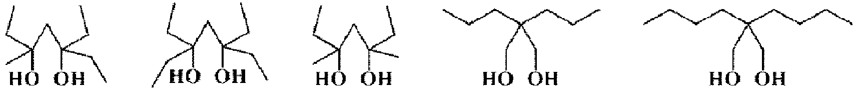

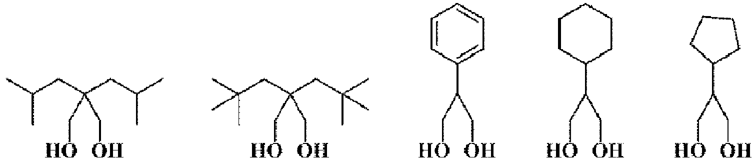

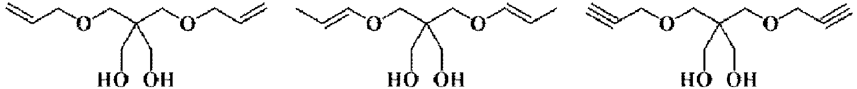

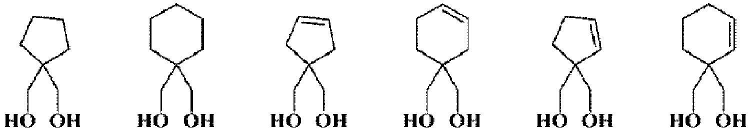

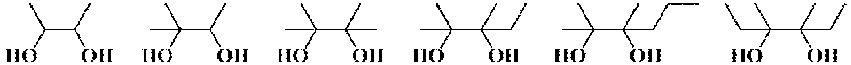

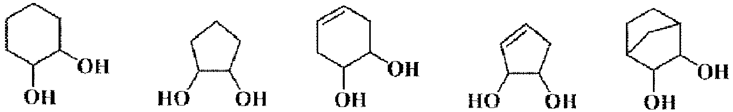

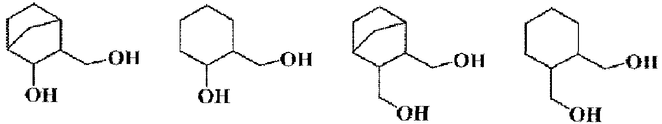

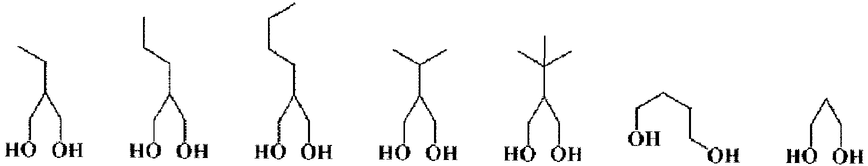

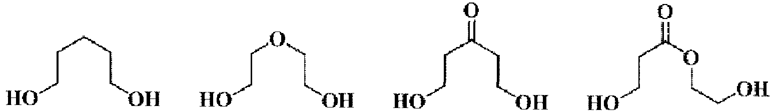

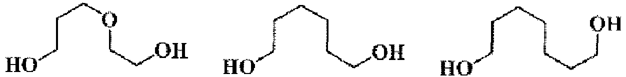

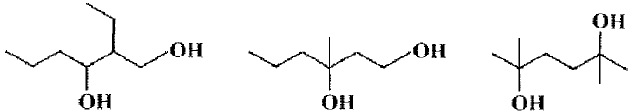

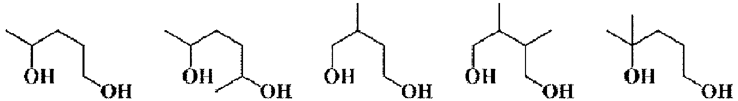

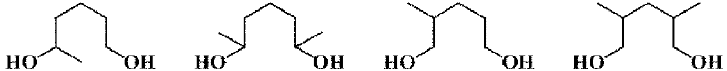

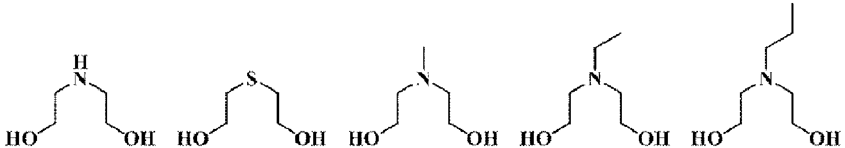

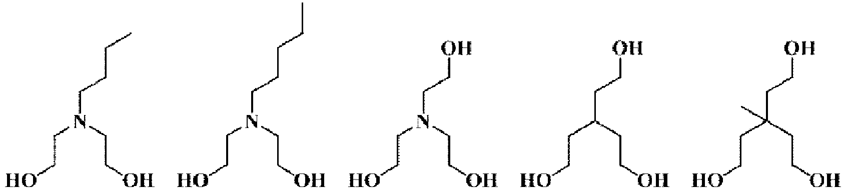

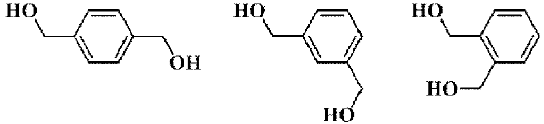

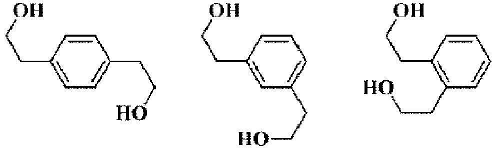

From the viewpoints of the productivity and stability of the compound for forming a metal-containing film, the compound (c) for forming a ligand is preferably a compound derived from a carboxy ligand, a compound derived from a ligand derived from β-diketone, or a compound having multiple hydroxy groups. One of these compounds may be used, or two or more thereof may be used in combination.

In the metal compound (A-1), the contained amount of the ligand derived from the compound (c) for forming a ligand is preferably 5 mol% to 95 mol%, more preferably 10 mol% to 90 mol%, and further preferably 15 mol% to 85 mol% of the total amount of ligands coordinated to metal atoms and hydrolysable groups.

Furthermore, on the occasion of the synthesis reaction of the metal compound (A-1), a silicon-containing compound (d) may be added besides the compound (c) for forming a ligand.

By substituting a hydrolysable group of the metal-containing compound (a) with the silicon-containing compound, it is possible to enhance the stability of the metal compound (A-1) in the composition for forming a metal-containing film.

Examples of the silicon-containing compound include a structure of the following formula (2).

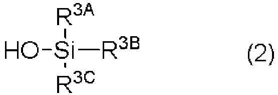

In the formula, R^{3A}, R^{3B}, and R^{3C} each represent any organic group selected from an organic group having 2 to 30 carbon atoms and having any crosslinking group of structures represented by the following general formulae (d-1) to (d-3), a substituted or unsubstituted alkyl group having 1 to 20 carbon atoms, and an aryl group having 6 to 20 carbon atoms.

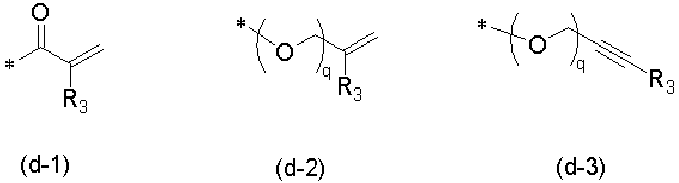

In the formulae, R₃ represents a hydrogen atom or a monovalent organic group having 1 to 10 carbon atoms; "q" represents 0 or 1; and "*" represents an attachment point.

The silicon-containing compound is preferably any compound of the following formulae, and from the viewpoint of productivity, trimethylsilanol is more preferable.

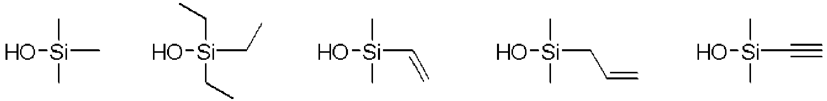

In the metal compound (A-1), the contained amount of the ligand derived from the silicon-containing compound (d) is preferably 5 mol% to 95 mol%, more preferably 10 mol% to 90 mol%, and further preferably 15 mol% to 85 mol% of the total amount of ligands coordinated to metal atoms and hydrolysable groups.

The method for synthesizing the metal compound (A-1) is not particularly limited. For example, a metal alkoxide, a metal carboxylate, or a metal acetylacetonate (acac) can be used as the metal-containing compound (a), and the metal compound can be obtained by allowing the alkoxy, carboxy, or acac metal to react with the ligand derived from the compound (c) for forming a ligand. The metal-containing compound (a) may be subjected to hydrolysis condensation and then the product may be allowed to react with the ligand derived from the compound (c) for forming a ligand, or the metal-containing compound (a) may be allowed to react with the ligand derived from the compound (c) for forming a ligand and then the product may be subjected to hydrolysis condensation. If it is difficult to control the hydrolysis condensation, the reaction with the ligand derived from the compound (c) for forming a ligand may be performed in a non-hydrous environment. The methods are preferably adjusted appropriately in accordance with the properties required in the metal compound (A-1) and the metal-containing film. When the silicon-containing compound (d) and the compound (c) for forming a ligand are to be contained as ligands, it is preferable to allow the metal-containing compound (a) and the silicon-containing compound (d) to react and then allow the product to react with the ligand derived from the compound (c) for forming a ligand.

As a method for performing a hydrolysis condensation reaction using the metal-containing compound (a), examples include a method of subjecting the metal-containing compound (a) to a hydrolysis condensation reaction in a solvent containing water. In this case, another compound having a hydrolysable group may be added as necessary. In addition, as a catalyst for the hydrolysis condensation reaction, an acid, such as acetic acid, may be added. The lower limit of the amount of water used in this hydrolysis condensation reaction is preferably 0.2-fold, more preferably 1-fold, and further preferably 3-fold, relative to the hydrolysable groups contained in the metal-containing compound (a) etc., on the molar basis. The upper limit of the amount of the water is preferably 20-fold, more preferably 15-fold, and further preferably 10-fold on the molar basis.

The solvent used in the synthesis reaction of the metal compound (A-1) is not particularly limited, and for example, a solvent given as an example of the solvent (B) described later can be used. Typical solvents and solvent mixtures contain an ester, ether, or alcohol functional group, and examples thereof include a mixture of propylene glycol monomethyl ether acetate (PGMEA) and propylene glycol monomethyl ether (PGME) at a ratio of 70/30 by volume. Examples of other solvents that can be used include butanediol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monobutyl ether, 1-butanol, 2-butanol, 2-methyl-1-propanol, 4-methyl-2-pentanol, acetone, tetrahydrofuran, toluene, hexane, ethyl acetate, cyclohexanone, methyl amyl ketone, propylene glycol dimethyl ether, diethylene glycol dimethyl ether, diamyl ether, isoamyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono-t-butyl ether acetate, γ-butyrolactone, methyl isobutyl ketone, cyclopentyl methyl ether, etc.

### ((A-2) Metallic Salt)

The metallic salt (A-2) is preferably a carboxylate having a valency of 1 to 4 and having 1 to 20 carbon atoms.

A composition for forming a metal-containing film containing such a metallic salt (A-2) makes it possible to form a metal-containing film having excellent dry etching resistance. The metallic salt is also preferable from the viewpoints of solvent solubility and the availability of raw materials.

A composition for forming a metal-containing film in which the metallic salt (A-2) has a structure represented by the following formula (3) is preferable.

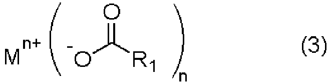

In the formula, M represents a metal atom; R₁ represents a monovalent organic group having 1 to 20 carbon atoms; and "n" represents an integer of 1 to 4.

Examples of preferable carboxylates include the following.

Ti⁴⁺(R¹COO⁻)₄ Ti⁴⁺(R²(COO⁻)₂)₂ Ti⁴⁺R⁴(COO⁻)₄

Cr²⁺(R¹COO⁻)₂ Cᵣ²⁺R²(COO⁻)₂

Cr³⁺(R¹COO⁻)₃ (Cr³⁺)₂(_{R}²(COO⁻)₂)₃ Cr₃³⁺(R¹COO⁻)(OH)₂ (Cr³⁺)₂(R³COO⁻)₆

Mn²⁺(R¹COO⁻)₂ Mn²⁺R²(COO⁻)₂ Mn³⁺(R¹COO⁻)₃ (Mn³⁺)₂(R²(COO⁻)₂)₃

Fe²⁺(R²COO⁻)₂ Fe³⁺(R¹COO⁻)₃ (Fe³⁺)₂(R²(COO⁻)₂)₃ Fe³⁺R³(COO⁻)₃ Fe²⁺(R¹COO⁻)

Co²⁺(R¹COO⁻)₂ Co²⁺R²(COO⁻)₂

Ni²⁺(R¹COO⁻)₂ Ni²⁺R²(COO⁻)₂

Cu⁺R¹COO⁻ (Cu⁺)₂R²(COO⁻)₂ Cu²⁺(R¹COO⁻)₂ Cu²⁺R²(COO⁻)₂

Zn⁺R¹COO⁻ (Zn⁺)₂R²(COO⁻)₂ Zn²⁺(R¹COO⁻)₂

Zr⁴⁺(R¹COO⁻)₄ Zr⁴⁺(R²(COO⁻)₂)₂ Zr⁴⁺R⁴(COO⁻)₄

In³⁺(R¹COO⁻)₃ (In³⁺)₂(R²(COO⁻)₂)₃ In³⁺R³(COO⁻)₃,

Sn²⁺(R¹COO⁻)₂ Sn²⁺R²(COO⁻)₂ Sn⁴⁺(R¹COO⁻)₄ Sn⁴⁺(R²(COO⁻)₂)₂ Sn⁴⁺R⁴(COO⁻)₄

Hf⁴⁺(R¹COO⁻)₄ Hf⁴⁺(R²(COO⁻)₂)₂ Hf⁴⁺R⁴(COO⁻)₄

Bi³⁺(R¹COO⁻)₃ (Bi³⁺)₂(R²(COO⁻)₂)₃ Bi³⁺R³(COO⁻)₃

In the formulae, R¹s are identical to or different from each other, and each represent a hydrogen atom, a linear, branched, or cyclic alkyl group having 1 to 20 carbon atoms, an alkenyl group having 2 to 20 carbon atoms, an alkynyl group having 2 to 20 carbon atoms, or an aryl group having 6 to 20 carbon atoms, the groups optionally having a hydroxy group, an ether group, an ester group, an amino group, an amide group, a sulfonic acid ester group, a halogen atom, a cyano group, a nitro group, a carbonate group, a carbamate group, a thiol group, a sulfide group, a thioketone group, or a heteroaromatic ring. R² represents a single bond, a linear, branched, or cyclic alkylene group, alkenylene group, or alkynylene group having 1 to 20 carbon atoms, or an arylene group having 6 to 20 carbon atoms, the groups optionally having a hydroxy group, an ether group, an ester group, an amino group, an amide group, a sulfonic acid ester group, a halogen atom, a cyano group, a nitro group, a carbonate group, a carbamate group, a thiol group, a sulfide group, a thioketone group, or a heteroaromatic ring. R³ and R⁴ each represent a group obtained by substituting one or two hydrogen atoms of the alkylene group, arylene group, alkenylene group, or alkynylene group of R² with one or two carboxy groups.

Specific examples of carboxylate ions for forming the carboxylates in the general formulae include the following.

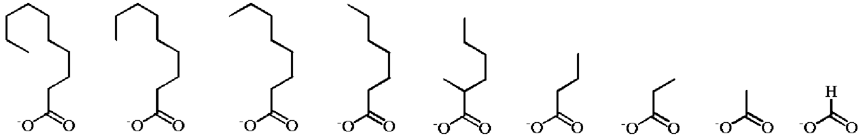

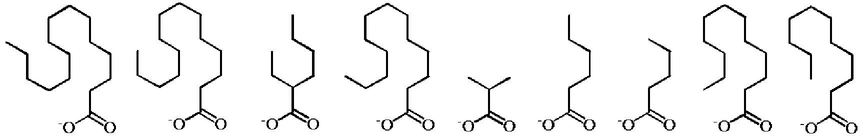

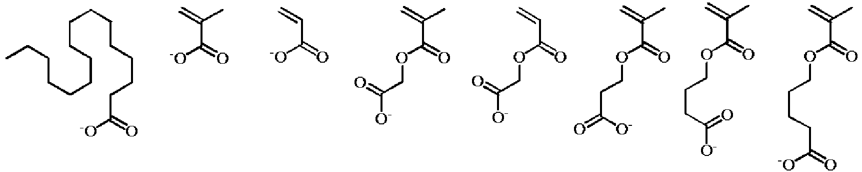

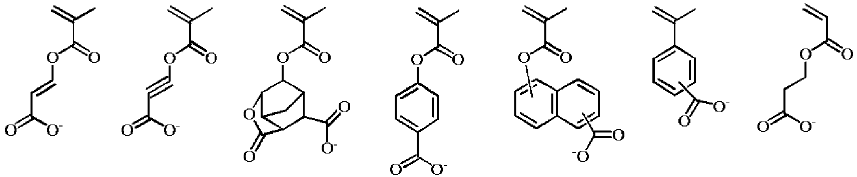

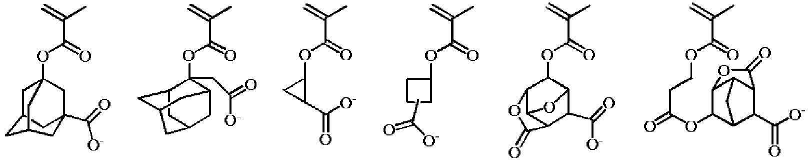

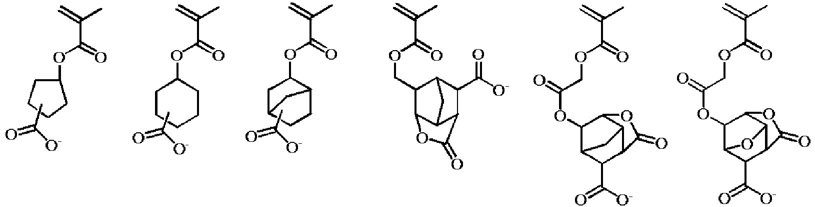

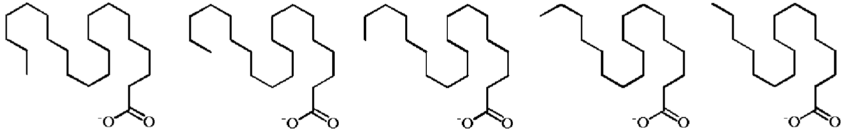

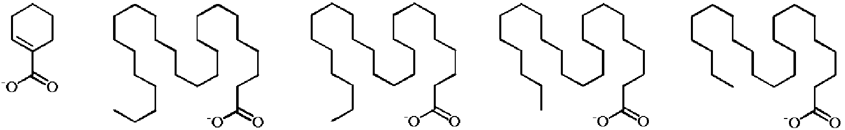

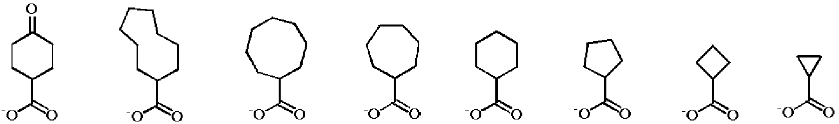

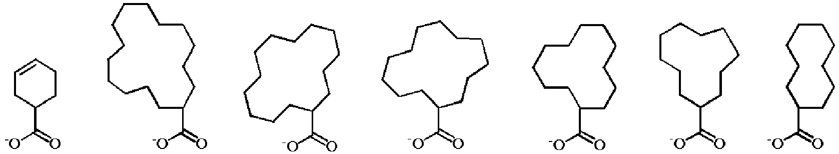

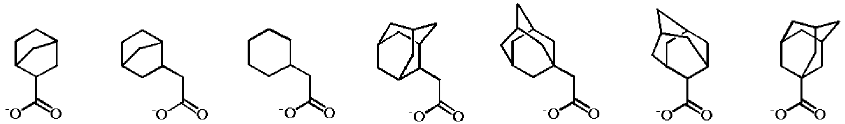

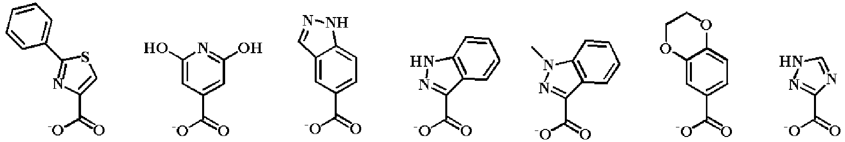

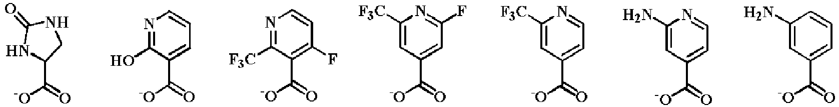

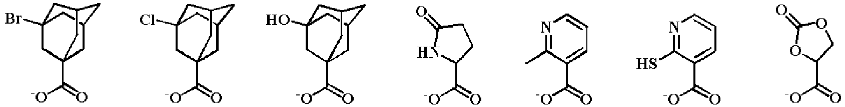

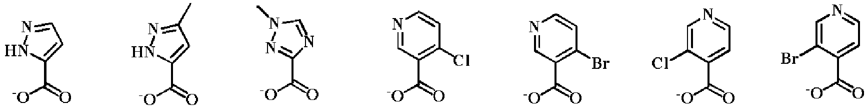

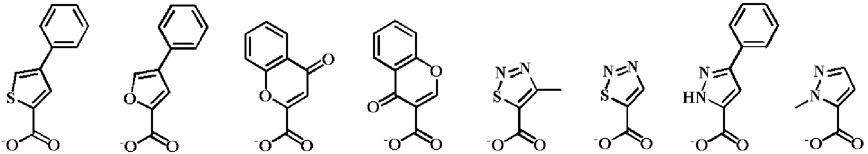

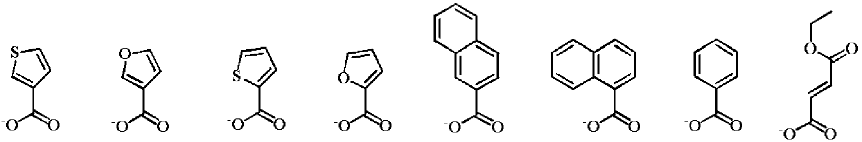

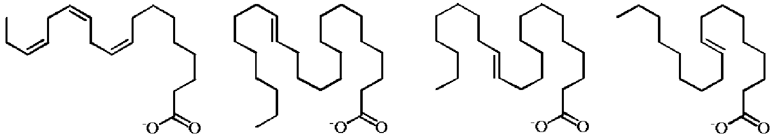

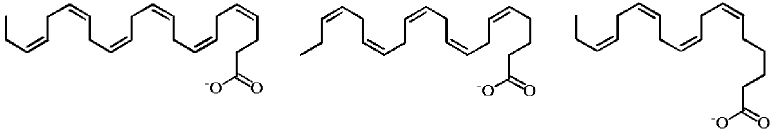

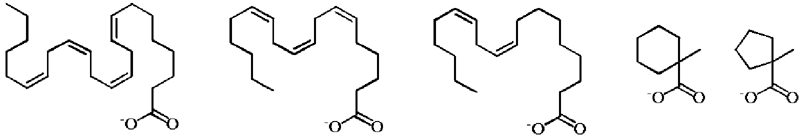

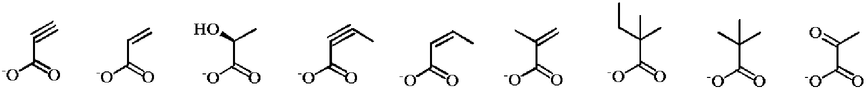

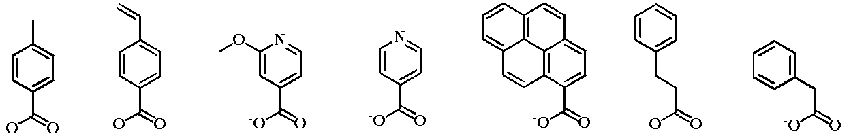

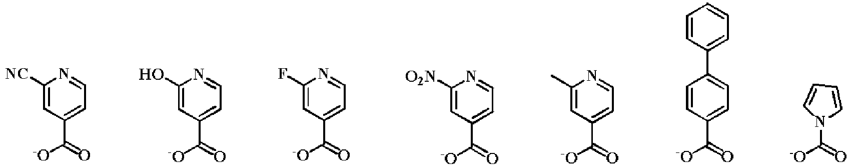

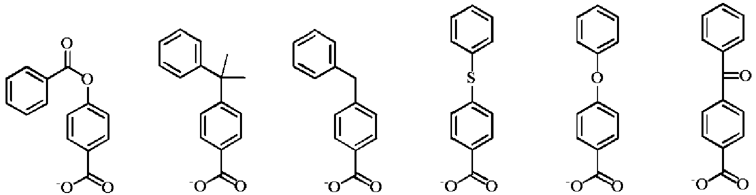

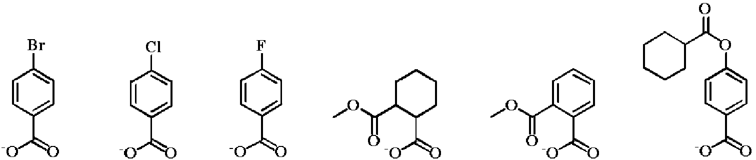

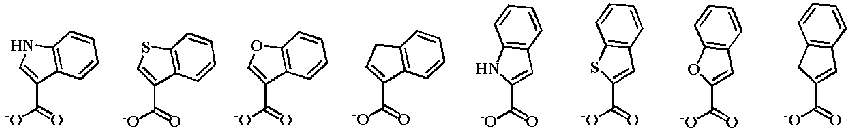

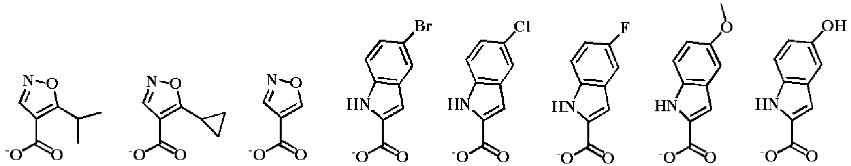

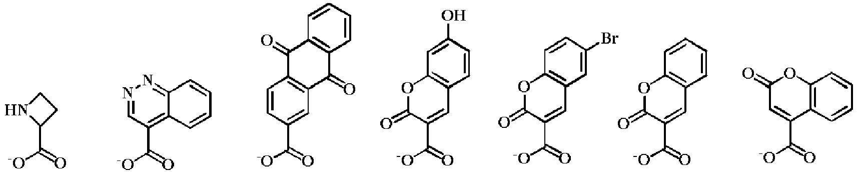

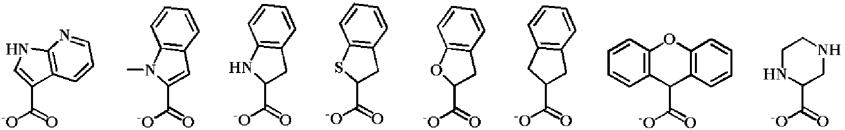

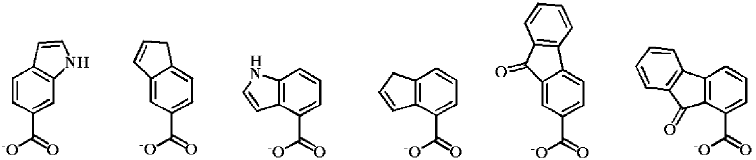

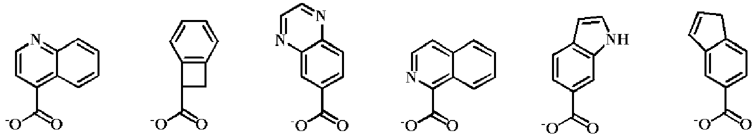

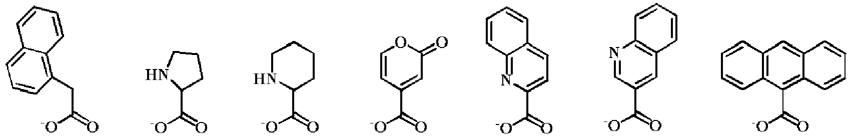

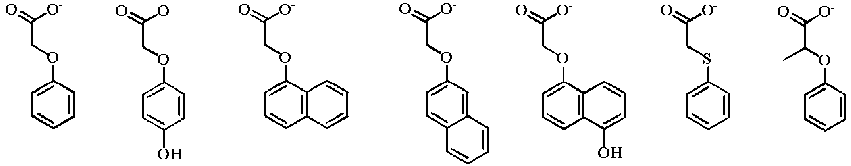

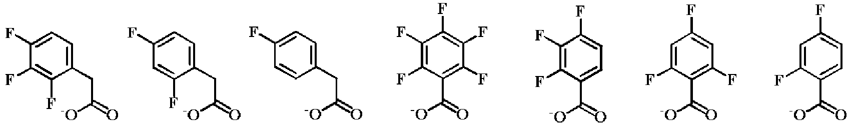

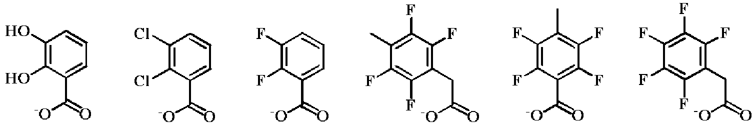

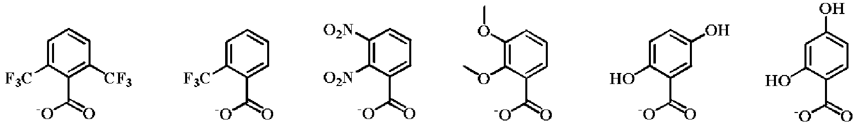

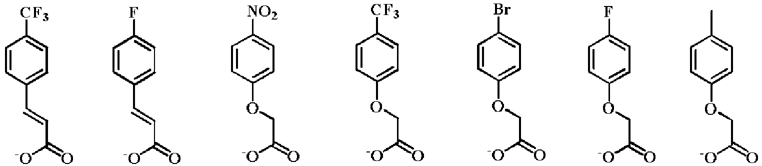

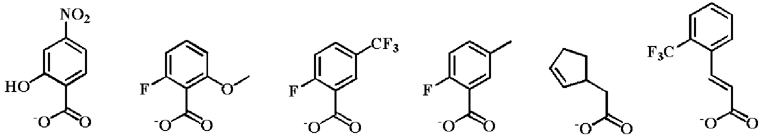

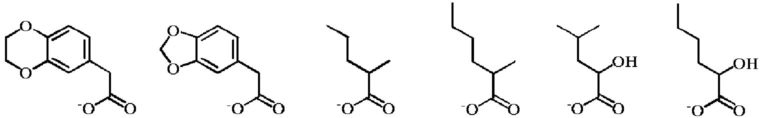

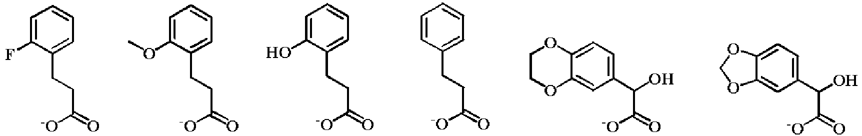

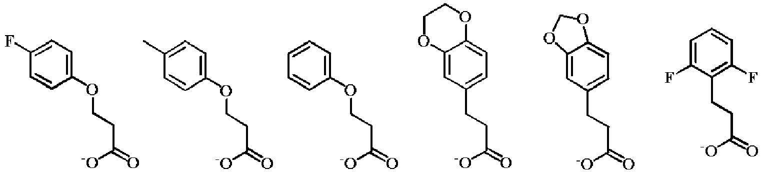

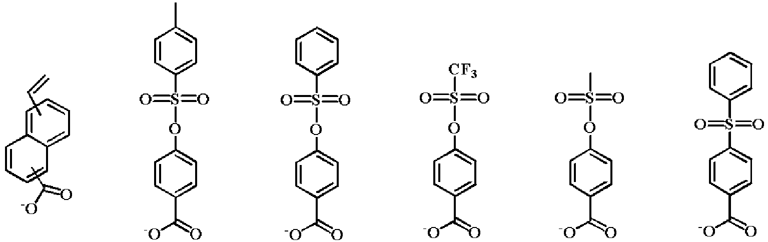

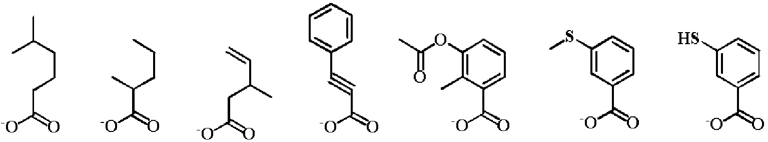

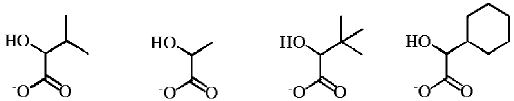

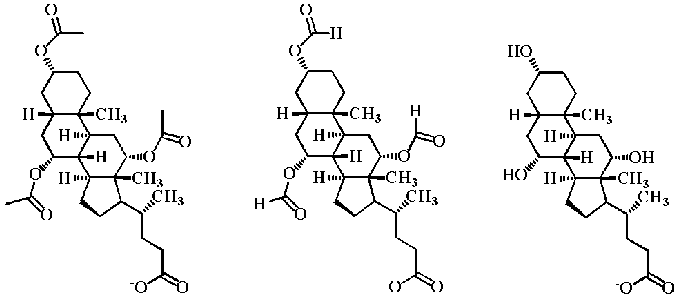

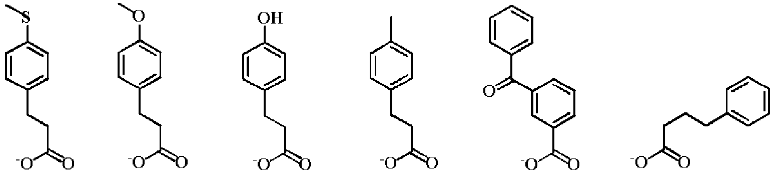

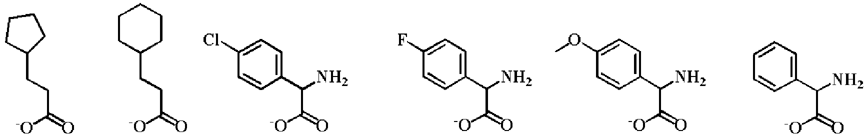

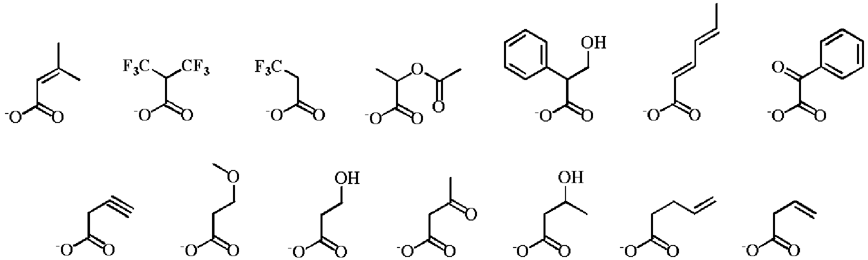

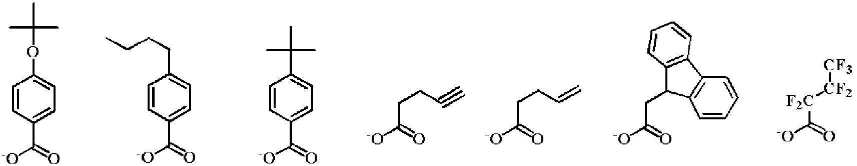

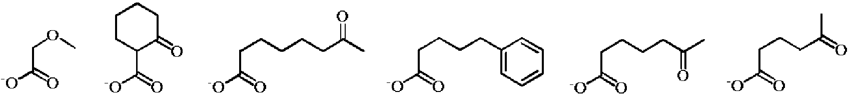

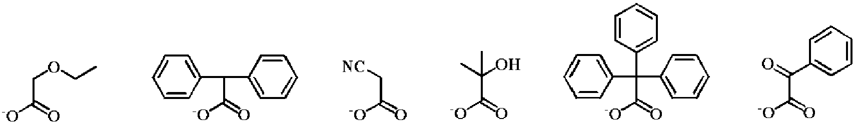

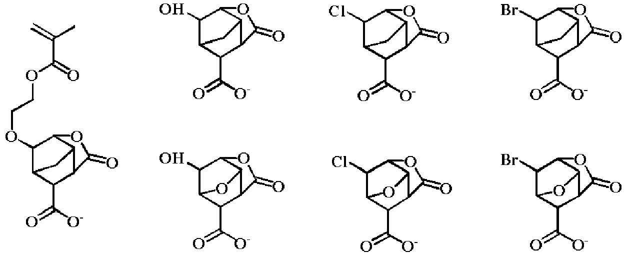

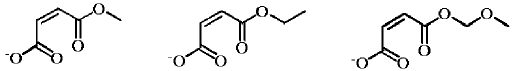

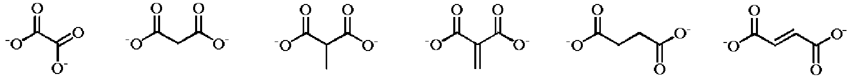

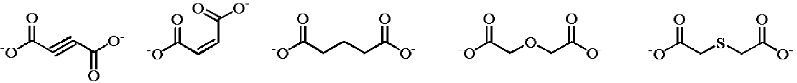

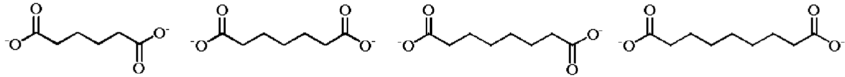

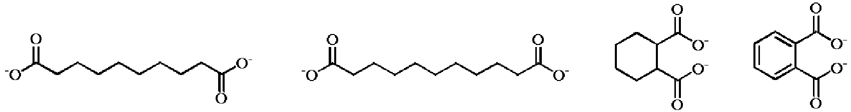

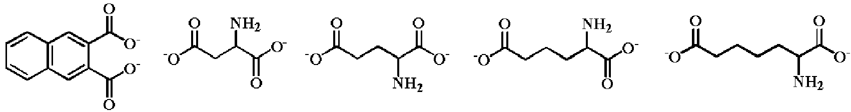

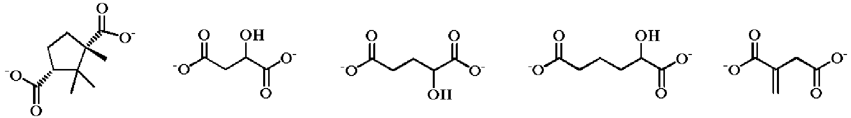

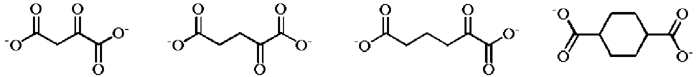

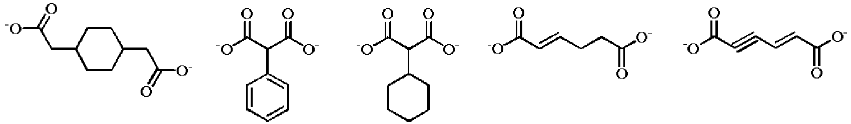

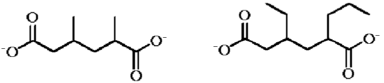

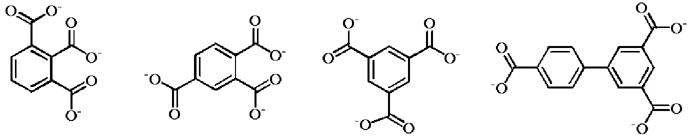

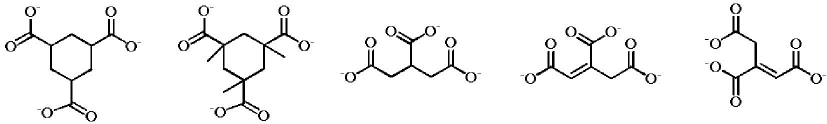

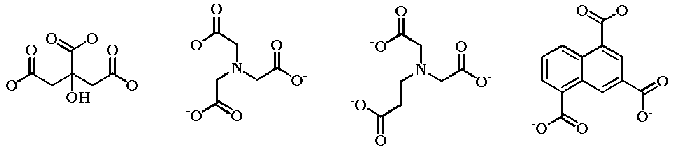

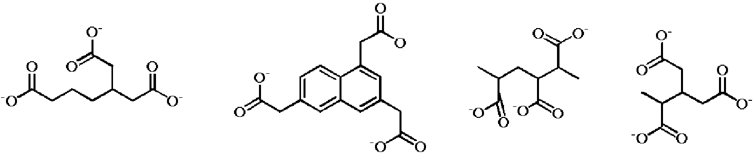

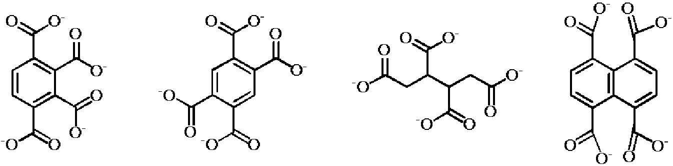

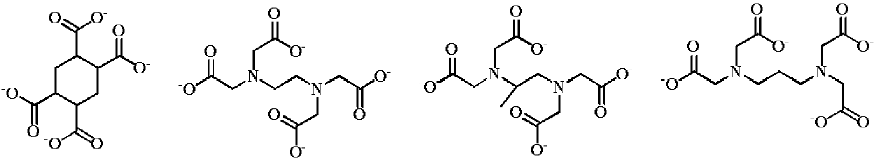

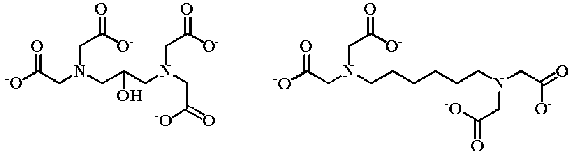

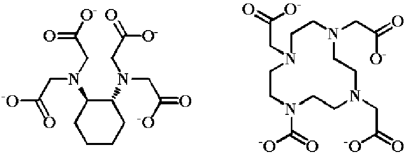

Among the carboxylate ions for forming a carboxylate, an ion in which the number of carbon atoms in the carboxylic acid is greater dissolves more easily in an organic solvent, and is preferable. In addition, the greater the number of carbon atoms in the carboxylic acid, the greater the amount of outgas components when the composition for forming a metal-containing film is applied by spin-coating. From such viewpoints, the carboxylate ion is more preferably a linear or branched alkyl group having 3 to 10 carbon atoms.

### <(B) Solvent>

The solvent (B) usable in the composition for forming a metal-containing film is not particularly limited as long as the solvent is capable of dissolving the metal source (A), and when contained, (C) a crosslinking agent, (D) an acid generator, (E) a basic compound, (F) a surfactant, (G) a flowability accelerator, (H) a curing accelerator, other additives, etc. described later.

Specifically, for example, an organic solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The solvent is preferably contained in an amount of 200 to 10,000 parts by mass, more preferably 250 to 5,000 parts by mass relative to 100 parts by mass of the metal source (A).

### <(B1) High-Boiling-Point Solvent>

The composition for forming a metal-containing film may contain (B1) a high-boiling-point solvent as the solvent (B).

As the high-boiling-point solvent (B1), one or more kinds of organic solvent having a boiling point of 180°C or higher may be used.

For example, it is possible to use, as the solvent (B), a mixture of one or more kinds of organic solvent having a boiling point of lower than 180°C and one or more kinds of organic solvent having a boiling point of 180°C or higher (high-boiling-point solvent (B1)).

The high-boiling-point solvent (B1) is not particularly limited to hydrocarbons, alcohols, ketones, esters, ethers, or chlorine-based solvents, as long as the solvent is capable of dissolving the components of the composition for forming a metal-containing film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (B1) may be selected suitably from the solvents above, for example, depending on the temperature at which the composition for forming a metal-containing film is heat-treated, etc. The boiling point of the high-boiling-point solvent is preferably 180°C to 300°C, further preferably 200°C to 300°C. When the boiling point is as described, there is no risk of the evaporation rate at the baking (heating) being excessively fast, and therefore, it is possible to suppress the generation of dryness-induced defects at the time of film formation. Moreover, there is no risk of a solvent having such a boiling point remaining in the film without evaporating after the baking. Therefore, there is no risk of the solvent adversely affecting the physical properties, such as etching resistance, of the film.

Furthermore, when the high-boiling-point solvent (B1) is used, the contained amount is preferably 1 to 30 parts by mass per 100 parts by mass of the organic solvent having a boiling point lower than 180°C. When the contained amount is as described, sufficient thermal flowability can be imparted at the time of baking and the solvent does not remain in the film and cause degradation in the physical properties, such as etching resistance, of the film. Therefore, such an amount is preferable.

### <Other Components>

When the composition for forming a metal-containing film is usable for a resist underlayer film used in a multilayer resist method, the composition may contain at least one kind of metal source (A) and a solvent (B), and may contain at least one of (C) a crosslinking agent, (D) an acid generator, (E) a basic compound, (F) a surfactant, (G) a flowability accelerator, and (H) a curing accelerator as necessary.

In the following, components other than the metal source (A) and the solvent (B) that may be contained in the composition for forming a metal-containing film will be described.

### [(C) Crosslinking Agent]

A crosslinking agent (C) may be added to the composition of the present invention for forming a metal-containing film to increase curability and further inhibit intermixing with a resist upper layer film. The crosslinking agent is not particularly limited, and various known crosslinking agents can be widely used. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. One kind of the crosslinking agent (C) can be used, or two or more kinds thereof can be used in combination, and when the crosslinking agent is added, the added amount is preferably 5 to 50 parts by mass, more preferably 10 to 40 parts by mass based on 100 parts by mass of the metal source (A). When the added amount is 5 parts by mass or more, sufficient curability can be exhibited, and intermixing with a resist upper layer film can be suppressed. Meanwhile, when the added amount is 50 parts by mass or less, there is no risk of degradation in dry etching resistance due to the proportion of the metal source (A) in the composition being low.

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agents include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis(4,5-diphenyl-2-oxazoline), 2,2'-methylene bis(4-phenyl-2-oxazoline), 2,2'-methylene bis(4-tert-butyl-2-oxazoline), 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the phenol-based crosslinking agents include compounds represented by the following general formula (10).

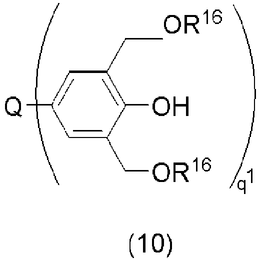

In the formula, Q represents a single bond or a q¹-valent hydrocarbon group having 1 to 20 carbon atoms. R¹⁶ represents a hydrogen atom or an alkyl group having 1 to 20 carbon atoms. "q¹" represents an integer of 1 to 5.

Q represents a single bond or a q¹-valent hydrocarbon group having 1 to 20 carbon atoms. "q¹" represents an integer of 1 to 5, more preferably 2 or 3. Specific examples of Q include groups obtained by removing "q¹" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R¹⁶ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. A hydrogen atom or a methyl group is preferable.

### <(D) Acid Generator>

An acid generator can be added to the composition for forming a metal-containing film in order to promote further the curing reaction of the metal source (A). Acid generators can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator can be used, or two or more kinds thereof can be used in combination. When the acid generator is added, the added amount is preferably 0.05 to 50 parts by mass, more preferably 0.1 to 10 parts by mass based on 100 parts by mass of the metal source (A).

### (Photo-Acid Generator)

When the above-described metal-containing film is used as a resist film, a photo-acid generator can be added to the composition for forming a metal-containing film as described above. By adding a photo-acid generator, sensitivity can be enhanced. It is assumed that higher sensitivity is achieved by an acid generated from the photo-acid generator being coordinated to metal, causing decrease in solubility in an organic solvent developer in portions irradiated with a high-energy beam, or by the acid promoting (partial) hydrolysis of metal alkoxide.

The photo-acid generator may be any compound as long as the compound generates an acid upon high-energy beam irradiation. Examples thereof include sulfonium salt, iodonium salt, sulfonyldiazomethane, N-sulfonyloxyimide, and oxime-O-sulfonate type photo-acid generators. Further specific examples include compounds disclosed in paragraphs [0122] to [0142] of JP2008-111103A.

Preferable photo-acid generators are onium salt compounds that have a sulfonium cation represented by the following general formula (D-1) or an iodonium cation represented by the following general formula (D-2) and that generate a sulfonic acid or a carboxylic acid by the action of light.

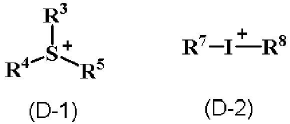

In the formulae, R³, R⁴, and R⁵ each independently represent a substituted or unsubstituted, linear, branched, or cyclic, alkyl group, alkenyl group, or oxoalkyl group having 1 to 10 carbon atoms or represent a substituted or unsubstituted aryl group, aralkyl group, or aryloxoalkyl group having 6 to 18 carbon atoms. Furthermore, any two or more of R³, R⁴, and R⁵ may be bonded to each other to form a ring together with the sulfur atom in the formula. R⁷ and R⁸ each independently represent a substituted or unsubstituted aryl group having 6 to 18 carbon atoms.

An onium salt compound having a cation represented by the general formula (D-1) or (D-2) has high thermal stability, and has high photosensitivity to high-energy beams. Specific examples of such cation structures are given below, but are not limited thereto.

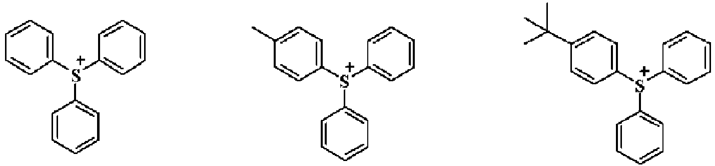

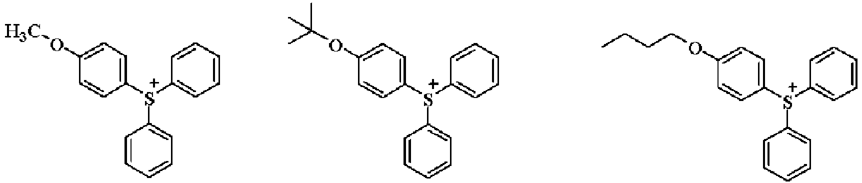

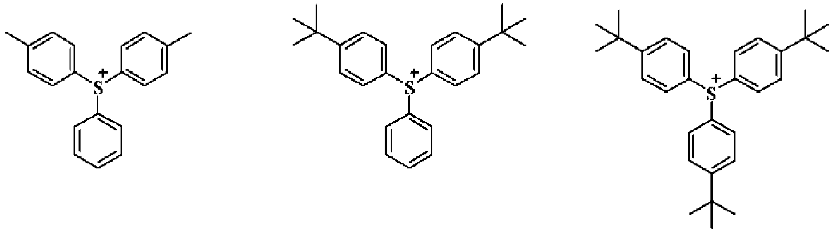

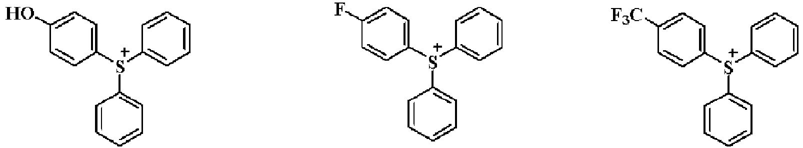

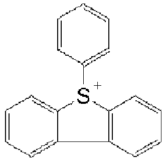

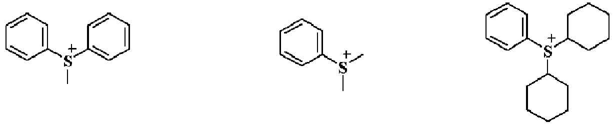

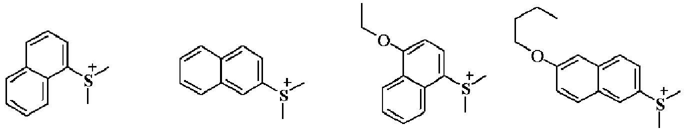

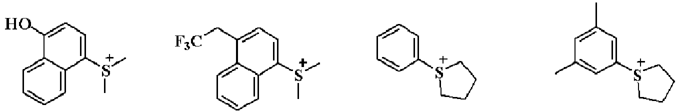

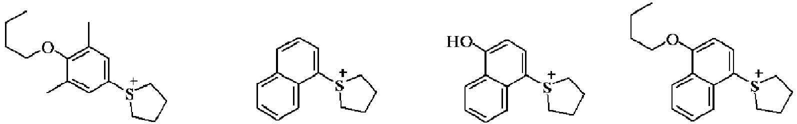

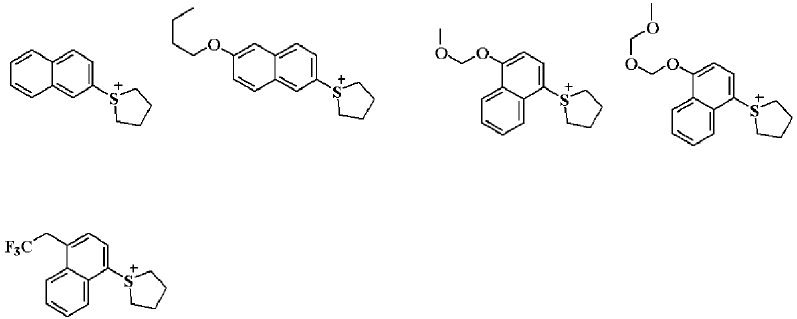

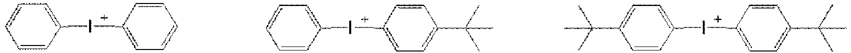

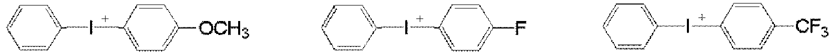

Meanwhile, the anion of the photo-acid generator used in the present invention is preferably a sulfonate anion or a carboxylate anion, and in this case, these anions receive a proton by the action of light, and a sulfonic acid or a carboxylic acid is generated. A particularly preferable acid to be generated is a carboxylic acid represented by the following general (D-3) or (D-4). 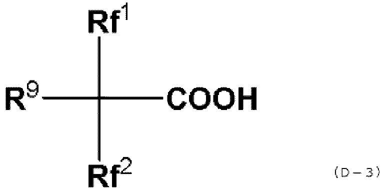 In the formula, R⁹ represents a linear, branched, or cyclic, alkyl group, alkenyl group, or oxoalkyl group having 5 to 20 carbon atoms or represent an aryl group, aralkyl group, or aryloxoalkyl group having 6 to 20 carbon atoms, the groups optionally containing an ester bond or an ether bond, and one or more of the hydrogen atoms of the groups optionally being substituted with a halogen atom, a hydroxy group, a carboxy group, or an amino group. R⁹ may also be a hydroxy group. Rf¹ and Rf² each independently represent a fluorine atom or a trifluoromethyl group. 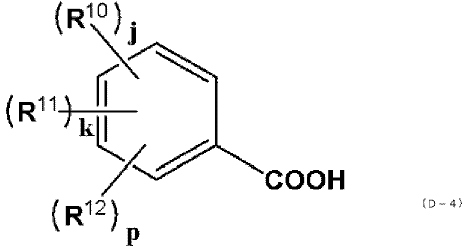 In the formula, R¹⁰ to R¹² each independently represent a halogen atom, a hydroxy group, a carboxy group, or a substituted or unsubstituted, linear, branched, or cyclic, alkyl group, alkenyl group, alkoxy group, alkoxycarbonyl group, or alkylcarbonyloxy group having 1 to 10 carbon atoms; and "j", "k", and "p" each independently represent 0 to 5, provided that j+k+p ≤ 5.

Specific examples of the carboxylic acid represented by the general formula (D-3) include the following, but are not limited thereto.

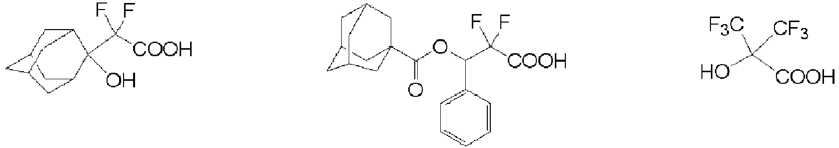

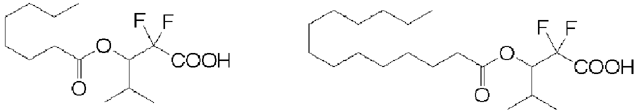

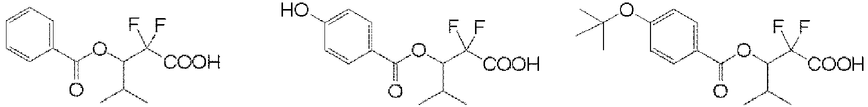

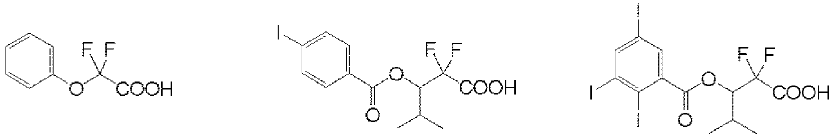

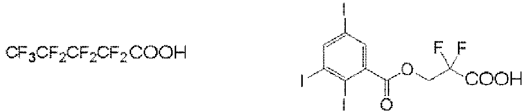

Next, specific examples of the carboxylic acid represented by the general formula (D-4) are given below, but are not limited thereto.

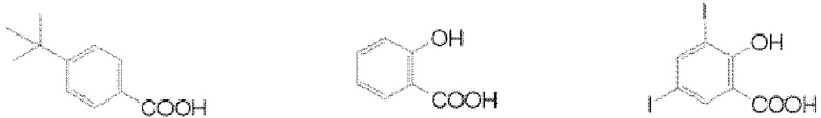

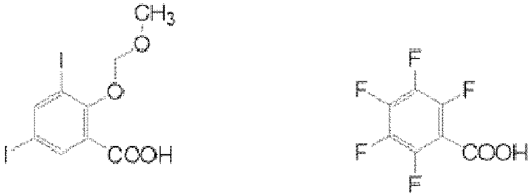

The type of the sulfonic acid to be generated is not particularly limited, but examples include compounds obtained by changing the -COOH to -SO₃H in the general formulae (D-3) and (D-4) and the specific examples given above.

The component (D) photo-acid generator contained in the composition of the present invention for forming a metal-containing film is preferably contained in an amount of 0.5 to 30 parts by mass, particularly preferably 1 to 15 parts by mass based on 100 parts by mass of the component (A).

### ((E) Basic Compound)

When the metal-containing film is used as a resist film, a basic compound can further be added to the composition for forming a metal-containing film. A basic compound indicates a compound that has basicity for neutralizing the acid generated from the photo-acid generator. A basic compound can adjust sensitivity, and is also effective for preventing the insolubilization of a resist film in unexposed regions and low-exposure regions and suppressing the generation of residues.

Preferable basic compounds are nitrogen-containing compounds (nitrogen-containing organic compounds), and specific examples include primary, secondary, or tertiary aliphatic amines, mixed amines, aromatic amines, heterocyclic amines, nitrogen-containing compounds having a carboxy group, nitrogen-containing compounds having a sulfonyl group, nitrogen-containing compounds having a hydroxy group, nitrogen-containing compounds having a hydroxyphenyl group, alcoholic nitrogen-containing compounds, amides, imides, and carbamates.

More specifically, examples of the primary aliphatic amines include ammonia, methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, and tetraethylenepentamine; examples of the secondary aliphatic amines include dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, and N,N-dimethyltetraethylenepentamine; and examples of the tertiary aliphatic amines include trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, and N,N,N',N'-tetramethyltetraethylenepentamine.

Examples of the mixed amines include dimethylethylamine, methylethylpropylamine, benzylamine, phenethylamine, and benzyldimethylamine. Specific examples of the aromatic amines and the heterocyclic amines include aniline derivatives (e.g., aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, N,N-dimethyltoluidine, etc.), diphenyl(p-tolyl)amine, methyldiphenylamine, triphenylamine, phenylenediamine, naphthylamine, diaminonaphthalene, pyrrole derivatives (e.g., pyrrole, 2H-pyrrole, 1-methylpyrrole, 2,4-dimethylpyrrole, 2,5-dimethylpyrrole, N-methylpyrrole, etc.), oxazole derivatives (e.g., oxazole, isoxazole, etc.), thiazole derivatives (e.g., thiazole, isothiazole, etc.), imidazole derivatives (e.g., imidazole, 4-methylimidazole, 4-methyl-2-phenylimidazole, etc.), pyrazole derivatives, furazane derivatives, pyrroline derivatives (e.g., pyrroline, 2-methyl-1-pyrroline, etc.), pyrrolidine derivatives (e.g., pyrrolidine, N-methylpyrrolidine, pyrrolidinone, N-methylpyrrolidone, etc.), imidazoline derivatives, imidazolidine derivatives, pyridine derivatives (e.g., pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 4-pyrrolidinopyridine, 2-(1-ethylpropyl)pyridine, aminopyridine, dimethylaminopyridine, etc.), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (e.g., quinoline, 3-quinoline carbonitrile, etc.), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, and uridine derivatives.

Furthermore, examples of the nitrogen-containing compounds having a carboxy group include aminobenzoic acid, indolecarboxylic acid, and amino acid derivatives (e.g., nicotinic acid, alanine, arginine, aspartic acid, glutamic acid, glycine, histidine, isoleucine, glycylleucine, leucine, methionine, phenylalanine, threonine, lysine, 3-aminopyrazine-2-carboxylic acid, and methoxyalanine); examples of the nitrogen-containing compounds having a sulfonyl group include 3-pyridine sulfonic acid and pyridinium p-toluenesulfonate; examples of the nitrogen-containing compounds having a hydroxy group, the nitrogen-containing compound having a hydroxyphenyl group, and the alcoholic nitrogen-containing compound include 2-hydroxypyridine, aminocresol, 2,4-quinolinediol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl)piperazine, 1-[2-(2-hydroxyethoxy)ethyl]piperazine, piperidineethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyeurolidine, 3-quinuclidinol, 3-tropanol, 1-methyl-2-pyrrolidineethanol, 1-aziridineethanol, N-(2-hydroxyethyl)phthalimide, and N-(2-hydroxyethyl)isonicotinamide. Examples of the amides include formamide, N-methylformamide, N,N-dimethylformamide, acetamide, N-methylacetamide, N,N-dimethylacetamide, propionamide, benzamide, and 1-cyclohexylpyrrolidone. Examples of the imides include phthalimide, succinimide, and maleimide. Examples of the carbamates include N-t-butoxycarbonyl-N,N-dicyclohexylamine, N-t-butoxycarbonylbenzimidazole, and oxazolidinone.

Furthermore, examples include the nitrogen-containing organic compound represented by the following general formula (E-1).

N(X)ₙ(Y)₃₋ₙ (E-1)

In the formula, "n" represents 1, 2, or 3. Side chains X may be identical to or different from each other, and can be represented by the following general formulae (X1) to (X3). Side chains Y are identical to or different from each other, and each represent a hydrogen atom or a linear, branched, or cyclic alkyl group having 1 to 20 carbon atoms, and optionally contains an ether group or a hydroxy group. The Xs may also be bonded to each other to form a ring.

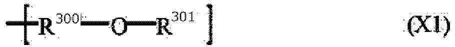

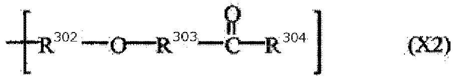

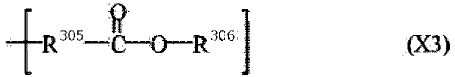

In the general formulae (X1) to (X3), R³⁰⁰, R³⁰², and R³⁰⁵ each represent a linear or branched alkylene group having 1 to 4 carbon atoms; and R³⁰¹ and R³⁰⁴ each represent a hydrogen atom or a linear, branched, or cyclic alkyl group having 1 to 20 carbon atoms, and optionally contain one or more hydroxy groups, ether groups, ester groups, or lactone rings. R³⁰³ represents a single bond or a linear or branched alkylene group having 1 to 4 carbon atoms; and R³⁰⁶ represents a linear, branched, or cyclic alkyl group having 1 to 20 carbon atoms, and optionally contains one or more hydroxy groups, ether groups, ester groups, or lactone rings.

Specific examples of the compound represented by the general formula (E-1) include tris(2-methoxymethoxyethyl)amine, tris{2-(2-methoxyethoxy)ethyl}amine, tris{2-(2-methoxyethoxymethoxy)ethyl}amine, tris{2-(1-methoxyethoxy)ethyl}amine, tris{2-(1-ethoxyethoxy)ethyl}amine, tris{2-(1-ethoxypropoxy)ethyl}amine, tris[2-{2-(2-hydroxyethoxy)ethoxy}ethyl]amine, 4,7,13,16,21,24-hexaoxa-1,10-diazabicyclo[8.8.8]hexacosane, 4,7,13,18-tetraoxa-1,10-diazabicyclo[8.5.5]eicosane, 1,4,10,13-tetraoxa-7,16-diazabicyclooctadecane, 1-aza-12-crown-4, 1-aza-15-crown-5, 1-aza-18-crown-6, tris(2-formyloxyethyl)amine, tris(2-acetoxyethyl)amine, tris(2-propionyloxyethyl)amine, tris(2-butyryloxyethyl)amine, tris(2-isobutyryloxyethyl)amine, tris(2-valeryloxyethyl)amine, tris(2-pivaloyloxyethyl)amine, N,N-bis(2-acetoxyethyl)2-(acetoxyacetoxy)ethylamine, tris(2-methoxycarbonyloxyethyl)amine, tris(2-tert-butoxycarbonyloxyethyl)amine, tris[2-(2-oxopropoxy)ethyl]amine, tris[2-(methoxycarbonylmethyl)oxyethyl]amine, tris[2-(tert-butoxycarbonylmethyloxy)ethyl]amine, tris[2-(cyclohexyloxycarbonylmethyloxy)ethyl]amine, tris(2-methoxycarbonylethyl)amine, tris(2-ethoxycarbonylethyl)amine, N,N-bis(2-hydroxyethyl)-2-(methoxycarbonyl)ethylamine, N,N-bis(2-acetoxyethyl)-2-(methoxycarbonyl)ethylamine, N,N-bis(2-hydroxyethyl)-2-(ethoxycarbonyl)ethylamine, N,N-bis(2-acetoxyethyl)-2-(ethoxycarbonyl)ethylamine, N,N-bis(2-hydroxyethyl)-2-(2-methoxyethoxycarbonyl)ethylamine, N,N-bis(2-acetoxyethyl)-2-(2-methoxyethoxycarbonyl)ethylamine, N,N-bis(2-hydroxyethyl)-2-(2-hydroxyethoxycarbonyl)ethylamine, N,N-bis(2-acetoxyethyl)-2-(2-acetoxyethoxycarbonyl)ethylamine, N,N-bis(2-hydroxyethyl)-2-[(methoxycarbonyl)methoxycarbonyl]ethylamine, N,N-bis(2-acetoxyethyl)-2-[(methoxycarbonyl)methoxycarbonyl]ethylamine, N,N-bis(2-hydroxyethyl)-2-(2-oxopropoxycarbonyl)ethylamine, N,N-bis(2-acetoxyethyl)-2-(2-oxopropoxycarbonyl)ethylamine, N,N-bis(2-hydroxyethyl)-2-(tetrahydrofurfuryloxycarbonyl)ethylamine, N,N-bis(2-acetoxyethyl)-2-(tetrahydrofurfuryloxycarbonyl)ethylamine, N,N-bis(2-hydroxyethyl)-2-[(2-oxotetrahydrofuran-3-yl)oxycarbonyl]ethylamine, N,N-bis(2-acetoxyethyl)-2-[(2-oxotetrahydrofuran-3-yl)oxycarbonyl]ethylamine, N,N-bis(2-hydroxyethyl)-2-(4-hydroxybutoxycarbonyl)ethylamine, N,N-bis(2-formyloxyethyl)-2-(4-formyloxybutoxycarbonyl)ethylamine, N,N-bis(2-formyloxyethyl)-2-(2-formyloxyethoxycarbonyl)ethylamine, N,N-bis(2-methoxyethyl)-2-(methoxycarbonyl)ethylamine, N-(2-hydroxyethyl)bis[2-(methoxycarbonyl)ethyl]amine, N-(2-acetoxyethyl)bis[2-(methoxycarbonyl)ethyl]amine, N-(2-hydroxyethyl)bis[2-(ethoxycarbonyl)ethyl]amine, N-(2-acetoxyethyl)bis[2-(ethoxycarbonyl)ethyl]amine, N-(3-hydroxy-1-propyl)bis[2-(methoxycarbonyl)ethyl]amine, N-(3-acetoxy-1-propyl)bis[2-(methoxycarbonyl)ethyl]amine, N-(2-methoxyethyl)bis[2-(methoxycarbonyl)ethyl]amine, N-butylbis[2-(methoxycarbonyl)ethyl]amine, N-butylbis[2-(2-methoxyethoxycarbonyl)ethyl]amine, N-methylbis(2-acetoxyethyl)amine, N-ethylbis(2-acetoxyethyl)amine, N-methylbis(2-pivaloyloxyethyl)amine, N-ethylbis[2-(methoxycarbonyloxy)ethyl]amine, N-ethylbis[2-(tert-butoxycarbonyloxy)ethyl]amine, tris(methoxycarbonylmethyl)amine, tris(ethoxycarbonylmethyl)amine, N-butylbis(methoxycarbonylmethyl)amine, N-hexylbis(methoxycarbonylmethyl)amine, and β-(diethylamino)-δ-valerolactone.

Furthermore, examples include nitrogen-containing organic compounds having a cyclic structure shown in the following general formula (E-2).

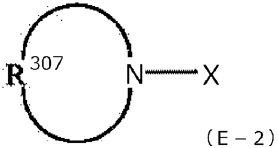

In the formula, X is as defined above; and R³⁰⁷ represents a linear or branched alkylene group having 2 to 20 carbon atoms and optionally containing one or more carbonyl groups, ether groups, ester groups, or sulfide groups.

Specific examples of the general formula (E-2) include 1-[2-(methoxymethoxy)ethyl]pyrrolidine, 1-[2-(methoxymethoxy)ethyl]piperidine, 4-[2-(methoxymethoxy)ethyl]morpholine, 1-[2-[(2-methoxyethoxy)methoxy]ethyl]pyrrolidine, 1-[2-[(2-methoxyethoxy)methoxy]ethyl]piperidine, 4-[2-[(2-methoxyethoxy)methoxy]ethyl]morpholine, 2-(1-pyrrolidinyl)ethyl acetate, 2-piperidinoethyl acetate, 2-morpholinoethyl acetate, 2-(1-pyrrolidinyl)ethyl formate, 2-piperidinoethyl propionate, 2-morpholinoethyl acetoxyacetate, 2-(1-pyrrolidinyl)ethyl methoxyacetate, 4-[2-(methoxycarbonyloxy)ethyl morpholine, 1-[2-(t-butoxycarbonyloxy)ethyl]piperidine, 4-[2-(2-methoxyethoxycarbonyloxy)ethyl]morpholine, methyl 3-(1-pyrrolidinyl)propionate, methyl 3-piperidinopropionate, methyl 3-morpholinopropionate, methyl 3-(thiomorpholino)propionate, methyl 2-methyl-3-(1-pyrrolidinyl)propionate, ethyl 3-morpholinopropionate, methoxycarbonylmethyl 3-piperidinopropionate, 2-hydroxyethyl 3-(1-pyrrolidinyl)propionate, 2-acetoxyethyl 3-morpholinopropionate, 2-oxotetrahydrofuran-3-yl 3-(1-pyrrolidinyl)propionate, tetrahydrofurfuryl 3-morpholinopropionate, glycidyl 3-piperidinopropionate, 2-methoxyethyl 3-morpholinopropionate, 2-(2-methoxyethoxy)ethyl 3-(1-pyrrolidinyl)propionate, butyl 3-morpholinopropionate, cyclohexyl 3-piperidinopropionate, α-(1-pyrrolidinyl)methyl-γ-butyrolactone, β-piperidino-γ-butyrolactone, β-morpholino-δ-valerolactone, methyl 1-pyrrolidinylacetate, methyl piperidinoacetate, methyl morpholinoacetate, methyl thiomorpholinoacetate, ethyl 1-pyrrolidinylacetate, 2-methoxyethyl morpholinoacetate, 2-morpholinoethyl 2-methoxyacetate, 2-morpholinoethyl 2-(2-methoxyethoxy)acetate, 2-morpholinoethyl 2-[2-(2-methoxyethoxy)ethoxy]acetate, hexanoate 2-morpholinoethyl, 2-morpholinoethyl octanoate, 2-morpholinoethyl decanoate, 2-morpholinoethyl laurate, 2-morpholinoethyl myristate, 2-morpholinoethyl palmitate, and 2-morpholinoethyl stearate.

Further examples include nitrogen-containing organic compounds containing a cyano group represented by the following general formulae (E-3) to (E-6).

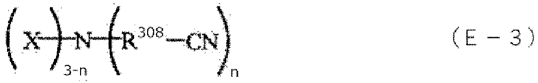

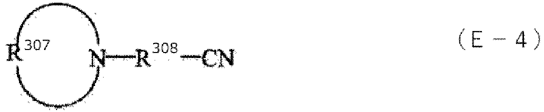

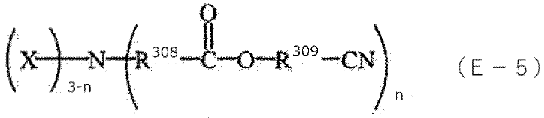

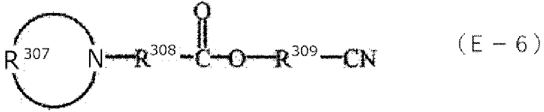

In the formulae, X, R³⁰⁷, and "n" are as defined above; and R³⁰⁸ and R³⁰⁹ are identical to or different from each other and each represent a linear or branched alkylene group having 1 to 4 carbon atoms.

Specific examples of the nitrogen-containing organic compounds containing a cyano group represented by the general formulae (E-3) to (E-6) include 3-(diethylamino)propiononitrile, N,N-bis(2-hydroxyethyl)-3-aminopropiononitrile, N,N-bis(2-acetoxyethyl)-3-aminopropiononitrile, N,N-bis(2-formyloxyethyl)-3-aminopropiononitrile, N,N-bis(2-methoxyethyl)-3-aminopropiononitrile, N,N-bis[2-(methoxymethoxy)ethyl]-3-aminopropiononitrile, methyl N-(2-cyanoethyl)-N-(2-methoxyethyl)-3-aminopropionate, methyl N-(2-cyanoethyl)-N-(2-hydroxyethyl)-3-aminopropionate, methyl N-(2-acetoxyethyl)-N-(2-cyanoethyl)-3-aminopropionate, N-(2-cyanoethyl)-N-ethyl-3-aminopropiononitrile, N-(2-cyanoethyl)-N-(2-hydroxyethyl)-3-aminopropiononitrile, N-(2-acetoxyethyl)-N-(2-cyanoethyl)-3-aminopropiononitrile, N-(2-cyanoethyl)-N-(2-formyloxyethyl)-3-aminopropiononitrile, N-(2-cyanoethyl)-N-(2-methoxyethyl)-3-aminopropiononitrile, N-(2-cyanoethyl)-N-[2-(methoxymethoxy)ethyl]-3-aminopropiononitrile, N-(2-cyanoethyl)-N-(3-hydroxy-1-propyl)-3-aminopropiononitrile, N-(3-acetoxy-1-propyl)-N-(2-cyanoethyl)-3-aminopropiononitrile, N-(2-cyanoethyl)-N-(3-formyloxy-1-propyl)-3-aminopropiononitrile, N-(2-cyanoethyl)-N-tetrahydrofurfuryl-3-aminopropiononitrile, N,N-bis(2-cyanoethyl)-3-aminopropiononitrile, diethylaminoacetonitrile, N,N-bis(2-hydroxyethyl)aminoacetonitrile, N,N-bis(2-acetoxyethyl)aminoacetonitrile, N,N-bis(2-formyloxyethyl)aminoacetonitrile, N,N-bis(2-methoxyethyl)aminoacetonitrile, N,N-bis[2-(methoxymethoxy)ethyl]aminoacetonitrile, methyl N-cyanomethyl-N-(2-methoxyethyl)-3-aminopropionate, methyl N-cyanomethyl-N-(2-hydroxyethyl)-3-aminopropionate, methyl N-(2-acetoxyethyl)-N-cyanomethyl-3-aminopropionate, N-cyanomethyl-N-(2-hydroxyethyl)aminoacetonitrile, N-(2-acetoxyethyl)-N-(cyanomethyl)aminoacetonitrile, N-cyanomethyl-N-(2-formyloxyethyl)aminoacetonitrile, N-cyanomethyl-N-(2-methoxyethyl)aminoacetonitrile, N-cyanomethyl-N-[2-(methoxymethoxy)ethyl]aminoacetonitrile, N-(cyanomethyl)-N-(3-hydroxy-1-propyl)aminoacetonitrile, N-(3-acetoxy-1-propyl)-N-(cyanomethyl)aminoacetonitrile, N-cyanomethyl-N-(3-formyloxy-1-propyl)aminoacetonitrile, N,N-bis(cyanomethyl)aminoacetonitrile, 1-pyrrolidinepropiononitrile, 1-piperidinepropiononitrile, 4-morpholinepropiononitrile, 1-pyrrolidineacetonitrile, 1-piperidineacetonitrile, 4-morpholineacetonitrile, cyanomethyl 3-diethylaminopropionate, cyanomethyl N,N-bis(2-hydroxyethyl)-3-aminopropionate, cyanomethyl N,N-bis(2-acetoxyethyl)-3-aminopropionate, cyanomethyl N,N-bis(2-formyloxyethyl)-3-aminopropionate, cyanomethyl N,N-bis(2-methoxyethyl)-3-aminopropionate, cyanomethyl N,N-bis[2-(methoxymethoxy)ethyl]-3-aminopropionate, 2-cyanoethyl 3-diethylaminopropionate, 2-cyanoethyl N,N-bis(2-hydroxyethyl)-3-aminopropionate, 2-cyanoethyl N,N-bis(2-acetoxyethyl)-3-aminopropionate, 2-cyanoethyl N,N-bis(2-formyloxyethyl)-3-aminopropionate, 2-cyanoethyl N,N-bis(2-methoxyethyl)-3-aminopropionate, 2-cyanoethyl N,N-bis[2-(methoxymethoxy)ethyl]-3-aminopropionate, cyanomethyl 1-pyrrolidinepropionate, cyanomethyl 1-piperidinepropionate, cyanomethyl 4-morpholinepropironate, 2-cyanoethyl 1-pyrrolidinepropionate, 2-cyanoethyl 1-piperidinepropionate and 2-cyanoethyl 4-morpholinepropionate.

Further examples include nitrogen-containing organic compounds having an imidazole skeleton represented by the following general formula (E-7) and having a polar functional group.

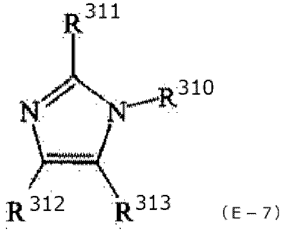

In the formula, R³¹⁰ represents a linear, branched, or cyclic alkyl group having 2 to 20 carbon atoms and having a polar functional group, and as the polar functional group, contains one or more of any of a hydroxy group, a carbonyl group, an ester group, an ether group, a sulfide group, a carbonate group, a cyano group, and an acetal group. R³¹¹, R³¹², and R³¹³ each represent a hydrogen atom or a linear, branched, or cyclic alkyl group, aryl group, or aralkyl group having 1 to 10 carbon atoms.

Further examples include nitrogen-containing organic compounds having a benzimidazole skeleton represented by the following general formula (E-8) and having a polar functional group.

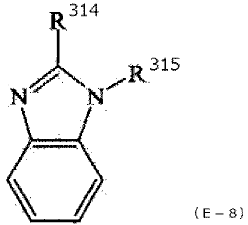

In the formula, R³¹⁴ represents a hydrogen atom or a linear, branched, or cyclic alkyl group, aryl group, or aralkyl group having 1 to 10 carbon atoms. R³¹⁵ represents a hydrogen atom or a linear, branched, or cyclic alkyl group having 1 to 20 carbon atoms and having a polar functional group, contains, as the polar functional group, any one or more of an ester group, an acetal group, and a cyano group, and also optionally contains any one or more of a hydroxy group, a carbonyl group, an ether group, a sulfide group, and a carbonate group.

Further examples include nitrogen-containing heterocyclic compounds represented by the following general formulae (E-9) and (E-10), having a polar functional group.

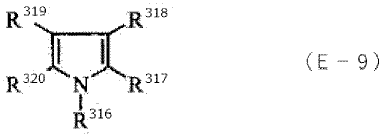

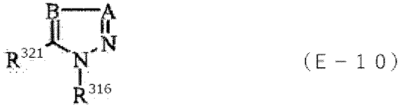

In the formulae, A represents a nitrogen atom or ≡C-R³²². B represents a nitrogen atom or ≡C-R³²³. R³¹⁶ represents a linear, branched, or cyclic alkyl group having 2 to 20 carbon atoms and having a polar functional group, and contains, as the polar functional group, one or more of a hydroxy group, a carbonyl group, an ester group, an ether group, a sulfide group, a carbonate group, a cyano group, or an acetal group. R³¹⁷, R³¹⁸, R³¹⁹, and R³²⁰ each represent a hydrogen atom or a linear, branched, or cyclic alkyl group or aryl group having 1 to 10 carbon atoms, or R³¹⁷ and R³¹⁸, and R³¹⁹ and R³²⁰ may each be bonded to each other to form a benzene ring, a naphthalene ring, or a pyridine ring. R³²¹ represents a hydrogen atom or a linear, branched, or cyclic alkyl group or aryl group having 1 to 10 carbon atoms. R³²² and R³²³ each represent a hydrogen atom or a linear, branched, or cyclic alkyl group or aryl group having 1 to 10 carbon atoms. R³²¹ and R³²³ may be bonded to each other to form a benzene ring or a naphthalene ring.

Further examples include nitrogen-containing organic compounds represented by the following general formulae (E-11) to (E-14), having an aromatic carboxylic acid ester structure.

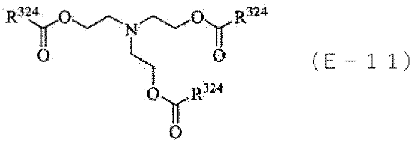

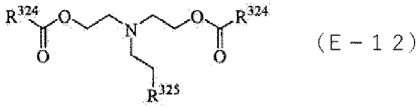

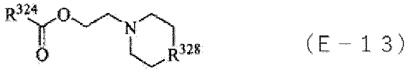

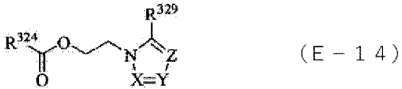

In the formulae, R³²⁴ represents a aryl group having 6 to 20 carbon atoms or a heteroaromatic group having 4 to 20 carbon atoms, and part or all of the hydrogen atoms may be substituted with a halogen atom, a linear, branched, or cyclic alkyl group having 1 to 20 carbon atoms, an aryl group having 6 to 20 carbon atoms, an aralkyl group having 7 to 20 carbon atoms, an alkoxy group having 1 to 10 carbon atoms, an acyloxy group having 1 to 10 carbon atoms, or an alkylthio group having 1 to 10 carbon atoms. R³²⁵ represents CO₂R³²⁶, OR³²⁷, or a cyano group. R³²⁶ represents an alkyl group having 1 to 10 carbon atoms, part of the methylene groups optionally being substituted with an oxygen atom. R³²⁷ represents an alkyl group or acyl group having 1 to 10 carbon atoms, part of the methylene groups optionally being substituted with an oxygen atom. R³²⁸ represents a single bond, a methylene group, an ethylene group, a sulfur atom, or a -O(CH₂CH₂O)ₙ- group. "n" represents 0, 1, 2, 3, or 4. R³²⁹ represents a hydrogen atom, a methyl group, an ethyl group, or a phenyl group. X represents a nitrogen atom or CR³³⁰. Y represents a nitrogen atom or CR³³¹. Z represents a nitrogen atom or CR³³². R³³⁰, R³³¹, and R³³² each independently represent a hydrogen atom, a methyl group, or a phenyl group, or R³³⁰ and R³³¹, or R³³¹ and R³³² may be bonded to each other to form an aromatic ring having 6 to 20 carbon atoms or a heteroaromatic ring having 2 to 20 carbon atoms.

Further examples include nitrogen-containing organic compounds represented by the following general formula (E-15), having a 7-oxanorbornane-2-carboxylic acid ester structure.

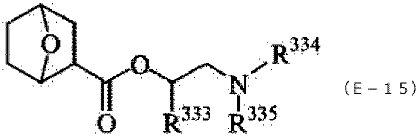

In the formula, R³³³ represents a hydrogen atom or a linear, branched, or cyclic alkyl group having 1 to 10 carbon atoms. R³³⁴ and R³³⁵ each independently represent an alkyl group having 1 to 20 carbon atoms, an aryl group having 6 to 20 carbon atoms, or an aralkyl group having 7 to 20 carbon atoms and optionally contain one or more polar functional groups, such as ether, carbonyl, ester, alcohol, sulfide, nitrile, amine, imine, and amide, and part of the hydrogen atoms may be substituted with a halogen atom. R³³⁴ and R³³⁵ may be bonded to each other to form a heterocycle or heteroaromatic ring having 2 to 20 carbon atoms.

Incidentally, the amount of the basic compound (E) to be contained is preferably 0.001 to 5 parts by mass, particularly preferably 0.01 to 3 parts by mass based on 100 parts by mass of the component (A). When the contained amount is 0.001 parts by mass or more, sufficient effect of the compound being contained can be achieved, and when 5 parts by mass or less, there is little risk of sensitivity being degraded.

### <(F) Surfactant>

A surfactant (F) can be contained in the above-described composition for forming a metal-containing film in order to improve coating property in spin-coating. Examples of the surfactant include those disclosed in [0142] to [0147] of JP2009-269953A. When the surfactant is contained, the contained amount is preferably 0.01 to 10 parts by mass, more preferably 0.05 to 5 parts by mass based on 100 parts by mass of the metal source (A).

### <(G) Flowability Accelerator>

Another organic compound or polymer may be further blended in the above-described composition for forming a metal-containing film. The flowability accelerator is mixed with the compound for forming a metal-containing film and serves to improve the film-formability by spin-coating and the filling property for a stepped substrate. Furthermore, as the flowability accelerator, a material having a high density of carbon atoms and high etching resistance is preferable.

Examples of such a material include novolak resins of phenol, o-cresol, m-cresol, p-cresol, 2,3-dimethyl phenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluorene-9-ylidene)bisphenol, 2,2'-dimethyl-4,4'-(9H-fluorene-9-ylidene)bisphenol, 2,2'-diallyl-4,4'-(9H-fluorene-9-ylidene)bisphenol, 2,2'-difluoro-4,4'-(9H-fluorene-9-ylidene)bisphenol, 2,2'-diphenyl-4,4'-(9H-fluorene-9-ylidene)bisphenol, 2,2'-dimethoxy-4,4'-(9H-fluorene-9-ylidene)bisphenol, 2,3,2',3'-tetrahydro-(1,1')-spirobiindene-6,6'-diol, 3,3,3',3'-tetramethyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6, 6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, 7-methoxy-2-naphthol, dihydroxynaphthalene such as 1,5-dihydroxynaphthalene, 1,7-dihydroxynaphthalene, and 2,6-dihydroxynaphthalene, methyl-3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, or limonene; polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth)acrylate, and copolymers thereof. In addition, the composition may contain a naphthol dicyclopentadiene copolymer disclosed in JP2004-205685A, a fluorene bisphenol novolak resin disclosed in JP2005-128509A, an acenaphthylene copolymer disclosed in JP2005-250434A, fullerene having a phenolic group disclosed in JP2006-227391A, a bisphenol compound and a novolak resin thereof disclosed in JP2006-293298A, a novolak resin of an adamantane phenol compound disclosed in JP2006-285095A, a bisnaphthol compound and a novolak resin thereof disclosed in JP2010-122656A, a fluorene compound disclosed in JP2017-119671A, a fullerene resin compound disclosed in JP2008-158002A, a fluorene resin disclosed in JP2020-183480A, and the like. The flowability accelerator is preferably contained in an amount of 0.001 to 100 parts by mass, more preferably 0.01 to 50 parts by mass based on 100 parts by mass of the metal source (A).

### <(H) Curing Accelerator>

Another silicon-containing polymer may further be blended in the composition for forming a metal-containing film. The curing accelerator is mixed with the above-described compound for forming a metal-containing film, and serves to improve film-formability by spin-coating, curability, and contact angle.

As the silicon-containing polymer, a polysiloxane (Sx) is preferably contained. A composition for forming a resist underlayer film containing such a resin makes it possible to form a resist underlayer film excellent in adhesiveness to a resist upper layer film pattern.

### <Polysiloxane (Sx)>

The polysiloxane (Sx) preferably contains any one or more of a repeating unit represented by the following general formula (Sx-1), a repeating unit represented by the following general formula (Sx-2), and a partial structure represented by the following general formula (Sx-3).

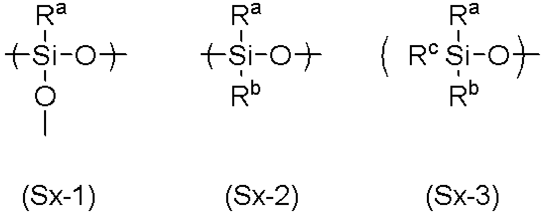

In the formulae, R^{a}, R^{b}, and R^{c} are each identical to or different from each other and represent a monovalent organic group having 1 to 30 carbon atoms.

The thermally crosslinkable polysiloxane (Sx) may be manufactured, by the hydrolysis condensation of a hydrolysable monomer (Sm) described below.

Specific examples of the hydrolysable monomer (Sm) include tetramethoxysilane, tetraethoxysilane, tetrapropoxysilane, tetraisopropoxysilane, trimethoxysilane, triethoxysilane, tripropoxysilane, triisopropoxysilane, methyltrimethoxysilane, methyltriethoxysilane, methyltripropoxysilane, methyltriisopropoxysilane, ethyltrimethoxysilane, ethyltriethoxysilane, ethyltripropoxysilane, ethyltriisopropoxysilane, vinyltrimethoxysilane, vinyltriethoxysilane, vinyltripropoxysilane, vinyltriisopropoxysilane, propyltrimethoxysilane, propyltriethoxysilane, propyltripropoxysilane, propyltriisopropoxysilane, isopropyltrimethoxysilane, isopropyltriethoxysilane, isopropyltripropoxysilane, isopropyltriisopropoxysilane, butyltrimethoxysilane, butyltriethoxysilane, butyltripropoxysilane, butyltriisopropoxysilane, sec-butyltrimethoxysilane, sec-butyltriethoxysilane, sec-butyltripropoxysilane, sec-butyltriisopropoxysilane, t-butyltrimethoxysilane, t-butyltriethoxysilane, t-butyltripropoxysilane, t-butyltriisopropoxysilane, cyclopropyltrimethoxysilane, cyclopropyltriethoxysilane, cyclopropyltripropoxysilane, cyclopropyltriisopropoxysilane, cyclobutyltrimethoxysilane, cyclobutyltriethoxysilane, cyclobutyltripropoxysilane, cyclobutyltriisopropoxysilane, cyclopentyltrimethoxysilane, cyclopentyltriethoxysilane, cyclopentyltripropoxysilane, cyclopentyltriisopropoxysilane, cyclohexyltrimethoxysilane, cyclohexyltriethoxysilane, cyclohexyltripropoxysilane, cyclohexyltriisopropoxysilane, cyclohexenyltrimethoxysilane, cyclohexenyltriethoxysilane, cyclohexenyltripropoxysilane, cyclohexenyltriisopropoxysilane, cyclohexenylethyltrimethoxysilane, cyclohexenylethyltriethoxysilane, cyclohexenylethyltripropoxysilane, cyclohexenylethyltriisopropoxysilane, cyclooctyltrimethoxysilane, cyclooctyltriethoxysilane, cyclooctyltripropoxysilane, cyclooctyltriisopropoxysilane, cyclopentadienylpropyltrimethoxysilane, cyclopentadienylpropyltriethoxysilane, cyclopentadienylpropyltripropoxysilane, cyclopentadienylpropyltriisopropoxysilane, bicycloheptenyltrimethoxysilane, bicycloheptenyltriethoxysilane, bicycloheptenyltripropoxysilane, bicycloheptenyltriisopropoxysilane, bicycloheptyltrimethoxysilane, bicycloheptyltriethoxysilane, bicycloheptyltripropoxysilane, bicycloheptyltriisopropoxysilane, adamantyltrimethoxysilane, adamantyltriethoxysilane, adamantyltripropoxysilane, adamantyltriisopropoxysilane, phenyltrimethoxysilane, phenyltriethoxysilane, phenyltripropoxysilane, phenyltriisopropoxysilane, benzyltrimethoxysilane, benzyltriethoxysilane, benzyltripropoxysilane, benzyltriisopropoxysilane, anisyltrimethoxysilane, anisyltriethoxysilane, anisyltripropoxysilane, anisyltriisopropoxysilane, tolyltrimethoxysilane, tolyltriethoxysilane, tolyltripropoxysilane, tolyltriisopropoxysilane, phenethyltrimethoxysilane, phenethyltriethoxysilane, phenethyltripropoxysilane, phenethyltriisopropoxysilane, naphthyltrimethoxysilane, naphthyltriethoxysilane, naphthyltripropoxysilane, naphthyltriisopropoxysilane, dimethyldimethoxysilane, dimethyldiethoxysilane, methylethyldimethoxysilane, methylethyldiethoxysilane, dimethyldipropoxysilane, dimethyldiisopropoxysilane, diethyldimethoxysilane, diethyldiethoxysilane, diethyldipropoxysilane, diethyldiisopropoxysilane, dipropyldimethoxysilane, dipropyldiethoxysilane, dipropyldipropoxysilane, dipropyldiisopropoxysilane, diisopropyldimethoxysilane, diisopropyldiethoxysilane, diisopropyldipropoxysilane, diisopropyldiisopropoxysilane, dibutyldimethoxysilane, dibutyldiethoxysilane, dibutyldipropoxysilane, dibutyldiisopropoxysilane, di-sec-butyldimethoxysilane, di-sec-butyldiethoxysilane, di-sec-butyldipropoxysilane, di-sec-butyldiisopropoxysilane, di-t-butyldimethoxysilane, di-t-butyldiethoxysilane, di-t-butyldipropoxysilane, di-t-butyldiisopropoxysilane, dicyclopropyldimethoxysilane, dicyclopropyldiethoxysilane, dicyclopropyldipropoxysilane, dicyclopropyldiisopropoxysilane, dicyclobutyldimethoxysilane, dicyclobutyldiethoxysilane, dicyclobutyldipropoxysilane, dicyclobutyldiisopropoxysilane, dicyclopentyldimethoxysilane, dicyclopentyldiethoxysilane, dicyclopentyldipropoxysilane, dicyclopentyldiisopropoxysilane, dicyclohexyldimethoxysilane, dicyclohexyldiethoxysilane, dicyclohexyldipropoxysilane, dicyclohexyldiisopropoxysilane, dicyclohexenyldimethoxysilane, dicyclohexenyldiethoxysilane, dicyclohexenyldipropoxysilane, dicyclohexenyldiisopropoxysilane, dicyclohexenylethyldimethoxysilane, dicyclohexenylethyldiethoxysilane, dicyclohexenylethyldipropoxysilane, dicyclohexenylethyldiisopropoxysilane, dicyclooctyldimethoxysilane, dicyclooctyldiethoxysilane, dicyclooctyldipropoxysilane, dicyclooctyldiisopropoxysilane, dicyclopentadienylpropyldimethoxysilane, dicyclopentadienylpropyldiethoxysilane, dicyclopentadienylpropyldipropoxysilane, dicyclopentadienylpropyldiisopropoxysilane, bis(bicycloheptenyl)dimethoxysilane, bis(bicycloheptenyl)diethoxysilane, bis(bicycloheptenyl)dipropoxysilane, bis(bicycloheptenyl)diisopropoxysilane, bis(bicycloheptyl) dimethoxysilane, bis(bicycloheptyl) diethoxysilane, bis(bicycloheptyl) dipropoxysilane, bis(bicycloheptyl) diisopropoxysilane, diadamantyldimethoxysilane, diadamantyldiethoxysilane, diadamantyldipropoxysilane, diadamantyldiisopropoxysilane, diphenyldimethoxysilane, diphenyldiethoxysilane, methylphenyldimethoxysilane, methylphenyldiethoxysilane, diphenyldipropoxysilane, diphenyldiisopropoxysilane, trimethylmethoxysilane, trimethylethoxysilane, dimethylethylmethoxysilane, dimethylethylethoxysilane, dimethylphenylmethoxysilane, dimethylphenylethoxysilane, dimethylbenzylmethoxysilane, dimethylbenzylethoxysilane, dimethylphenethylmethoxysilane, dimethylphenethylethoxysilane, and the like.

Preferable examples of the compounds include tetramethoxysilane, tetraethoxysilane, methyltrimethoxysilane, methyltriethoxysilane, ethyltrimethoxysilane, ethyltriethoxysilane, vinyltrimethoxysilane, vinyltriethoxysilane, propyltrimethoxysilane, propyltriethoxysilane, isopropyltrimethoxysilane, isopropyltriethoxysilane, butyltrimethoxysilane, butyltriethoxysilane, isobutyltrimethoxysilane, isobutyltriethoxysilane, allyltrimethoxysilane, allyltriethoxysilane, cyclopentyltrimethoxysilane, cyclopentyltriethoxysilane, cyclohexyltrimethoxysilane, cyclohexyltriethoxysilane, cyclohexenyltrimethoxysilane, cyclohexenyltriethoxysilane, phenyltrimethoxysilane, phenyltriethoxysilane, benzyltrimethoxysilane, benzyltriethoxysilane, phenethyltrimethoxysilane, phenethyltriethoxysilane, dimethyldimethoxysilane, dimethyldiethoxysilane, diethyldimethoxysilane, diethyldiethoxysilane, methylethyldimethoxysilane, methylethyldiethoxysilane, dipropyldimethoxysilane, dibutyldimethoxysilane, methylphenyldimethoxysilane, methylphenyldiethoxysilane, trimethylmethoxysilane, dimethylethylmethoxysilane, dimethylphenylmethoxysilane, dimethylbenzylmethoxysilane, dimethylphenethylmethoxysilane, and the like.

Other examples of the organic groups represented by R^{a}, R^{b}, and R^{c}, corresponding to the compounds given above as examples of the hydrolysable monomer (Sm) include organic groups having one or more carbon-oxygen single bonds or carbon-oxygen double bonds. Specific examples include organic groups having one or more groups selected from the group consisting of an ether bond, an ester bond, alkoxy groups, a hydroxy group, etc. Examples of the organic groups include ones shown by the following general formula (Sm-R).

(P-Q₁-(S₁)ᵥ₁-Q₂-)ᵤ-(T)ᵥ₂-Q₃-(S₂)ᵥ₃-Q₄- (Sm-R)

In the formula, P represents a hydrogen atom, a cyclic ether group, a hydroxy group, an alkoxy group having 1 to 4 carbon atoms, an alkylcarbonyloxy group having 1 to 6 carbon atoms, or an alkylcarbonyl group having 1 to 6 carbon atoms; Q₁, Q₂, Q₃, and Q₄ each independently represent -C_{q}H_{(2q-p)}Pₚ-, where P is as defined above, "p" represents an integer of 0 to 3, and "q" represents an integer of 0 to 10, provided that q=0 means a single bond; "u" represents an integer of 0 to 3; S₁ and S₂ each independently represent -O-, -CO-, - OCO-, -COO-, or -OCOO-. "v1", "v2", and "v3" each independently represent 0 or 1. T represents a divalent atom other than carbon, or a divalent group selected from the group consisting of an alicyclic, aromatic, or heterocyclic ring. As T, examples of the alicyclic, aromatic, or heterocyclic ring optionally containing a hetero atom such as an oxygen atom are shown below. In T, positions bonded to Q₂ and Q₃ are not particularly limited, and can be selected appropriately in consideration of reactivity dependent on steric factors, availability of commercial reagents used in the reaction, and so on.

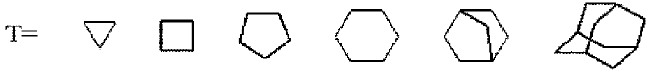

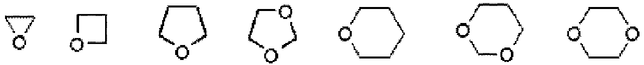

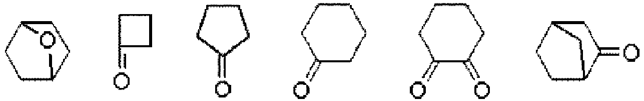

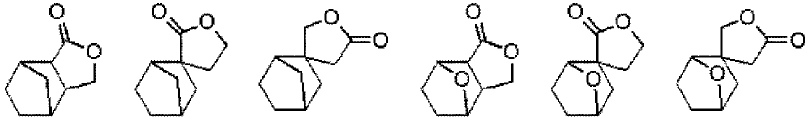

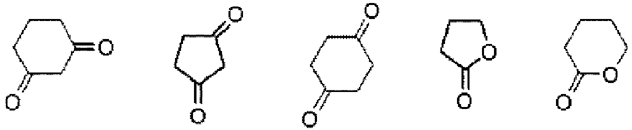

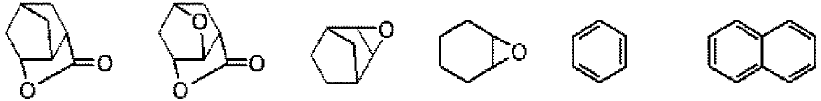

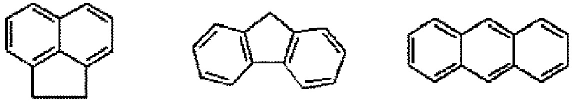

Preferable examples of the organic groups having one or more carbon-oxygen single bonds or carbon-oxygen double bonds in the general formula (Sm-R) include the following. Note that, in the following formulae, (Si) is depicted to show a bonding site to Si.

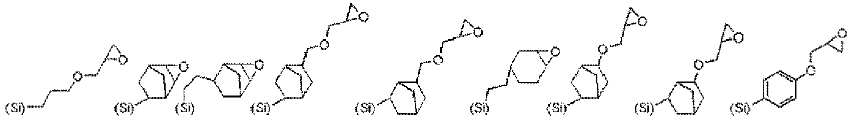

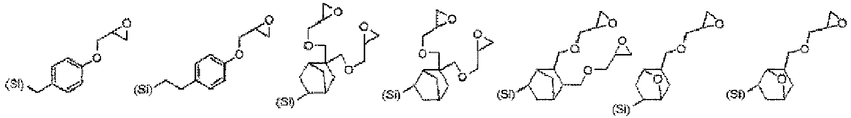

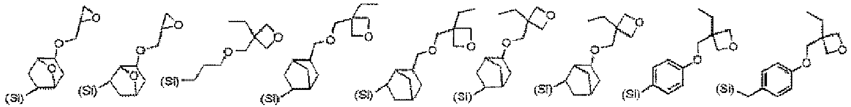

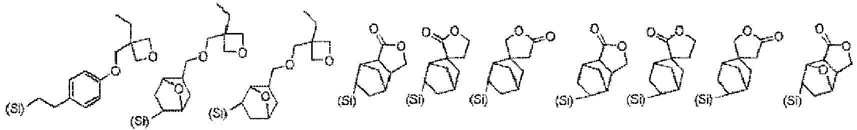

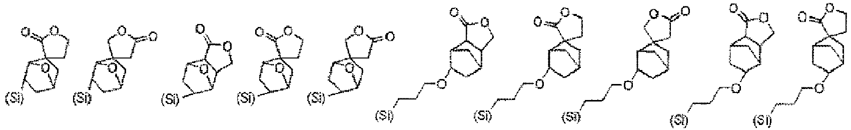

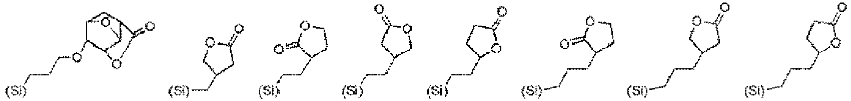

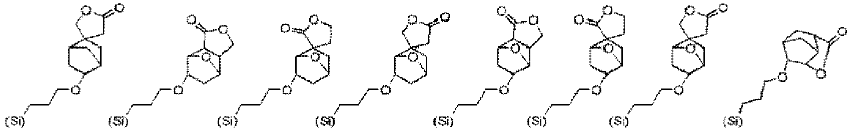

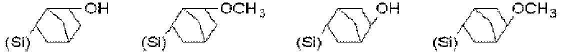

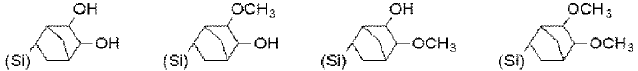

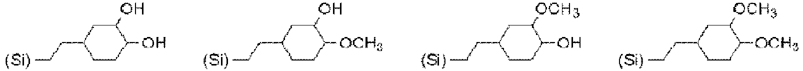

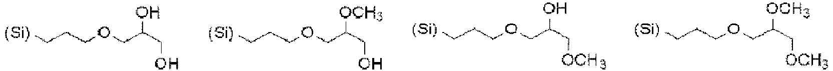

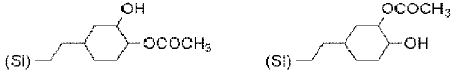

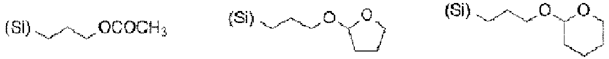

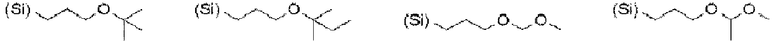

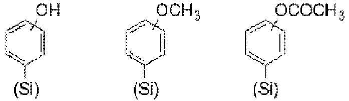

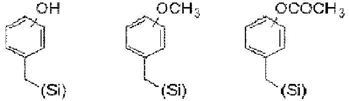

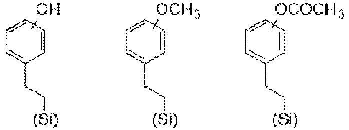

When at least one of R^{a} to R^{c} in the formulae (Sx-1) to (Sx-3) is an organic group having one or more carbon-oxygen single bonds or carbon-oxygen double bonds, adhesiveness to a resist upper layer film pattern can be further enhanced.

Furthermore, as examples of the organic groups of R^{a}, R^{b}, and R^{c}, an organic group containing a silicon-silicon bond can also be used. Specific examples thereof include the following.

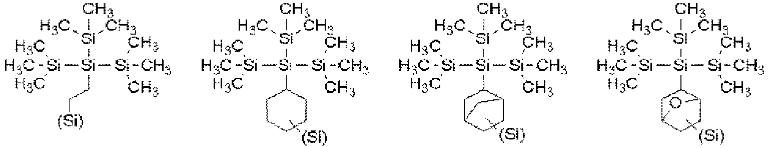

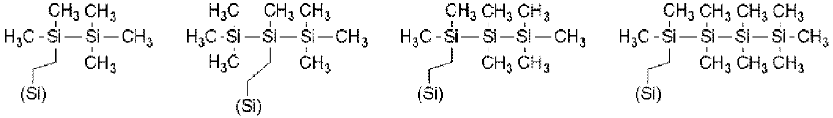

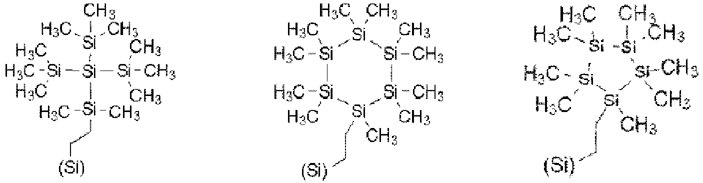

Further, as examples of the organic groups of R^{a}, R^{b}, and R^{c}, organic groups having a protective group that is decomposed with an acid can also be used. Specific examples thereof include organic groups shown in paragraphs [0043] to [0048] of JP2013-167669A and organic groups obtained from silicon compounds shown in paragraph [0056] of JP2013-224279A.

Furthermore, as examples of the organic groups of R^{a}, R^{b}, and R^{c}, an organic group having a fluorine atom can also be used. Specific examples thereof include organic groups obtained from silicon compounds shown in paragraphs [0059] to [0065] of JP2012-53253A.

To enhance the sensitivity of a resist upper layer film in EUV lithography, an organic group having a fluorine atom is preferably contained as the organic groups of R^{a}, R^{b}, and R^{c}.

Further examples of the organic groups of R^{a}, R^{b}, and R^{c} include organic groups having an iodine atom. Specific examples include organic groups obtained from silicon compounds shown in paragraphs [0043] to [0047] of JP2023-116531A.

To enhance the sensitivity of a resist upper layer film in EUV lithography, an organic group having an iodine atom is preferably contained as the organic groups of R^{a}, R^{b}, and R^{c}.

To the hydrolysable monomer (Sm), 1, 2, or 3 chlorine atoms, bromine atoms, iodine atoms, acetoxy groups, methoxy groups, ethoxy groups, propoxy groups, butoxy groups, or the like are bonded as hydrolysable groups on the silicon atom shown as (Si) in the partial structures shown above.

### [Step (I-2)]

Step (I-2) is a step of forming a pattern directly or indirectly in the metal-containing film.

The present invention is a patterning process including subjecting the pattern of the metal-containing film to plasma irradiation and processing the film to be processed while using the resultant as an etching mask, and the method for forming the metal-containing film pattern is not particularly limited. However, methods for forming a pattern directly or indirectly in the metal-containing film can be described separately.

### <Method for Forming Pattern Directly in Metal-Containing Film>

In the step (I-2), the metal-containing film is preferably subjected to pattern exposure with a high-energy beam and then development with a developer to form the pattern in the metal-containing film.

That is, the present invention can be a patterning process for forming a pattern on a substrate, including the steps of:
(i-1) applying a composition for forming a metal-containing film onto a substrate on which a film to be processed has been formed, followed by heating to form a metal-containing film;
(i-2) subjecting the metal-containing film to pattern exposure with a high-energy beam and then development with a developer to form the pattern in the metal-containing film
(i-3) subjecting the pattern of the metal-containing film to plasma irradiation; and
(i-4) forming the pattern directly or indirectly in the film to be processed while using the plasma-irradiated pattern of the metal-containing film as a mask, where
a plasma used in the plasma irradiation in the step (i-3) etches the metal-containing film less than an etching gas used in the step (i-2) and etches the film to be processed less than an etching gas used in the step (i-4).

Incidentally, the process of heating may be applied after the exposure in addition to the treatment after the application. Heating after exposure is effective for achieving higher sensitivity and higher contrast.

### [Step (i-1)]

In step (i-1), the method for applying the composition for forming a metal-containing film onto the substrate is not particularly limited, and an existing method can be used. For example, the composition can be applied onto a substrate (Si, SiO₂, SiN, SiON, TiN, WSi, BPSG, SOG, organic antireflective film, organic resist underlayer film, etc.) for manufacturing an integrated circuit, a layer to be processed on the substrate, a substrate (Cr, CrO, CrON, MoSi₂, SiO₂, etc.) for manufacturing a mask circuit, or a layer to be processed on the substrate by an appropriate coating process, such as spin coating, roll coating, flow coating, dip coating, spray coating, or doctor coating, so that the coating film has a thickness of 0.01 to 2.0 µm.

In step (i-1), the method for performing the heating is not particularly limited, and for example, the heating can be performed by prebaking on a hot plate at 60 to 350°C for 10 seconds to 30 minutes, preferably 100 to 300°C for 30 seconds to 20 minutes.

### [Step (i-2)]

In the step of exposing the metal-containing film with a high-energy beam (step (i-2)), a vacuum ultraviolet ray having a wavelength of 3 to 15 nm or an electron beam with an acceleration voltage of 1 to 250 kV, especially 1 to 150 kV, is preferable as the high-energy beam from the viewpoints of sensitivity and resolution. It is assumed that, by virtue of the irradiation with the high-energy beam, the bond between metal and an alkoxy group is dissociated or a condensation or (hydrolysis) condensation reaction further occurs, and solubility in a developer changes.

In the developing process (step (i-2)), the developer is not particularly limited, and a suitable developer can be selected depending on the resist material used. However, the developer preferably contains an organic solvent, and preferably contains one or more organic solvents selected from 2-octanone, 2-nonanone, 2-heptanone, 3-heptanone, 4-heptanone, 2-hexanone, 3-hexanone, diisobutyl ketone, 2-methylcyclohexanone, 3-methylcyclohexanone, 4-methylcyclohexanone, acetophenone, 2'-methylacetophenone, 4'-methylacetophenone, butyl acetate, isobutyl acetate, amyl acetate, isoamyl acetate, phenyl acetate, methyl valerate, methyl 2-hydroxyisobutyrate, ethyl 2-hydroxyisobutyrate, methyl benzoate, ethyl benzoate, benzyl acetate, methyl phenylacetate, and methyl 3-phenylpropionate. The total concentration of these organic solvents is preferably 60 mass% or more based on the total amount of the developer.

When a developer containing such an organic solvent is used, a negative pattern, where unexposed portions are dissolved and exposed portions remain as a pattern, can be formed.

### [Step (i-3)]

The plasma irradiation step (step (i-3)) is as described later.

### [Step (i-4)]

In the pattern formation step (step (i-4)), the plasma-irradiated metal-containing film pattern is transferred to the film to be processed by performing dry etching once or more times, and there are no particular limitations in this process, and examples of patterning processes include the following.

### (Patterning Process 1)

A patterning process including the steps of:
(a-1) forming an organic resist underlayer film on a substrate on which a film to be processed has been formed;
(a-2) applying a composition for forming a metal-containing film onto the organic resist underlayer film, followed by heating to form a metal-containing film;
(a-3) subjecting the metal-containing film to pattern exposure with a high-energy beam and then development with a developer to form a pattern in the metal-containing film;
(a-4) subjecting the pattern of the metal-containing film to plasma irradiation; and
(a-5) forming the pattern in the organic resist underlayer film by etching while using the pattern of the metal-containing film as a mask.

### (Patterning Process 2)

A patterning process including the steps of:
(b-1) forming an organic resist underlayer film on a substrate on which a film to be processed has been formed;
(b-2) forming an adhesive film on the organic resist underlayer film;
(b-3) applying a composition for forming a metal-containing film onto the adhesive film, followed by heating to form a metal-containing film;
(b-4) subjecting the metal-containing film to pattern exposure with a high-energy beam and then development with a developer to form a pattern in the metal-containing film;
(b-5) subjecting the pattern of the metal-containing film to plasma irradiation; and
(b-6) dry-etching the adhesive film and the organic resist underlayer film while using the pattern of the metal-containing film as a mask to form the pattern in the organic resist underlayer film.

As the organic resist underlayer film, it is possible to use an organic film formed by a spin-coating method using a coating-type composition for forming an organic underlayer film, amorphous carbon or diamondlike carbon formed by a PVD method, a CVD method, or an ALD method, etc.

The thickness of the organic resist underlayer film is usually 10 to 1,000 nm, particularly preferably 30 to 500 nm.

When the organic resist underlayer film is etched while using a metal-containing film pattern as an etching mask, dry etching conditions where the etching rate of the organic resist underlayer film is higher than that of the metal-containing film are preferable, for example, dry etching including an oxygen-based gas can be performed.

As the adhesive film, preferable are adhesive films formed by spin-coating with an organic antireflective film (BARC), an organic adhesive film, or a silicon-containing resist middle layer film. The thickness of the adhesive film is usually 3 to 30 nm, particularly preferably 5 to 15 nm.

When the adhesive film is etched while using the metal-containing film pattern as an etching mask, the etching is preferably performed under dry etching conditions where the etching rate of the adhesive film is higher than that of the metal-containing film. When the adhesive film is an organic antireflective film (BARC) or an organic adhesive film, it is preferable to perform dry etching including an oxygen-based gas, for example. When the adhesive film is a silicon-containing resist middle layer film, it is preferable to perform dry etching including a fluorine-based gas.

A metal-containing resist film pattern is excellent in dry etching resistance to oxygen-based and fluorine-based gases, and therefore, is hardly affected by film thickness reduction or side-etching in the dry etching of an adhesive film formed as a thin film. Accordingly, pattern transfer to the organic resist underlayer film can be performed while using a metal-containing film pattern.

When the film to be processed is etched while using the organic resist underlayer film pattern as an etching mask, it is preferable to perform the etching under dry etching conditions where the etching rate of the film to be processed is higher than that of the organic resist underlayer film, for example, dry etching with a halogen-based gas plasma, such as a fluorine-based, chlorine-based, or bromine-based gas plasma, is preferably performed. The metal-containing film that remains on the organic resist underlayer film pattern is preferably removed by the etching.

### <Method for Forming Pattern Indirectly in Metal-Containing Film>

It is preferable to use the above-described patterning process, including, between the step (I-1) and the step (I-2), the steps of:
(I-1-1) forming a resist upper layer film directly or indirectly on the metal-containing film; and
(I-1-2) subjecting the resist upper layer film to pattern exposure and then development with a developer to form a pattern in the resist upper layer film, where
in the step (I-2), the pattern is formed in the metal-containing film by performing etching at least once while using the pattern of the resist upper layer film as a mask.

That is, in the present invention, it is possible to use a patterning process for forming a pattern on a substrate, including the steps of:
(ii-1) applying a composition for forming a metal-containing film onto a substrate on which a film to be processed has been formed, followed by heating to form a metal-containing film;
(ii-2) forming a resist upper layer film directly or indirectly on the metal-containing film;
(ii-3) subjecting the resist upper layer film to pattern exposure and then development with a developer to form a pattern in the resist upper layer film;
(ii-4) forming the pattern in the metal-containing film by performing etching at least once while using the pattern of the resist upper layer film as a mask;
(ii-5) subjecting the pattern of the metal-containing film to plasma irradiation; and
(ii-6) forming the pattern directly or indirectly in the film to be processed while using the plasma-irradiated pattern of the metal-containing film as a mask, where
a plasma used in the plasma irradiation in the step (ii-5) etches the metal-containing film less than an etching gas used in the step (ii-4) and etches the film to be processed less than an etching gas used in the step (ii-6).

### [Step (ii-1)]

The method for applying the composition for forming a metal-containing film in the step (ii-1) is not particularly limited.

In the step (ii-1), the heating (baking) temperature of the metal-containing film can be 100°C or higher and 800°C or lower, more preferably 150°C or higher and 600°C or lower, further preferably 150°C or higher and 450°C or lower, and even further preferably 200°C or higher and 400°C or lower. The baking time can be 10 seconds to 7,200 seconds, further preferably 30 seconds to 600 seconds.

By adjusting appropriately the baking temperature and time within the above-described ranges, it is possible to achieve curing properties, such as planarizing and filling properties, dry etching resistance, and heat resistance, suitable for the purpose. By performing the heat treatment (baking) within a temperature range of 150°C or higher and 600°C or lower, a state is achieved, where many active sites, at which recombination in the metal-containing film occurs, are contained in the film, and film modification by irradiation with plasma is more easily promoted, so that a metal-containing film pattern having small edge roughness can be formed after the plasma irradiation. When the baking temperature is 100°C or higher, the solvent remaining in the film can be reduced, and degradation in film shrinkage due to plasma irradiation can be suppressed. When the baking temperature is 800°C or lower, thermal decomposition of the organic groups contained in the metal source and so forth can be suppressed, and it is possible to provide a metal-containing film with little sublimation product. It is also possible to perform the heat treatment in multiple steps (step-baking).

Furthermore, in the step (ii-1), the heat treatment can be performed under an atmosphere having an oxygen concentration of 1% or more and 21% or less.

According to such a method, it is possible to activate reactive sites of the metal source (A) in the metal-containing film and promote the curing reaction performed by plasma irradiation.

Alternatively, in the step (ii-1), the heat treatment can be performed under an atmosphere having an oxygen concentration of less than 1%.

As the atmosphere during the baking, it is possible to select, as necessary, an oxygen-containing atmosphere (oxygen concentration: 1% to 21%), such as air, or a non-oxygen atmosphere, such as nitrogen. For example, in a case where the substrate to be processed easily undergoes air oxidation, damage to the substrate can be suppressed by performing the heat treatment in an atmosphere with an oxygen concentration of less than 1% to form a cured film.

In the step (ii-1), plasma irradiation may be performed after baking the metal-containing film. The plasma irradiation step is as described later.

In the inventive patterning process, plasma irradiation may be performed in multiple steps: after forming the metal-containing resist film; and after forming the metal-containing resist underlayer film pattern. According to the above-described method, the modification of the metal-containing resist underlayer film pattern can be further promoted.

### [Step (ii-2)]

Examples of methods for forming pattern indirectly in the metal-containing film include a method in which a resist upper layer film is formed directly or indirectly on a metal-containing resist underlayer film.

### Method for Forming Resist Upper Layer Film Directly on Metal-Containing Film

When the resist upper layer film pattern is formed directly on the metal-containing film, resist upper layer films usable for the inventive patterning process are not particularly limited, and any of the various resist films conventionally known can be used.

### <Resist Upper Layer Film>

In the above-described patterning process, the resist upper layer film may be either a positive type or a negative type, and it is possible to use a film similar to the typically used photoresist composition. In addition, the photoresist composition may contain a metal atom of Sn, In, Ga, Ge, Al, Ce, La, Cs, Zr, Hf, Ti, Bi, Sb, Zn, etc. In a case where the resist upper layer film is formed with the photoresist composition, a spin-coating method may be employed, or the film may be formed by a deposition treatment according to CVD or ALD.

In a case where the photoresist composition is formed by a spin-coating method, prebaking is conducted after applying the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

### <Water-Repellent Coating Film>

When the resist upper layer film pattern is formed, if a top coat for the resist upper layer film is necessary for using liquid immersion exposure, a water-repellent coating film may be further formed on the resist upper layer film. The water-repellent coating film is not particularly limited, and various films can be used.

### Method for Forming Resist Upper Layer Film Indirectly on Metal-Containing Film

In the inventive patterning process, one or more films may be formed between the metal-containing film and the resist upper layer film to improve the process window of the resist upper layer film pattern.

Films to be formed between the metal-containing film and the resist upper layer film are not particularly limited, and an organic film, a silicon-containing film, etc. can be used.

Preferable resist underlayer films are as described above.

The thickness of the organic resist underlayer film is usually 10 to 1,000 nm, particularly preferably 30 to 500 nm.

### <Silicon-Containing Resist Middle Layer Film>

The silicon-containing middle layer film is not particularly limited, and a composition containing polysiloxane can be used. Examples include resins and compositions disclosed in JP2004-310019A, JP2005-15779A, JP2005-18054A, JP2005-352104A, JP2007-226170A, etc.

Specific examples of the resin contained in the composition for forming a silicon-containing middle layer film used in the present invention include polysiloxanes containing one or more of a compound represented by the following general formula (4), a hydrolysis product thereof, a condensate thereof, and a hydrolysis condensate thereof.

R^{1A}_{A1}R^{2A}_{A2}R^{3A}_{A3}Si(OR^{OA})_{(4-A1-A2-A3)} (4)

In the formula, R^{0A} represents a hydrocarbon group having 1 to 6 carbon atoms; and R^{1A}, R^{2A}, and R^{3A} each represent a hydrogen atom or a monovalent organic group. A1, A2, and A3 each represent 0 or 1, provided that 0 ≤ A1+A2+A3 ≤ 3.

Other examples of the organic groups represented by R^{1A}, R^{2A}, and R^{3A} include organic groups having one or more carbon-oxygen single bonds or carbon-oxygen double bonds. Specific examples include organic groups having one or more groups selected from the group consisting of an oxirane ring, an oxetane ring, an ester bond, an alkoxy group, and a hydroxy group. Examples thereof include those represented by the following general formula (5).

(P-Q₁₋(S₁)ᵥ₁-Q₂-)ᵤ-(T) ᵥ₂-Q₃-(S₂)ᵥ₃-Q₄- (5)

In the formula, P represents a hydrogen atom, an oxirane ring, an oxetane ring, a hydroxy group, an alkoxy group having 1 to 4 carbon atoms, an alkylcarbonyloxy group having 1 to 6 carbon atoms, or an alkylcarbonyl group having 1 to 6 carbon atoms; Q₁, Q₂, Q₃, and Q₄ each independently represent -CqH(2q-p)Pp- (in the formula, P being as defined above, "p" representing an integer of 0 to 3, and "q" representing an integer of 0 to 10, provided that q=0 indicates a single bond); "u" represents an integer of 0 to 3; and S₁ and S₂ each independently represent -O-, -CO-, -OCO-, -COO-, or - OCOO-. "v1", "v2", and "v3" each independently represent 0 or 1. In addition, T represents a divalent group including an aliphatic ring or aromatic ring optionally containing a heteroatom, an oxirane ring, or an oxetane ring, and examples of the aliphatic ring or aromatic ring of the T, optionally containing a heteroatom, such as an oxygen atom, are shown below. In T, positions bonded to Q₂ and Q₃ are not particularly limited, and can be selected appropriately in consideration of reactivity dependent on steric factors, availability of commercial reagents used in the reaction, and so on.

As the silicon-containing middle layer film, it is possible to use an inorganic hard mask middle layer film selected from a silicon oxide film, a silicon nitride film, and a silicon oxynitride film.

### <Inorganic Hard Mask Middle Layer Film>

When the inorganic hard mask is formed on the resist underlayer film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask is preferably 5 to 200 nm, more preferably 10 to 100 nm. The SiON film, which has a high function as an antireflective film, is the most preferably used as the inorganic hard mask. Since the substrate temperature increases to 300 to 500°C when the SiON film is formed, the resist underlayer film needs to withstand a temperature of 300 to 500°C. The composition for forming a resist underlayer film used in the present invention has high heat resistance and can withstand a high temperature of 300 to 500°C. Thus, the resist underlayer film formed by spin-coating and the inorganic hard mask formed by the CVD method or the ALD method can be combined.

The thickness of the silicon-containing film is usually 50 to 100 nm, particularly preferably 10 to 50 nm.

A photoresist film may be formed on the inorganic hard mask as the resist upper layer film. Alternatively, to improve adhesiveness to the resist upper layer film pattern, an organic antireflective film (BARC), an adhesive film, or a silicon-containing resist middle layer film may be formed on the inorganic hard mask by spin-coating, and a photoresist film may be formed thereon. In particular, when a SiON film is used as the inorganic hard mask, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

The thickness of the organic antireflective film (BARC), adhesive film, and silicon-containing resist middle layer film is usually 3 to 30 nm, particularly preferably 5 to 15 nm.

### [Step (ii-3)]

Step (ii-3) is a step of subjecting the resist upper layer film to pattern exposure and then development with a developer to form a pattern in the resist upper layer film.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

### [Step (ii-4)]

Step (ii-4) is a step of forming the pattern in the metal-containing film by performing etching at least once while using the pattern of the resist upper layer film as a mask.

That is, step (ii-4) is a step of transferring the pattern to the metal-containing film while using the resist upper layer film having the formed resist upper layer film pattern as a mask to form the pattern in the metal-containing film.

In the inventive patterning process, the resist upper layer film pattern is transferred to the metal-containing film by performing dry etching once or more times, and there are no particular limitations in this process, and examples of patterning processes include the following.

### (Patterning Process 1)

A patterning process including the steps of:
(c-1) applying a composition for forming a metal-containing film, followed by heating to form a metal-containing resist underlayer film;
(c-2) forming a resist upper layer film directly on the metal-containing resist underlayer film;
(c-3) subjecting the resist upper layer film to pattern exposure and then development with a developer to form a pattern in the resist upper layer film;
(c-4) forming a metal-containing resist underlayer film pattern by performing etching while using the pattern of the resist upper layer film as a mask;
(c-5) subjecting the metal-containing resist underlayer film pattern to plasma irradiation; and
(c-6) forming the pattern in the film to be processed by etching while using the metal-containing resist underlayer film pattern as a mask.

A photoresist film may be formed on the metal-containing film as the resist upper layer film. Alternatively, to improve adhesiveness to the resist upper layer film pattern, an organic antireflective film (BARC), an adhesive film, or a silicon-containing resist middle layer film may be formed on the metal-containing film by spin-coating, and a photoresist film may be formed thereon.

When the metal-containing film is etched while using the upper layer resist pattern as an etching mask, it is preferable to perform the etching under dry etching conditions where the etching rate of the metal-containing film is higher than that of the upper layer resist film, for example, dry etching with a halogen-based gas plasma, such as a fluorine-based, chlorine-based, or bromine-based gas plasma, is preferably performed. When an adhesive film is formed on the metal-containing film, the adhesive film is preferably removed by the etching.

When the film to be processed is etched while using the metal-containing resist underlayer film pattern as an etching mask, it is preferable to perform the etching under dry etching conditions where the etching rate of the film to be processed is higher than that of the metal-containing resist underlayer film pattern, for example dry etching with a halogen-based gas plasma, such as a chlorine-based or bromine-based gas plasma, is preferably performed.

### (Patterning Process 2)

A patterning process including the steps of:
(d-1) applying a composition for forming a metal-containing film, followed by heating to form a metal-containing resist underlayer film;
(d-2) forming an organic resist underlayer film on the metal-containing resist underlayer film;
(d-3) applying a silicon-containing resist middle layer film composition on the organic resist underlayer film, followed by heating to form a silicon-containing resist middle layer film;
(d-4) forming a resist upper layer film on the silicon-containing resist middle layer film;
(d-5) subjecting the resist upper layer film to pattern exposure and then development with a developer to form a pattern in the resist upper layer film;
(d-6) forming the pattern in the silicon-containing resist middle layer film by etching while using the pattern in the resist upper layer film as a mask;
(d-7) forming the pattern in the organic resist underlayer film by etching while using the pattern of the silicon-containing resist middle layer film as a mask;
(d-8) forming a metal-containing resist underlayer film pattern by etching while using the pattern of the organic resist underlayer film as a mask;
(d-9) subjecting the metal-containing resist underlayer film pattern to plasma irradiation; and
(d-10) forming the pattern in the film to be processed by etching while using the metal-containing resist underlayer film pattern as a mask.

As the organic resist underlayer film, it is possible to use an organic film formed by a spin-coating method using a coating-type composition for forming an organic underlayer film, amorphous carbon or diamondlike carbon formed by a PVD method, a CVD method, or an ALD method, etc.

When the silicon-containing resist middle layer film is etched while using the upper layer resist pattern as an etching mask, it is preferable to perform the etching under dry etching conditions where the etching rate of the silicon-containing resist middle layer film is higher than that of the upper layer resist film, for example, dry etching with a fluorine-based gas plasma is preferably performed.

When the organic resist underlayer film is etched while using the silicon-containing resist middle layer film pattern as an etching mask, it is preferable to perform the etching under dry etching conditions where the etching rate of the organic resist underlayer film is higher than that of the silicon-containing resist middle layer film, for example, dry etching with an oxygen-based gas plasma is preferably performed.

When the metal-containing film is etched while using the organic resist underlayer film pattern as an etching mask, it is preferable to perform the etching under dry etching conditions where the etching rate of the metal-containing film is higher than that of the organic resist underlayer film, for example, dry etching with a halogen-based gas plasma, such as a fluorine-based, chlorine-based, or bromine-based gas plasma, is preferably performed.

When the film to be processed is etched while using the metal-containing resist underlayer film pattern as an etching mask, it is preferable to perform the etching under dry etching conditions where the etching rate of the film to be processed is higher than that of the metal-containing resist underlayer film pattern, for example, dry etching with a halogen-based gas plasma, such as a chlorine-based or bromine-based gas plasma, is preferably performed.

### (Patterning Process 3)

A patterning process including the steps of:
(e-1) applying a composition for forming a metal-containing film, followed by heating to form a metal-containing resist underlayer film;
(e-2) forming an organic resist underlayer film on the metal-containing resist underlayer film;
(e-3) forming an inorganic hard mask middle layer film selected from a silicon oxide film, a silicon nitride film, and a silicon oxynitride film on the organic resist underlayer film;
(e-4) forming a resist upper layer film on the inorganic hard mask middle layer film;
(e-5) subjecting the resist upper layer film to pattern exposure and then development with a developer to form a pattern in the resist upper layer film;
(e-6) forming the pattern in the inorganic hard mask middle layer film by etching while using the pattern of the resist upper layer film as a mask;
(e-7) forming the pattern in the organic resist underlayer film by etching while using the pattern of the inorganic hard mask middle layer film as a mask;
(e-8) forming a metal-containing resist underlayer film pattern by etching while using the pattern of the organic resist underlayer film as a mask;
(e-9) subjecting the metal-containing resist underlayer film pattern to plasma irradiation; and
(e-10) forming the pattern in the film to be processed by etching while using the metal-containing resist underlayer film pattern as a mask.

A photoresist film may be formed on the inorganic hard mask as the resist upper layer film. Alternatively, to improve adhesiveness to the resist upper layer film pattern, an organic antireflective film (BARC), an adhesive film, or a silicon-containing resist middle layer film may be formed on the inorganic hard mask by spin-coating, and a photoresist film may be formed thereon.

As the inorganic hard mask film, a silicon oxide film, a silicon nitride film, and a silicon oxynitride film (SiON film) can be formed by a CVD method, an ALD method, etc.

When the silicon-containing resist middle layer film is etched while using the resist upper layer film pattern as an etching mask, it is preferable to perform the etching under dry etching conditions where the etching rate of the silicon-containing resist middle layer film is higher than that of the upper layer resist film, for example, dry etching with a fluorine-based gas plasma is preferably performed. When an adhesive film is formed on the inorganic hard mask, the adhesive film is preferably removed by the etching.

When the organic resist underlayer film is etched while using the silicon-containing resist middle layer film pattern as an etching mask, it is preferable to perform the etching under dry etching conditions where the etching rate of the organic resist underlayer film is higher than that of the silicon-containing resist middle layer film, for example, dry etching with an oxygen-based gas plasma is preferably performed.

When the metal-containing film is etched while using the organic resist underlayer film pattern as an etching mask, it is preferable to perform the etching under dry etching conditions where the etching rate of the metal-containing film is higher than that of the organic resist underlayer film, for example, dry etching with a halogen-based gas plasma, such as a fluorine-based, chlorine-based, or bromine-based gas plasma, is preferably performed.

When the film to be processed is etched while using the metal-containing resist underlayer film pattern as an etching mask, it is preferable to perform the etching under dry etching conditions where the etching rate of the film to be processed is higher than that of the metal-containing resist underlayer film pattern, for example, dry etching with a halogen-based gas plasma, such as a chlorine-based or bromine-based gas plasma, is preferably performed.

### <Step (I-3)>

Step (I-3) (steps (i-3) and (ii-5)) is a step of subjecting the pattern of the metal-containing film to plasma irradiation.

For the plasma irradiation in the step (I-3), a known method can be used. Examples include methods disclosed in JP5746670B2 and "Improvement of the wiggling profile of spin-on carbon hard mask by H2 plasma treatment" (J. Vac. Sci. Technol. B26 (1), Jan/Feb 2008, p67-71).

RF discharge power is preferably 100 to 10,000 W, more suitably 500 to 5,000 W.

Examples of the gas atmosphere include N₂, NF₃, H₂, rare gases such as He, and fluorocarbon; and more suitable examples include He, Ar, N₂, Ne, NF₃, H₂, CF₄, CHF₃, CH₂F₂, CH₃F, C₄F₆, C₄F₈, etc. These gases may be used as a mixture of two or more kinds. An advantage of the present invention is that the advantageous effects of the present invention can be expected even when using a gas atmosphere not containing O₂.

The time of the plasma irradiation can be selected from, for example, 10 to 240 seconds. The pressure can be selected appropriately.

In the step (I-3), the plasma irradiation is preferably performed under an atmosphere of N₂, NF₃, H₂, fluorocarbon, a rare gas such as He, or a mixture of any thereof.

From the viewpoint of productivity, examples of particularly favorable gas atmospheres include He, Ar, N₂, H₂, etc., and a gas containing H₂ or helium is preferable.

After the plasma irradiation, the metal-containing film may be subjected to heat treatment. When heating is to be performed after the plasma irradiation, as the heating conditions, the heating temperature can be selected appropriately from the range of 80 to 800°C (preferably 100 to 700°C, more preferably 200 to 600°C), and the heating time from the range of 30 to 180 seconds (preferably 30 to 120 seconds). Although not bound by the theory, it is considered that, by performing high-temperature heating after the plasma irradiation, dangling bonds are bonded, and this can contribute to higher density of the cured film (metal-containing film).

As the atmosphere during the heating after the plasma irradiation, it is possible to select, as necessary, an oxygen-containing atmosphere (oxygen concentration: 1% to 21%), such as air, or a non-oxygen atmosphere, such as nitrogen. For example, in a case where the substrate to be processed easily undergoes air oxidation, damage to the substrate can be suppressed by performing the heat treatment in an atmosphere with an oxygen concentration of less than 1% to form a cured film.

The irradiation apparatus is not particularly limited as long as plasma irradiation can be performed with the apparatus, and for example, it is possible to use Telius SP or Tactras Vigus manufactured by Tokyo Electron Ltd. It is possible to select an apparatus and set conditions in such a manner as to achieve the advantageous effects of the present invention more prominently.

The design of the metal-containing film pattern is not particularly limited. Examples include a line pattern and a contact hole pattern, and from the viewpoint of the uniformity of the surface modification by the plasma irradiation, a line pattern is preferable.

Before the plasma irradiation, the residual etching mask that remains on the metal-containing film pattern may be removed. In a case where a resist upper layer film, an organic antireflective film (BARC), an adhesive film, or an organic resist underlayer film remains on the metal-containing film pattern, the film can be removed by dry etching using an oxygen gas. In a case where a silicon-containing resist middle layer film remains on the metal-containing film, the film can be removed by dry etching using a fluorine-based gas.

The metal-containing film exhibits excellent dry etching resistance to oxygen and fluorine-based gas, and therefore, it is possible to remove the residual etching mask remaining on the metal-containing film pattern while minimizing change in line size and edge roughness.

In addition, the metal-containing film exhibits resistance to solutions such as basic solutions and acidic solutions, and therefore, the residual etching mask can also be removed by wet peeling.

When the removal is performed with a peeling solution, the peeling solution is not particularly limited as long as it is a solution such as a basic solution or an acidic solution.

As acid-containing removers, there is no particular limitation as long as they are acidic solutions containing an acid, but a solution containing any one or two out of hydrogen fluoride, hydrogen peroxide, and sulfuric acid is preferable. More specifically, particularly preferable are: an aqueous solution containing hydrochloric acid and hydrogen peroxide (SC-2 chemical solution); an aqueous solution containing sulfuric acid and hydrogen peroxide (SPM chemical solution); and an aqueous solution containing hydrofluoric acid and hydrogen peroxide (FPM chemical solution).

As base-containing removers, there is no particular limitation as long as they are basic solutions containing a base. Examples of the base include sodium hydroxide, potassium hydroxide, sodium carbonate, sodium silicate, sodium metasilicate, ammonia, ethylamine, n-propylamine, diethylamine, di-n-propylamine, triethylamine, methyldiethylamine, dimethylethanolamine, triethanolamine, tetramethylammonium hydroxide (hereinafter also referred to as "TMAH"), tetraethylammonium hydroxide, pyrrole, piperidine, choline, 1,8-diazabicyclo[5.4.0]-7-undecene, and 1,5-diazabicyclo-[4.3.0]-5-nonene. Among these, from the viewpoint of avoiding damage to the substrate, tetramethylammonium hydroxide (hereinafter also referred to as "TMAH") or ammonia is preferable.

As the base-containing removers, a solution containing a base and water or a solution containing a base, a hydrogen peroxide, and water is preferable. More specifically, particularly preferable are mixed aqueous solutions of ammonia and hydrogen peroxide (a mixed aqueous solution in which 25% aqueous ammonia solution/30% hydrogen peroxide solution/water = 1/2/40, a mixed aqueous solution in which 25% aqueous ammonia solution/30% hydrogen peroxide solution/water = 1/1/5, etc. (SC1)).

### <Step (I-4)>

Step (I-4) (steps (i-4) and (ii-6)) is a step of forming the pattern in the film to be processed while using the pattern of the metal-containing film as an etching mask.

The film to be processed to be processed while using the metal-containing film pattern as an etching mask is as described above, but from the viewpoint of forming a film-to-be-processed pattern having small edge roughness, the film to be processed is preferably Si, SiO₂, SiN, SiON, TiN, SOG, or an organic resist underlayer film. The metal-containing film pattern of the present invention exhibits excellent resistance to dry etching conditions where the etching rate of the film to be processed is higher (e.g. dry etching by a halogen-based gas plasma, such as a chlorine-based or bromine-based gas plasma), and therefore, a pattern having small edge roughness can be formed in the film to be processed.

### <Tone-Reversal Patterning Process Using Composition for Forming Metal-Containing Film>

The present invention also provides, as a tone-reversal patterning process using such a composition for forming a metal-containing film, a tone-reversal patterning process including the steps of:
forming a resist underlayer film on a substrate to be processed;
forming a resist middle layer film or a combination of an organic thin film and an inorganic hard mask middle layer film selected from a silicon oxide film, a silicon nitride film, and a silicon oxynitride film on the resist underlayer film;
forming a resist upper layer film on the resist middle layer film or the combination of the organic thin film and the inorganic hard mask middle layer film by using a photoresist material;
subjecting the resist upper layer film to pattern exposure and then development with a developer to form a pattern in the resist upper layer film;
transferring the pattern to the resist middle layer film or the organic thin film and the inorganic hard mask middle layer film by dry etching while using the resist upper layer film having the formed pattern as a mask;
transferring the pattern to the resist underlayer film by dry etching while using the resist middle layer film or the inorganic hard mask middle layer film having the transferred pattern as a mask;
covering the resist underlayer film having the formed pattern with a metal-containing film by using the above-described composition for forming a metal-containing film, thereby filling a space between the resist underlayer film patterns with the metal-containing film;
etching back the metal-containing film covering the resist underlayer film having the formed pattern by a chemical stripper or dry etching to expose an upper surface of the resist underlayer film having the formed pattern;
removing the resist middle layer film or the inorganic hard mask middle layer film remaining on the upper surface of the resist underlayer film by dry etching;
removing, by dry etching, the resist underlayer film having the formed pattern with an exposed surface to form a reverse pattern of an original pattern on the metal-containing film;
subjecting the metal-containing film pattern having the formed reverse pattern to plasma irradiation; and
processing the substrate to be processed while using the metal-containing film pattern as a mask to form the reverse pattern in the substrate to be processed.

As described above, when the resist underlayer film is formed on the substrate to be processed, the resist underlayer film can be formed by a method using a coating-type organic underlayer film material, a CVD method, an ALD method, or the like. Examples of the coating-type organic underlayer film material include resins and compositions disclosed in JP2012-1687A, JP2012-77295A, JP2004-264710A, JP2005-043471A, JP2005-250434A, JP2007-293294A, JP2008-65303A, JP2004-205685A, JP2007-171895A, JP2009-14816A, JP2007-199653A, JP2008-274250A, JP2010-122656A, JP2012-214720A, JP2014-29435A, WO2012/077640A1, WO2010/147155A1, WO2012/176767A1, JP2005-128509A, JP2006-259249A, JP2006-259482A, JP2006-293298A, JP2007-316282A, JP2012-145897A, JP2017-119671A, JP2019-44022A, etc.

In the tone-reversal patterning process, after the obtained resist underlayer film pattern is coated with the composition for forming a metal-containing film, it is preferable to remove the metal-containing film by using a dry etching gas mainly containing a chlorine-based gas so as to expose the upper surface of the resist underlayer film pattern. Thereafter, the resist middle layer film or the hard mask middle layer film remaining on the resist underlayer film is removed by dry etching using a fluorocarbon-based gas, and the resist underlayer film pattern having an exposed surface is removed by dry etching using an oxygen-based gas to form a metal-containing film pattern.

In the present invention, after the obtained resist underlayer film pattern is coated with the composition for forming a metal-containing film and after baking the metal-containing film, plasma irradiation may be performed. The plasma irradiation step is as described above.

In the inventive patterning process, plasma irradiation may be performed in multiple steps: after forming the metal-containing resist underlayer film; and after forming the metal-containing resist underlayer film pattern. By this method, the modification of the metal-containing resist underlayer film pattern can be further promoted.

### EXAMPLES

Hereinafter, the present invention will be specifically described with reference to Examples and Comparative Examples, but the present invention is not limited thereto.

The present invention is more specifically described below with reference to Synthesis Examples, Examples, and Comparative Examples. However, the present invention is not limited to these Examples. To obtain molecular weight and dispersity, weight-average molecular weight (Mw) and number-average molecular weight (Mn) on polystyrene basis were measured by gel permeation chromatography (GPC) using tetrahydrofuran as an eluent, and dispersity (Mw/Mn) was calculated from these values.

### [Synthesis Examples]

In the following Synthesis Examples, the following organic group raw material group G ((G1) to (G11)) and silicon-containing organic group raw material group H ((H1) and (H2)) were used.

The organic group raw material group G ((G1) to (G11)), (H1), and (H2) are shown below.

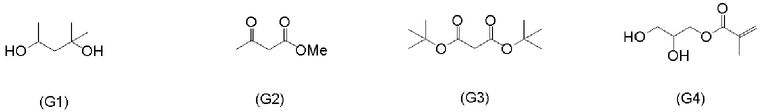

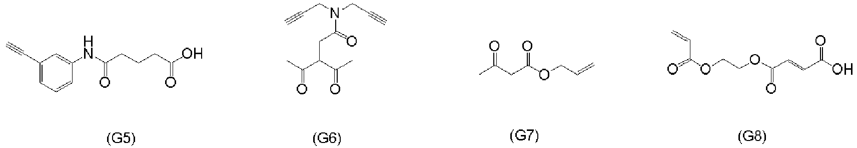

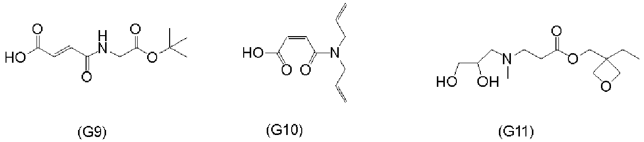

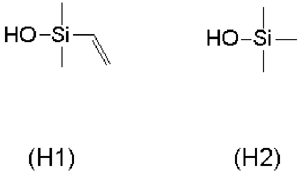

As a metal raw material M, the following metal compounds were used.
(M1): titanium tetraisopropoxide (377996 available from Sigma-Aldrich Corp)
(M2): Zr(OBu)₄: zirconium(IV) tetrabutoxide (80 mass% solution in 1-butanol) (Z0016 available from Tokyo Chemical Industry Co., Ltd.)
(M3): Hf(OBu)₄: hafnium(IV) n-butoxide (667943 available from Sigma-Aldrich Corp)

### [Synthesis Example 1] Synthesis of Compound (A-1) for Forming Metal-Containing Film

Under a nitrogen atmosphere, a solution of 1.6 g of deionized water in 54.5 g of n-butanol was added dropwise to a solution of 28.4 g of titanium tetraisopropoxide (M1) in 40.5 g of n-butanol while stirring at room temperature over 2 hours. To the obtained solution, 11.2 g of the organic group raw material group (G1) was added, and agitated at room temperature for 30 minutes. After the solution was concentrated under reduced pressure at 30°C, it was further heated to 60°C and heating was continued under reduced pressure to generate no distillate. When a distillate was no longer observed, 69.0 g of a PGMEA/PGME (ratio by weight: 70/30) solution was added thereto and heated under reduced pressure at 40°C until no IPA was distilled. Thus, a solution of a compound (A-1) for forming a metal-containing film in PGMEA/PGME was obtained. The concentration of the components other than the solvent in the solution was 17 mass%.

### [Synthesis of Compounds (A-2) to (A-11)]

The compounds (A-2) to (A-11) shown in Table 1 were obtained under the same reaction conditions as in Synthesis Example 1, except that the metal raw material M and the organic group raw material group G were used at the charging amounts shown in Table 1. The results for (A-1) are also shown.

**[Table 1]**

| Synthesis Example | Metal raw material M | | Organic group raw material group G | | Compound for forming metal-containing film |
|---|---|---|---|---|---|
| | Symbol | g | Symbol | g | |
| 1 | M1 | 28.4 | G1 | 11.2 | A-1 |
| 2 | M2 | 57.5 | G2 | 13.6 | A-2 |
| 3 | M3 | 54.9 | G3 | 25.1 | A-3 |
| 4 | M1 | 28.4 | G4 | 15.8 | A-4 |
| 5 | M2 | 57.5 | G5 | 50.1 | A-5 |
| 6 | M3 | 54.9 | G6 | 26.5 | A-6 |
| 7 | M2 | 57.5 | G7 | 17.4 | A-7 |
| 8 | M2 | 57.5 | G8 | 56.4 | A-8 |
| 9 | M2 | 57.5 | G9 | 59.6 | A-9 |
| 10 | M2 | 57.5 | G10 | 53.0 | A-10 |
| 11 | M2 | 57.5 | G11 | 32.4 | A-11 |

### [Synthesis Example 12] Synthesis of Compound (A-12) for Forming Metal-Containing Film

Under a nitrogen atmosphere, 12.6 g of titanium tetraisopropoxide (M1) was dissolved in 23.4 g of a PGMEA/PGME (ratio by weight: 70/30) solution, and while stirring, the reaction temperature was raised to 50°C, and 6.5 g of the compound H1 was added dropwise to the solution. After the addition, the reaction temperature was set to 60°C, and stirring was continued for 2 hours. Subsequently, a mixture obtained by suspending 5.4 g of the compound G4 in 10.8 g of a PGMEA/PGME (ratio by weight: 70/30) solution was added to the reaction system, and stirring was continued for 1 hour with the reaction temperature still at 60°C. After cooling to room temperature, the obtained reaction solution was filtered with a 0.45-µm PTFE filter. Thus, a solution of a compound (A-12) for forming a metal-containing film in PGMEA/PGME was obtained. The concentration of the components in the solution other than the solvent was 15 mass%.

### [Synthesis of Compounds (A-13) to (A-15)]

The compounds (A-13) to (A-15) shown in Table 2 were obtained under the same reaction conditions as in Synthesis Example 12, except that the metal raw material M, the raw material group G, and the raw material group H were used at the charging amounts shown in Table 2. The results for (A-12) are also shown.

**[Table 2]**

| Synthesis Example | Metal raw material M | | Organic group raw material group G | | Organic group raw material group H | | Compound for forming metal-containing film |
|---|---|---|---|---|---|---|---|
| | Raw material | g | Raw material | g | Raw material | g | |
| 12 | M2 | 12.6 | G4 | 5.4 | H1 | 6.5 | A-12 |
| 13 | M2 | 20.9 | G5 | 20.4 | H2 | 6.5 | A-13 |
| 14 | M3 | 20.3 | G6 | 7.8 | H2 | 6.5 | A-14 |
| 15 | M2 | 20.9 | G7 | 6.4 | H2 | 6.5 | A-15 |

### [Preparation of Composition (UDL-1) for Forming Metal-Containing Film]

The compound (A-1) for forming a metal-containing film was dissolved at the ratio shown in Table 3 in a mixed solvent of propylene glycol monomethyl ether acetate (PGMEA) and propylene glycol monomethyl ether (PGME), and the solution was filtered through a 0.02-µm membrane filter to prepare a composition (UDL-1) for forming a metal-containing film.

### [Preparation of Compositions (UDL-2 to -19) for Forming Metal-Containing Film]

Each chemical liquid was prepared in the same manner as UDL-1, except that the type and the contained amount of each component were as shown in Table 3. The following formula (E-1) was used for an acid generator (TAG), the following formula (PAG-1) was used for a photo-acid generator, and the following formula (Base-1) was used for a basic compound.

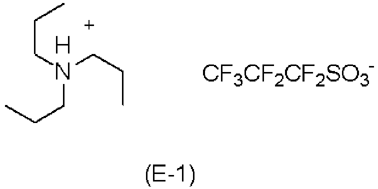

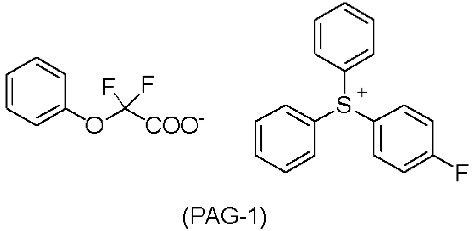

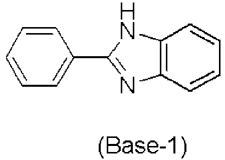

As metallic salts, the following (A-16) and (A-17) were used.
(A-16): hafnium carboxyethyl acrylate
(A-17): tetra(2,2,6,6-tetramethyl-3,5-heptanedionato)zirconium

### [Synthesis Example 16] Synthesis of Blended Polymer (BP-1)

The blended polymer (BP-1) was synthesized using the following raw materials (K1) and (K2).

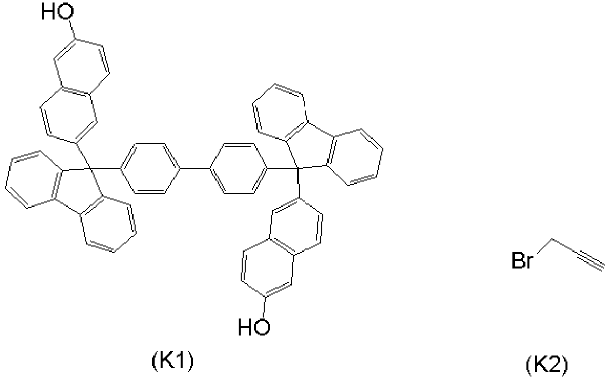

Under a nitrogen atmosphere, 45.5 g of the compound (K1) of the raw material group, 9.8 g of potassium carbonate, and 150 g of DMF were added together to form a homogeneous dispersion at an internal temperature of 50°C. 17.6 g of the modifying agent (K2) was slowly added thereto, and a reaction was allowed to take place at an internal temperature of 50°C for 24 hours. To the reaction solution, 300 ml of methyl isobutyl ketone and 300 g of pure water were added to dissolve the precipitated salt, and then the separated aqueous layer was removed. Furthermore, the organic layer was washed six times with 100 g of a 3% aqueous nitric acid solution and 100 g of pure water, and then the organic layer was evaporated under reduced pressure to dryness to obtain a compound (BP-1) for a flowability accelerator.

The weight-average molecular weight (Mw) and the dispersity (Mw/Mn) were determined by GPC, and the following results were obtained.
(BP-1): Mw=965, Mw/Mn=1.08

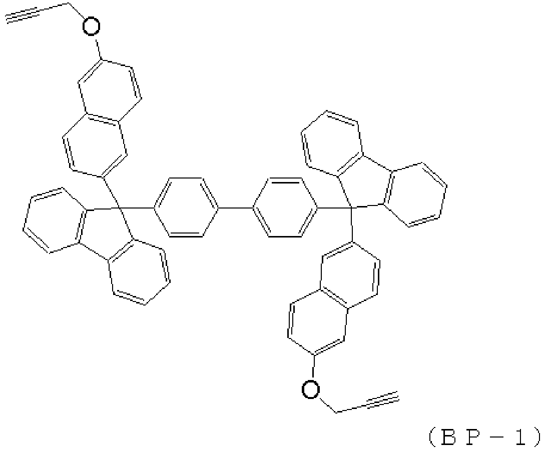

### [Synthesis Example 17] Synthesis of Blended Polymer (BP-2)

1400 g of ethanol, 700 g of ultrapure water, and 50 g of 25% tetramethylammonium hydroxide were added together to form a homogeneous solution at 40°C under a nitrogen atmosphere. A mixture of 138.6 g of 2-(3,4-epoxycyclohexyl)ethyltrimethoxysilane and 37.2 g of phenyltrimethoxysilane was slowly added dropwise thereto, and then a reaction was allowed to take place at 40°C for 2 hours. After completion of the reaction, 35 g of acetic acid was added thereto to terminate the reaction, and ethanol was distilled off under reduced pressure. To the solution after the distillation, 2000 ml of ethyl acetate was added to separate the aqueous layer, and the organic layer was washed twice with 400 ml of ultrapure water. Then, 1000 g of PGMEA (propylene glycol monomethyl ether acetate) was added thereto, and the water and low-boiling-point solvent were distilled off to collect a polysiloxane compound (BP-2) as 600 g of a solution in PGMEA (compound concentration: 20%). The molecular weight of the polysiloxane compound (BP-2) was measured in terms of polystyrene, and was Mw=2800.

**[Table 3]**

| Composition for forming metal-containing film | (A) Compound for forming metal-containing film | Additive | Solvent |
|---|---|---|---|
| | (parts by mass) | (parts by mass) | (parts by mass) |
| UDL-1 | A-1 (5) | PAG-1 (0.5) | PGMEA/PGEE (65/30) |
| UDL-2 | A-2 (5) | PAG-1 (0.5) | PGMEA/PGEE (65/30) |
| | | Base-1 (0.1) | |
| UDL-3 | A-3 (5) | | PGMEA/PGEE (65/30) |
| UDL-4 | A-4 (5) | | PGMEA/PGEE (65/30) |
| UDL-5 | A-5 (5) | | PGMEA/PGEE (65/30) |
| UDL-6 | A-6 (5) | | PGMEA/PGEE (65/30) |
| UDL-7 | A-7 (5) | | PGMEA/PGEE (65/30) |
| UDL-8 | A-8 (5) | | PGMEA/PGEE (65/30) |
| UDL-9 | A-9 (5) | | PGMEA/PGEE (65/30) |
| UDL-10 | A-10 (5) | | PGMEA/PGEE (65/30) |
| UDL-11 | A-11 (5) | | PGMEA/PGEE (65/30) |
| UDL-12 | A-12 (5) | | PGMEA/PGEE (65/30) |
| UDL-13 | A-13 (5) | | PGMEA/PGEE (65/30) |
| UDL-14 | A-14 (5) | | PGMEA/PGEE (65/30) |
| UDL-15 | A-15 (5) | | PGMEA/PGEE (65/30) |
| UDL-16 | A-16 (10) | | PGMEA/PGEE (60/30) |
| UDL-17 | A-17 (10) | | PGMEA/PGEE (60/30) |
| UDL-18 | A-18 (5) | BP-1 (2) | PGMEA/PGEE (65/28) |
| | | F-1 (1) | |
| UDL-19 | A-19 (5) | BP-2 (2) | PGMEA/PGEE (65/28) |
| | | E-1 (0.2) | |

### [Resist Underlayer Film Pattern Formation Evaluation]

Each of the compositions (UDL-1 to -19) for forming a metal-containing film was respectively applied onto a silicon wafer substrate having an SiO₂ film formed thereon, and baked at the temperature shown in Table 3 for 60 seconds to form a metal-containing film having a thickness of 30 nm. An organic resist underlayer film (SOC-1) was applied thereto, followed by baking at 350°C for 60 seconds to form a resist underlayer film having a thickness of 80 nm. A silicon-containing resist middle layer film material (SOG-1) was applied thereto, followed by baking at 220°C for 60 seconds to form a resist middle layer film having a thickness of 20 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

As the organic resist underlayer film composition (SOC-1), a coating-type resist underlayer film composition (SOC-1) was prepared by dissolving an organic underlayer film polymer represented by (SOP1) in an organic solvent containing 0.1 mass% of FC-4430 (available from Sumitomo 3M Limited) in the proportion shown in Table 4; and filtering the solution through a filter made of a fluororesin and having a pore size of 0.2 µm**.**

**[Table 4]**

| | Organic underlayer film polymer | Organic solvent |
|---|---|---|
| | (parts by mass) | (parts by mass) |
| SOC-1 | SOP1 (7) | PGMEA (93) |

The structural formula of the used organic underlayer film polymer (SOP1) is shown in Table 5.

**[Table 5]**

| Compound or polymer | Mw | Mw/Mn |
|---|---|---|
| 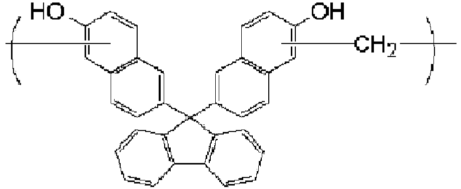 (SOP1) | 3,700 | 2.82 |

The silicon-containing resist middle layer film material (SOG-1) was prepared by dissolving a polymer represented by an ArF silicon-containing middle layer film polymer (SiP1) and a crosslinking catalyst (CAT1) in an organic solvent containing 0.1 mass% of FC-4430 (manufactured by Sumitomo 3M Limited) in the proportion shown in Table 6; and filtering the solution through a filter made of a fluororesin and having a pore size of 0.1 µm.

**[Table 6]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4000) |

The structural formulae of the ArF silicon-containing middle layer film polymer (SiP1) and the crosslinking catalyst (CAT1) used are shown below.

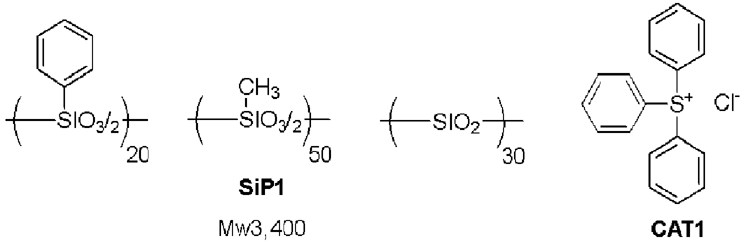

The resist upper layer film material (monolayer resist for ArF) was prepared by dissolving a polymer (RP1), an acid generator (PAG2), and a basic compound (Amine1), each in the proportion shown in Table 7, in a solvent containing 0.1% by mass of a surfactant FC-4430 (manufactured by Sumitomo 3M Limited), and filtering the solution through a 0.1-µm filter made of a fluororesin.

**[Table 7]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG2 (6.6) | Amine1 (0.8) | PGMEA (2500) |

The polymer (RP1), the acid generator (PAG2), and the basic compound (Amine1) used for the resist upper layer film material (monolayer resist for ArF) are shown below.

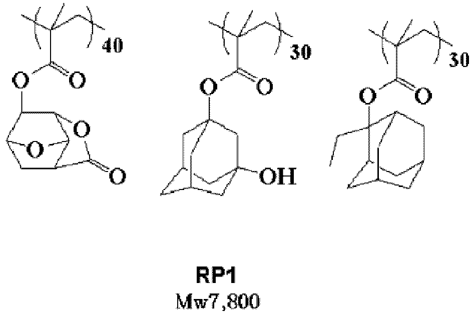

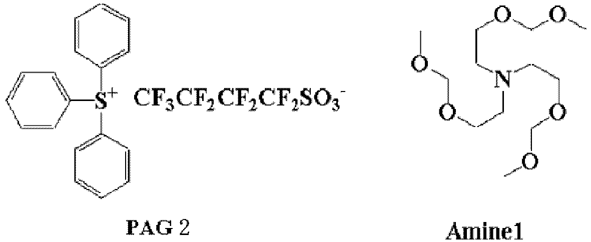

The liquid immersion top coat composition (TC-1) was prepared by dissolving a top coat polymer (PP1) in an organic solvent at the proportion shown in Table 8, and filtering the solution through a 0.1-µm filter made of a fluororesin.

**[Table 8]**

| | Polymer (parts by mass) | Organic solvent (parts by mass) |
|---|---|---|
| TC-1 | PP1 (100) | Diisoamyl ether (2700) |
| | | 2-methyl-1-butanol (270) |

The polymer (PP1) used for the liquid immersion top coat composition (TC-1) is shown below.

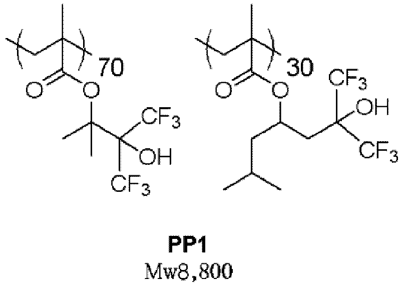

Then, the substrate was exposed to light with an ArF liquid immersion exposure apparatus (NSR-S610C manufactured by Nikon Corporation, NA: 1.30, σ: 0.98/0.78, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 45 nm 1 : 1 positive line-and-space pattern (a resist pattern).

Subsequently, the silicon-containing resist middle layer film material (SOG-1) was etched by dry etching by using an etching apparatus Tactras manufactured by Tokyo Electron Ltd. while using the resist pattern as a mask to form a hard mask pattern. Then, the resist underlayer film was etched while using the obtained SOG-1 pattern as a mask to form a resist underlayer film pattern. The line size of the obtained resist underlayer film pattern was measured using CD-SEM (CG5000) manufactured by Hitachi High-Technologies Corp.

### Conditions in transferring resist pattern to silicon-containing resist middle layer film material (SOG-1)

Chamber pressure: 50 mT
RF-power (upper portion): 500 W
RF-power (lower portion): 300 W
CF₄ gas flow rate: 150 sccm
CHF₃ gas flow rate: 50 sccm
Time: 15 sec

### Conditions in transferring silicon-containing resist middle layer film material (SOG-1) pattern to resist underlayer film

Chamber pressure: 10 mT
RF-power (upper portion): 1,000 W
RF-power (lower portion): 300 W
CO₂ gas flow rate: 320 sccm
N₂ gas flow rate: 80 sccm
Time: 60 sec

### Conditions in transferring organic resist underlayer film pattern to metal-containing film

Chamber pressure: 20 mT
RF-power (upper portion): 500 W
RF-power (lower portion): 100 W
BCl₃ gas flow rate: 50 sccm
H₂ gas flow rate: 100 sccm
Ar gas flow rate: 150 sccm
Time: 45 sec

After that, each substrate having the formed metal-containing film pattern was subjected to plasma treatment by using an etching apparatus Tactras manufactured by Tokyo Electron Ltd. under the following conditions, and the line size of the obtained metal-containing film pattern was measured using CD-SEM (CG5000) manufactured by Hitachi High-Technologies Corp. The pattern cross section was observed with an electron microscope (S-4700) manufactured by Hitachi, Ltd.
Chamber pressure: 100 mT
RF-power (upper portion): 100 W
RF-power (lower portion): 2000 W
H₂ gas flow rate: 200 sccm
Time: 20 sec

The SiO₂ film was etched while using the metal-containing film pattern obtained in the above evaluation as a mask. The etching conditions were as shown below. The line size of the obtained pattern was measured using CD-SEM (CG5000) manufactured by Hitachi High-Technologies Corp. The pattern cross section was observed with an electron microscope (S-4700) manufactured by Hitachi, Ltd. The results are shown in Table 9.
Chamber pressure: 100 mT
RF-power (upper portion): 500 W
RF-power (lower portion): 300 W
CF₄ gas flow rate: 150 sccm
CHF₃ gas flow rate: 30 sccm
O₂ gas flow rate: 10 sccm
Time: 100 sec

### (Comparative Example 1-1)

As a comparative example, the following evaluation was performed.

The organic resist underlayer film composition (SOC-1) was applied onto a silicon wafer substrate having an SiO₂ film formed thereon, and baked at 350°C for 60 seconds to form a resist underlayer film having a thickness of 80 nm. A silicon-containing resist middle layer film material (SOG-1) was applied thereto, followed by baking at 220°C for 60 seconds to form a resist middle layer film having a thickness of 20 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

Then, the substrate was exposed to light with an ArF liquid immersion exposure apparatus (NSR-S610C manufactured by Nikon Corporation, NA: 1.30, σ: 0.98/0.78, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 45 nm 1 : 1 positive line-and-space pattern (a resist pattern).

Subsequently, the silicon-containing resist middle layer film material (SOG-1) was etched by dry etching by using an etching apparatus Tactras manufactured by Tokyo Electron Ltd. while using the resist pattern as a mask to form an SOG-1 pattern. Then, the resist underlayer film was etched while using the obtained SOG-1 pattern as a mask to form a resist underlayer film pattern. The line size of the obtained resist underlayer film pattern was measured using CD-SEM (CG5000) manufactured by Hitachi High-Technologies Corp. The results are shown in Table 9.

### Conditions in transferring resist pattern to silicon-containing resist middle layer film material (SOG-1)

Chamber pressure: 50 mT
RF-power (upper portion): 500 W
RF-power (lower portion): 300 W
CF₄ gas flow rate: 150 sccm
CHF₃ gas flow rate: 50 sccm
Time: 15 sec

### Conditions in transferring silicon-containing resist middle layer film material (SOG-1) pattern to organic resist underlayer film

Chamber pressure: 10 mT
RF-power (upper portion): 1,000 W
RF-power (lower portion): 300 W
CO₂ gas flow rate: 320 sccm
N₂ gas flow rate: 80 sccm
Time: 60 sec

The SiO₂ film was etched while using the organic resist underlayer film pattern obtained in the above evaluation as a mask. The etching conditions were as shown below. The line size of the obtained pattern was measured using CD-SEM (CG5000) manufactured by Hitachi High-Technologies Corp. The pattern cross section was observed with an electron microscope (S-4700) manufactured by Hitachi, Ltd.
Chamber pressure: 100 mT
RF-power (upper portion): 500 W
RF-power (lower portion): 300 W
CF₄ gas flow rate: 150 sccm
CHF₃ gas flow rate: 30 sccm
O₂ gas flow rate: 10 sccm
Time: 100 sec

### (Comparative Example 1-2)

In Comparative Example 1-2, the SiO₂ film was etched without performing plasma irradiation on a metal-containing film pattern formed using the composition (UDL-1) for forming a resist underlayer film in the same manner as in Example 1-1. The results are shown in Table 9.

**[Table 9]**

| Example | Composition for forming resist underlayer film | Baking temperature | Pattern to be plasma-irradiated | Cross-sectional profile of pattern | LWR after substrate processing (nm) |
|---|---|---|---|---|---|
| Example 1-1 | UDL-1 | 350°C | Metal-containing film pattern | Rectangular | 3.04 |
| Example 1-2 | UDL-2 | 350°C | Metal-containing film pattern | Rectangular | 2.94 |
| Example 1-3 | UDL-3 | 350°C | Metal-containing film pattern | Rectangular | 2.97 |
| Example 1-4 | UDL-4 | 350°C | Metal-containing film pattern | Rectangular | 3.01 |
| Example 1-5 | UDL-5 | 350°C | Metal-containing film pattern | Rectangular | 3.01 |
| Example 1-6 | UDL-6 | 350°C | Metal-containing film pattern | Rectangular | 3.08 |
| Example 1-7 | UDL-7 | 350°C | Metal-containing film pattern | Rectangular | 2.97 |
| Example 1-8 | UDL-8 | 350°C | Metal-containing film pattern | Rectangular | 3.09 |
| Example 1-9 | UDL-9 | 350°C | Metal-containing film pattern | Rectangular | 3.13 |
| Example 1-10 | UDL-10 | 350°C | Metal-containing film pattern | Rectangular | 3.08 |
| Example 1-11 | UDL-11 | 350°C | Metal-containing film pattern | Rectangular | 3.03 |
| Example 1-12 | UDL-12 | 350°C | Metal-containing film pattern | Rectangular | 3.02 |
| Example 1-13 | UDL-13 | 350°C | Metal-containing film pattern | Rectangular | 3.03 |
| Example 1-14 | UDL-14 | 350°C | Metal-containing film pattern | Rectangular | 3.07 |
| Example 1-15 | UDL-15 | 350°C | Metal-containing film pattern | Rectangular | 2.97 |
| Example 1-16 | UDL-16 | 350°C | Metal-containing film pattern | Rectangular | 2.97 |
| Example 1-17 | UDL-17 | 350°C | Metal-containing film pattern | Rectangular | 2.99 |
| Example 1-18 | UDL-18 | 350°C | Metal-containing film pattern | Rectangular | 3.05 |
| Example 1-19 | UDL-19 | 350°C | Metal-containing film pattern | Rectangular | 3.02 |
| Comparative Example 1-1 | Comparative UDL-1 | 350°C | Resist underlayer film pattern | Distorted | 3.63 |
| Comparative Example 1-2 | Comparative UDL-2 | 350°C | No plasma irradiation performed | Rectangular | 3.35 |

As shown in Table 9, it was observed that, in Examples 1-1 to 1-19, where a plasma-irradiated metal-containing film pattern was used as a mask, the LWR of the SiO₂ film pattern was better than in Comparative Example 1-1, where an organic resist underlayer film pattern was used as a mask, and that the Examples can be used suitably in fine processing.

Better results were also achieved compared to Comparative Example 1-2, where the dry etching of the SiO₂ film was performed without subjecting the metal-containing film pattern to plasma irradiation. The full mechanism is not certain, but it is conjectured that, by subjecting the metal-containing film pattern to plasma irradiation, the film on the surface of the pattern side walls was modified, and the dry etching resistance necessary for forming the pattern of the film to be processed, having excellent edge roughness, was imparted.

As described above, the inventive patterning process makes it possible to form a metal-containing film pattern that exhibits excellent dry etching resistance, and therefore, makes it possible to form, in a film to be processed, a pattern having small edge roughness, and is extremely useful for next-generation fine-processing processes.

The present description includes the following embodiments.
[1] A patterning process for forming a pattern on a substrate, comprising the steps of:
   (I-1) applying a composition for forming a metal-containing film onto a substrate on which a film to be processed has been formed, followed by heating to form a metal-containing film;
   (I-2) forming a pattern directly or indirectly in the metal-containing film;
   (I-3) subjecting the pattern of the metal-containing film to plasma irradiation; and
   (I-4) forming the pattern directly or indirectly in the film to be processed while using the plasma-irradiated pattern of the metal-containing film as an etching mask, wherein
   a plasma used in the plasma irradiation in the step (I-3) etches the metal-containing film less than an etching gas used in the step (I-2) and etches the film to be processed less than an etching gas used in the step (I-4).
[2] The patterning process according to [1], wherein, in the step (I-2), the metal-containing film is subjected to pattern exposure with a high-energy beam and then development with a developer to form the pattern in the metal-containing film.
[3] The patterning process according to [2], wherein, in the step (I-2), an extreme ultraviolet ray having a wavelength of 3 to 15 nm or an electron beam with an acceleration voltage of 1 to 150 kV is used as the high-energy beam.
[4] The patterning process according to [2] or [3], wherein, in the step (I-2), the developer contains an organic solvent.
[5] The patterning process according to [1], comprising, between the step (I-1) and the step (I-2), the steps of:
   (I-1-1) forming a resist upper layer film directly or indirectly on the metal-containing film; and
   (I-1-2) subjecting the resist upper layer film to pattern exposure and then development with a developer to form a pattern in the resist upper layer film, wherein
   in the step (I-2), the pattern is formed in the metal-containing film by performing etching at least once while using the pattern of the resist upper layer film as a mask.
[6] The patterning process according to any one of [1] to [5], wherein the step of performing plasma irradiation is performed under an atmosphere of N₂, NF₃, H₂, fluorocarbon, a rare gas, or a mixture thereof.
[7] The patterning process according to [6], wherein the step of performing plasma irradiation is performed under an atmosphere containing hydrogen or helium.
[8] The patterning process according to any one of [1] to [7], wherein the composition for forming a metal-containing film contains (A) a metal source containing at least one of (A-1) a metal compound and (A-2) a metallic salt and contains (B) a solvent, the metal being a metal element belonging to the third period to the seventh period of group 3 to 15 of the periodic table.
[9] The patterning process according to [8], wherein the metal contained in the metal compound (A-1) is titanium, zirconium, or hafnium.
[10] The patterning process according to any one of [1] to [9], wherein the film to be processed is any of a metal film, a metal carbide film, a metal oxide film, a metal nitride film, a metal oxycarbide film, a metal oxynitride film, and an organic film containing carbon and one or more elements selected from nitrogen, hydrogen, and oxygen.
[11] The patterning process according to [10], wherein the metal of the film to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A patterning process for forming a pattern on a substrate, comprising the steps of:
(I-1) applying a composition for forming a metal-containing film onto a substrate on which a film to be processed has been formed, followed by heating to form a metal-containing film;
(I-2) forming a pattern directly or indirectly in the metal-containing film;
(I-3) subjecting the pattern of the metal-containing film to plasma irradiation; and
(I-4) forming the pattern directly or indirectly in the film to be processed while using the plasma-irradiated pattern of the metal-containing film as an etching mask, wherein
a plasma used in the plasma irradiation in the step (I-3) etches the metal-containing film less than an etching gas used in the step (I-2) and etches the film to be processed less than an etching gas used in the step (I-4).

2. The patterning process according to claim 1, wherein, in the step (I-2), the metal-containing film is subjected to pattern exposure with a high-energy beam and then development with a developer to form the pattern in the metal-containing film.

3. The patterning process according to claim 2, wherein, in the step (I-2), an extreme ultraviolet ray having a wavelength of 3 to 15 nm or an electron beam with an acceleration voltage of 1 to 150 kV is used as the high-energy beam.

4. The patterning process according to claim 2 or 3, wherein, in the step (I-2), the developer contains an organic solvent.

5. The patterning process according to claim 1, comprising, between the step (I-1) and the step (I-2), the steps of:
(I-1-1) forming a resist upper layer film directly or indirectly on the metal-containing film; and
(I-1-2) subjecting the resist upper layer film to pattern exposure and then development with a developer to form a pattern in the resist upper layer film, wherein
in the step (I-2), the pattern is formed in the metal-containing film by performing etching at least once while using the pattern of the resist upper layer film as a mask.

6. The patterning process according to any one of claims 1 to 5, wherein the step of performing plasma irradiation is performed under an atmosphere of N₂, NF₃, H₂, fluorocarbon, a rare gas, or a mixture thereof.

7. The patterning process according to claim 6, wherein the step of performing plasma irradiation is performed under an atmosphere containing hydrogen or helium.

8. The patterning process according to any one of claims 1 to 7, wherein the composition for forming a metal-containing film contains (A) a metal source containing at least one of (A-1) a metal compound and (A-2) a metallic salt and contains (B) a solvent, the metal being a metal element belonging to the third period to the seventh period of group 3 to 15 of the periodic table.

9. The patterning process according to claim 8, wherein the metal contained in the metal compound (A-1) is titanium, zirconium, or hafnium.

10. The patterning process according to any one of claims 1 to 9, wherein the film to be processed is any of a metal film, a metal carbide film, a metal oxide film, a metal nitride film, a metal oxycarbide film, a metal oxynitride film, and an organic film containing carbon and one or more elements selected from nitrogen, hydrogen, and oxygen.

11. The patterning process according to claim 10, wherein the metal of the film to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.
